# EUROPEAN PATENT APPLICATION

(11) **EP 2 325 920 A2**
(43) Date of publication of application: **25.05.2011**
(21) Application number: 10251872.7
(22) Date of filing: 29.10.2010
(51) Int. Cl.: H01M 2/10, H01M 2/20, H01M 10/48, B60L 11/18, G01R 31/36, H02J 7/00

(54) **Battery module, battery system and electric vehicle including the same**

(30) Priority: 30.10.2009 JP 2009251146; 23.07.2010 JP 2010166129; 08.10.2010 JP 2010229097
(71) Applicant: Sanyo Electric Co., Ltd., Osaka 570-8677 (JP)
(72) Inventor: Seo, Kazuhiro, Moriguchi City Osaka 570-8677 (JP); Kishimoto, Keiji, Moriguchi City Osaka 570-8677 (JP); Ohkura, Kazumi, Moriguchi City Osaka 570-8677 (JP); Nishihara, Yoshitomo, Moriguchi City Osaka 570-8677 (JP); Kunimitsu, Tomonori, Moriguchi City Osaka 570-8677 (JP); Matsubara, Tomoyuki, Moriguchi City Osaka 570-8677 (JP)
(74) Representative: Calderbank, Thomas Roger

(57) **Abstract**

A battery system includes a plurality of battery modules each including a plurality of battery cells. One battery module includes a main circuit board, and the other battery modules include auxiliary circuit boards. The main circuit board includes a cell characteristics detecting circuit that detects characteristics of each battery cell and a control-related circuit having a function related to control of the plurality of battery modules. The auxiliary circuit board includes a cell characteristics detecting circuit that detects characteristics of each battery cell, and does not include a control-related circuit having the function related to control of the plurality of battery modules. In a battery module of another battery system, a first printed circuit board, a board holder and a second printed circuit board are attached to one end surface frame. A voltage detecting circuit that detects a voltage between terminals of each battery cell and a communication circuit having a communication function are mounted on the first and second printed circuit boards, respectively.

## Description

The present invention relates to a battery module, a battery system including a plurality of battery modules, and an electric vehicle including the same.

In a battery system used as a driving source of a movable object such as an electric automobile, one or a plurality of chargeable and dischargeable battery modules are provided for supplying a driving force. Each of the battery modules has a battery block constituted by a plurality of batteries (battery cells) connected in series, for example, and a detecting circuit that detects a voltage of each battery cell.

JP 8-162171 A discloses a monitoring device of a battery pack mounted on a movable object such as an electric automobile. The battery pack is composed of a plurality of modules, each of which includes a plurality of cells. The monitoring device includes a plurality of voltage measuring units connected to the plurality of modules, respectively, and an electronic control unit (ECU). The ECU is connected to the plurality of voltage measuring units. A voltage of the module detected by each voltage measuring unit is transmitted to the ECU.

JP 2009-168720 A discloses a battery system including a capacitor unit, a contactor and a management unit (MGU). The capacitor unit includes a plurality of cells connected in series and a plurality of controlling units. Each controlling unit includes a state detector that detects a voltage of each cell and so on. The plurality of controlling units are connected to the MGU.

In the monitoring device of the battery pack described in JP 8-162171 A, the ECU performs various types of monitoring and control such as charge control and life determination of the battery pack.

In the battery system described in JP 2009-168720 A, the MGU performs monitoring and control of the capacitor unit.

JP 2009-220740 A discloses a signal processing module that detects voltages of a plurality of battery cells (single cells) of a fuel cell. The fuel cell is configured to have the plurality of battery cells stacked in a thickness direction with both end surfaces sandwiched by a pair of plates and a support rod. The signal processing module has such a configuration that a plurality of circuit boards are stacked inside a housing. The signal processing module is attached to an upper surface of the fuel cell that is parallel to the direction in which the plurality of battery cells are stacked.

The system using the battery pack and monitoring device of JP 8-162171 A and the battery system of JP 2009-168720 A, however, may result in complicated wiring and difficulty in being reduced in size.

In the fuel cell including the signal processing module disclosed in JP 2009-220740 A, the plurality of circuit boards corresponding to the number of the battery cells are stacked in the signal processing module. However, arranging the fuel cell including the signal processing module requires large space of three dimensions. Therefore, there is a limitation of space for arranging the fuel cell including the signal processing module.

An object of the present invention is to provide a battery system whose wiring can be simplified and size can be reduced, and an electric vehicle including the same.

Another object of the present invention is to provide a battery module in which a limitation of space caused by arranging a plurality of circuit boards may be relieved, a battery system and an electric vehicle.
(1) According to one aspect of the present invention, a battery system includes a plurality of battery modules each including a plurality of battery cells, wherein at least one of the plurality of battery modules further includes a main circuit board, another battery module further includes an auxiliary circuit board, the main circuit board includes a first cell characteristics detecting circuit arranged to detect characteristics of each battery cell and a control-related circuit having a function related to control of the plurality of battery modules, and the auxiliary circuit board includes a second cell characteristics detecting circuit arranged to detect characteristics of each battery cell, and does not include the control-related circuit having the function related to control of the plurality of battery modules.
   In the battery system according to the one aspect of the present invention, the at least one of the plurality of battery modules includes the main circuit board. The another battery module includes the auxiliary circuit board. The main circuit board includes the first cell characteristics detecting circuit that detects the characteristics of each battery cell, and the control-related circuit having the function related to control of the plurality of battery modules. On the other hand, the auxiliary circuit board includes the second cell characteristics detecting circuit that detects the characteristics of each battery cell, and does not include the control-related circuit.
   In this case, a controlling unit having the function related to control of the plurality of battery modules need not be separately provided in the battery system because the battery module includes the control-related circuit. This allows wiring of the battery system to be simplified and allows the battery system to be reduced in size.
(2) The main circuit board may be constituted by a circuit board including the first cell characteristics detecting circuit and the control-related circuit.
   In this case, the wiring between the first cell characteristics detecting circuit and the control-related circuit can be formed on the circuit board. This allows wiring of the battery system to be further simplified and allows the battery system to be further reduced in size.
(3) The main circuit board may be constituted by a first circuit board including the first cell characteristics detecting circuit and a second circuit board including the control-related circuit.
   In this case, the control-related circuit is mounted on the second circuit board that is provided separately from the first circuit board including the first cell characteristics detecting circuit. Therefore, the control-related circuit having functions related to greater variety of control can be provided in the second circuit.
(4) The battery system may further include a detecting unit arranged to detect a parameter, wherein the control-related circuit may have a detecting function for detecting information, which is used for controlling the plurality of battery modules, based on the parameter detected by the detecting unit, and the control-related circuit of the main circuit board may be arranged closer than the auxiliary circuit board to the detecting unit.
   In this case, the control-related circuit detects the information, which is used for controlling the plurality of battery modules, based on the parameter detected by the detecting unit. The control-related circuit is arranged closer to the detecting unit. This shortens wiring connecting the control-related circuit and the detecting unit.
(5) The battery system may further include a control target that is related to control of the plurality of battery modules, wherein the control-related circuit may have a controlling function for controlling operation of the control target, and the control-related circuit of the main circuit board may be arranged closer than the auxiliary circuit board to the control target.
   In this case, the operation of the control target is controlled by the control-related circuit. The control-related circuit is arranged closer to the control target. This shortens wiring connecting the control-related circuit and the control target.
(6) The main circuit board may further include a first discharging circuit arranged to cause each battery cell of the at least one battery module to discharge, and the auxiliary circuit board may further include a second discharging circuit arranged to cause each battery cell of the another battery module to discharge.
   In this case, the first discharging circuit and the second discharging circuit are individually provided in the main circuit board and the auxiliary circuit board, respectively. This allows heat generated by discharge of the battery cells of the plurality of battery modules to be efficiently released. This prevents deterioration of the first and second cell characteristics detecting circuits and the control-related circuit.
(7) According to another aspect of the present invention, an electric vehicle includes the battery system according to the one aspect of the present invention, a motor driven by electric power supplied from the plurality of battery modules of the battery system, and a drive wheel rotated by a torque generated by the motor.
   In the electric vehicle according to the another aspect of the present invention, the motor is driven by the electric power supplied from the battery modules. The drive wheel is rotated by the torque generated by the motor, thereby moving the electric vehicle.
   The battery system according to the one aspect of the present invention is used in the electric vehicle, so that wiring of the electric vehicle can be simplified and the electric vehicle can be reduced in size.
(8) According to still another aspect of the present invention, a battery module that can communicate with an external apparatus includes a battery block constituted by a plurality of battery cells that are stacked, and a first circuit board and a second circuit board on which circuits for detecting states of the plurality of battery cells and communicating with the external apparatus are mounted, wherein the battery block has a first surface intersecting with a direction (X-direction) in which the plurality of battery cells are stacked, the first circuit board is provided on the first surface of the battery block, and the second circuit board is provided on a surface that is different from the first surface of the battery block.
   In this case, the first circuit board is provided on the first surface that intersects with the direction in which the plurality of battery cells are stacked, and the second circuit board is provided on the surface that different from the first surface of the battery block. This inhibits increased size of the battery module in directions different from the direction in which the battery cells are stacked. Accordingly, a limitation of space caused by arranging the plurality of circuit boards is relieved.
(9) The second circuit board may be provided on a second surface that is parallel to the first surface so as to be stacked on the first circuit board.
   In this case, increased size of the battery module in the direction (Y-direction or Z-direction, for example) different from the direction in which the battery cells are stacked is sufficiently inhibited. This allows the battery module to be arranged without difficulty even though there is limited space in the directions different from the direction in which the battery cells are stacked for arranging the battery module.
(10) The battery block may have a third surface that is opposite to the first surface with the plurality of battery cells arranged between the first surface and the third surface, and the second circuit board may be provided on the third surface of the battery block.
   In this case, increased size of the battery module in the direction (Y-direction or Z-direction, for example) different from the direction in which the battery cells are stacked is sufficiently inhibited. This allows the battery module to be arranged without difficulty even though there is limited space in the directions different from the directions in which the battery cells are stacked for arranging the battery module.
(11) The battery block may have a fourth surface along the direction (X-direction) intersecting with the first surface, and the second circuit board may be provided on the fourth surface of the battery block.
   In this case, increased size of the battery module in a direction (Y-direction, for example) along the first surface and the fourth surface is inhibited. This allows the battery module to be arranged without difficulty even though there is limited space in the direction along the first surface and the fourth surface for arranging the battery module.
   The first circuit board is provided on the first surface, and the second circuit board is provided on the fourth surface that is different from the first surface of the battery block, thus minimizing an increase in size of the battery module in the direction intersecting with the first surface (the X-direction, for example) and the direction intersecting with the fourth surface (a Z-direction, for example). This allows the battery module to be arranged even though there is limited space in the direction intersecting with the first surface and the direction intersecting with the fourth surface for arranging the battery module.
(12) The circuits may include a detecting unit arranged to detect the states of the plurality of battery cells and a communication unit arranged to communicate with the external apparatus, the first circuit board may include one of the detecting unit and the communication unit, and the second circuit board may include the other one of the detecting unit and the communication unit.
   In this case, the detecting unit and the communication unit are separately provided on the respective circuit boards. Therefore, one of the circuit boards is replaced when the number of the plurality of battery cells is increased, so that voltages of the plurality of battery cells can be detected.
(13) According to yet another aspect of the present invention, a battery system includes a plurality of battery modules each including a plurality of battery cells, wherein at least one of the plurality of battery modules is the battery module according the foregoing invention.
   In the battery system, the at least one of the plurality of battery modules is the battery module according the foregoing invention. Accordingly, a limitation of space caused by arranging the plurality of circuit boards in the at least one of the battery modules is relieved. This improves design flexibility of the battery system.
(14) According to yet another aspect of the present invention, an electric vehicle includes the battery system according the foregoing invention, a motor driven by electric power supplied from the plurality of battery modules included in the battery system, and a drive wheel rotated by a torque generated by the motor.
   In the electric vehicle, the motor is driven by the electric power supplied from the plurality of battery modules. The drive wheel is rotated by the torque generated by the motor, thereby moving the electric vehicle.
   The battery system according to the foregoing invention is used in the electric vehicle, thus improving design flexibility of the electric vehicle.

According to the present invention, the wiring of the battery system can be simplified and the battery system can be reduced in size. In addition, a limitation of space in the battery module caused by arranging the plurality of circuit boards is relieved.

Other features, elements, characteristics, and advantages of the present invention will become more apparent from the following description of preferred embodiments of the present invention with reference to the attached drawings.

In the drawings
Fig. 1 is a block diagram showing the configuration of a battery system according to a first embodiment;
Fig. 2 is a block diagram showing the configuration of an auxiliary circuit board of Fig. 1;
Fig. 3 is a block diagram showing the configuration of a main circuit board of Fig. 1;
Fig. 4 is an external perspective view of a battery module;
Fig. 5 is a plan view of the battery module;
Fig. 6 is an end view of the battery module;
Fig. 7 is an external perspective view of bus bars;
Fig. 8 is an external perspective view of FPC boards to which a plurality of bus bars and a plurality of PTC elements are attached;
Fig. 9 is a schematic plan view for explaining connection between the bus bars and a voltage detecting circuit;
Fig. 10 is an enlarged plan view showing a voltage/current bus bar and the FPC board;
Fig. 11 is a schematic plan view showing one example of the configuration of the auxiliary circuit board;
Fig. 12 is a schematic plan view showing one example of the configuration of the main circuit board;
Fig. 13 is a schematic plan view showing one example of connection and wiring among the battery modules;
Fig. 14 is a block diagram showing the configuration of a main circuit board in a second embodiment;
Fig. 15 is a schematic plan view showing one example of the configuration of the main circuit board in the second embodiment;
Fig. 16 is a schematic plan view showing one example of connection and wiring among battery modules in the second embodiment;
Fig. 17 is a block diagram showing the configuration of a main circuit board in a third embodiment;
Fig. 18 is a schematic plan view showing one example of the configuration of the main circuit board in the third embodiment;
Fig. 19 is a schematic plan view showing one example of connection and wiring among battery modules in the third embodiment;
Fig. 20 is a block diagram showing the configuration of a main circuit board in a fourth embodiment;
Fig. 21 is a schematic plan view showing one example of the configuration of the main circuit board in the fourth embodiment;
Fig. 22 is a schematic plan view showing one example of connection and wiring among battery modules in the fourth embodiment;
Fig. 23 is a block diagram showing the configuration of a main circuit board in a fifth embodiment;
Fig. 24 is a schematic plan view showing one example of the configuration of the main circuit board in the fifth embodiment;
Fig. 25 is a schematic plan view showing one example of connection and wiring among battery modules in the fifth embodiment;
Fig. 26 is a block diagram showing the configuration of a main circuit board in a sixth embodiment;
Fig. 27 is a schematic plan view showing one example of the configuration of the main circuit board in the sixth embodiment;
Fig. 28 is a schematic plan view showing one example of connection and wiring among battery modules in the sixth embodiment;
Fig. 29 is a schematic plan view showing one example of connection and wiring among battery modules in a seventh embodiment;
Fig. 30 is a schematic plan view showing one example of connection and wiring among battery modules in an eighth embodiment;
Fig. 31 is a schematic plan view showing one example of connection and wiring among battery modules in a ninth embodiment;
Fig. 32 is an external perspective view of an end of a battery module in a tenth embodiment;
Fig. 33 is a plan view of a battery module in an eleventh embodiment;
Fig. 34 is an external perspective view of a battery module according to a twelfth embodiment;
Fig. 35 is a plan view of the battery module of Fig. 34;
Fig. 36 is an end view of the battery module of Fig. 34;
Fig. 37 is a vertical sectional view taken along the line A-A of Fig. 35;
Fig. 38 is a diagram showing the attachment configuration of first and second printed circuit boards;
Fig. 39 is a schematic plan view of the first and second printed circuit boards;
Fig. 40 is a schematic plan view for explaining connection between the bus bars and the first printed circuit board;
Fig. 41 is an enlarged plan view showing the voltage/current bus bar and the FPC board;
Fig. 42 is a block diagram showing the configuration of a battery system using the battery module of Fig. 34;
Fig. 43 is a block diagram for explaining details of the configurations of the first and second printed circuit boards;
Fig. 44 is a schematic plan view showing a first example of arrangement of the battery system according to the twelfth embodiment;
Fig. 45 is a schematic plan view showing a second example of arrangement of the battery system according to the twelfth embodiment;
Fig. 46 is a schematic plan view showing a third example of arrangement of the battery system according to the twelfth embodiment;
Fig. 47 is a plan view of a battery module according to a thirteenth embodiment;
Fig. 48 is a schematic plan view showing an example of arrangement of a battery system according to the thirteenth embodiment;
Fig. 49 is an external perspective view of a battery module according to a fourteenth embodiment;
Fig. 50 is a diagram showing the attachment configuration of a first printed circuit board of Fig. 49;
Fig. 51 is a schematic plan view showing an example of arrangement of a battery system according to the fourteenth embodiment; and
Fig. 52 is a block diagram showing the configuration of an electric automobile including the battery system.

### [1] First Embodiment

Hereinafter, description will be made of a battery system according to a first embodiment by referring to the drawings. The battery system according to the present embodiment is mounted on an electric vehicle (an electric automobile, for example) using electric power as a driving source.

### (1) Configuration of the Battery System

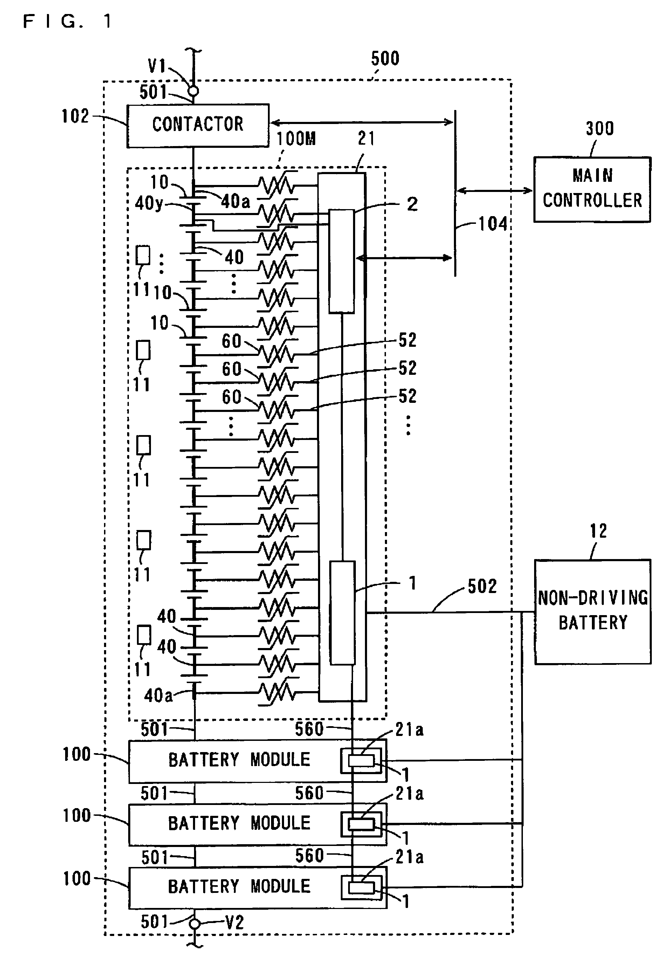

Fig. 1 is a block diagram showing the configuration of the battery system according to the first embodiment. As shown in Fig. 1, the battery system 500 includes a plurality of battery modules 100M, 100, and a contactor 102. In the present embodiment, the battery system 500 includes one battery module 100M and three battery modules 100.

The plurality of battery modules 100M, 100 of the battery system 500 are connected to one another through power supply lines 501. Each of the battery modules 100M, 100 includes a plurality of (eighteen in this example) battery cells 10 and a plurality of (five in this example) thermistors 11.

The battery module 100M includes a main circuit board 21 made of a rigid printed circuit board. Each battery module 100 includes an auxiliary circuit board 21a made of a rigid printed circuit board.

A cell characteristics detecting circuit 1 that detects cell characteristics of each battery cell 10 is mounted on each auxiliary circuit board 21 a. As well as the cell characteristics detecting circuit 1, a control-related circuit 2 having functions related to control of the plurality of battery modules 100M, 100 is mounted on the main circuit board 21.

In each of the battery module 100M, 100, the plurality of battery cells 10 are integrally arranged adjacent to one another, and are connected in series through a plurality of bus bars 40. Each battery cell 10 is a secondary battery such as a lithium-ion battery or a nickel metal hydride battery.

The battery cells 10 arranged at both ends of each of the battery modules 100M, 100 are connected to the power supply lines 501 through bus bars 40a, respectively. In this manner, all the battery cells 10 of the plurality of battery modules 100M, 100 are connected in series in the battery system 500. The power supply lines 501 pulled out from the battery system 500 are connected to a load such as a motor of the electric vehicle via voltage terminals V1, V2. Details of the battery modules 100M, 100 will be described below.

The control-related circuit 2 is connected to a main controller 300 of the electric vehicle through a bus 104. The contactor 102 is inserted in the power supply line 501 connected to the battery module 100M at one end of the battery system 500. The contactor 102 is connected to the main controller 300 through the bus 104.

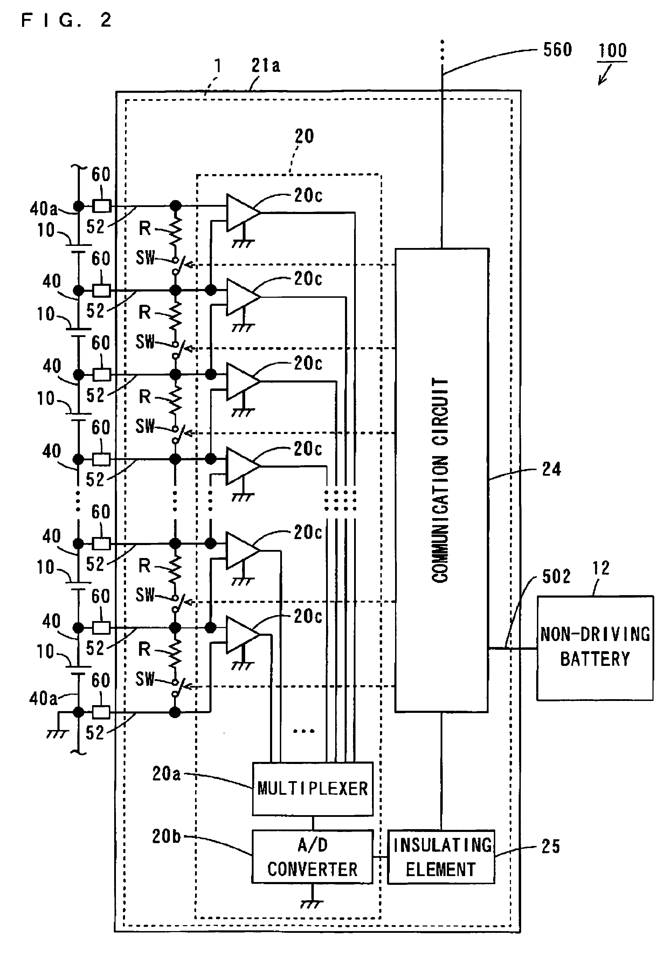

Fig. 2 is a block diagram showing the configuration of the auxiliary circuit board 21 a of Fig. 1. The auxiliary circuit board 21 a includes a voltage detecting circuit 20, a communication circuit 24, an insulating element 25, a plurality of resistors R and a plurality of switching elements SW. The voltage detecting circuit 20 includes a multiplexer 20a, an A/D (Analog/Digital) converter 20b and a plurality of differential amplifiers 20c.

The voltage detecting circuit 20 is composed of an ASIC (Application Specific Integrated Circuit), for example, and the plurality of battery cells 10 of the battery module 100 are used as a power source of the voltage detecting circuit 20. Each differential amplifier 20c of the voltage detecting circuit 20 has two input terminals and an output terminal. Each differential amplifier 20c differentially amplifies a voltage input to the two input terminals, and outputs the amplified voltage from the output terminal.

The two input terminals of each differential amplifier 20c are electrically connected to two adjacent bus bars 40, 40a through conductor lines 52 and PTC (Positive Temperature Coefficient) elements 60.

The PTC element 60 has such resistance temperature characteristics as to have a resistance value rapidly increasing when its temperature exceeds a certain value. Therefore, if a short occurs in the voltage detecting circuit 20 and the conductor line 52, for example, the temperature of the PTC element 60 that rises because of a current flowing through the short-circuited path causes the resistance value of the PTC element 60 to increase. Accordingly, a large current is inhibited from flowing through the short-circuited path including the PTC element 60.

The communication circuit 24 includes a CPU (Central Processing Unit), a memory and an interface circuit, for example, and has a communication function and an operating function. A battery 12 of the electric vehicle is connected to the communication circuit 24 through a DC-DC converter, not shown, and a power supply line 502. The battery 12 is not used as an electric power source for driving the electric vehicle. Hereinafter, the battery 12 is referred to as a non-driving battery 12. The non-driving battery 12 is used as a power source of the communication circuit 24. The non-driving battery 12 is a lead-acid battery in the present embodiment.

A series circuit composed of the resistor R and the switching element SW is connected between two adjacent bus bars 40, 40a. The main controller 300 of Fig. 1 controls the switching element SW to be turned on and off through the communication circuit 24. Note that the switching element SW is turned off in a normal state.

The voltage detecting circuit 20 and the communication circuit 24 are connected to communicate with each other while being electrically insulated from each other by the insulating element 25. A voltage between two adjacent bus bars 40, 40a is differentially amplified by each differential amplifier 20c. The output voltage from each differential amplifier 20c corresponds to a terminal voltage of each battery cell 10. The terminal voltages output from the plurality of differential amplifiers 20c are applied to the multiplexer 20a. The multiplexer 20a sequentially outputs the terminal voltages applied from the plurality of differential amplifiers 20c to the A/D converter 20b. The A/D converter 20b converts the terminal voltages output from the multiplexer 20a into digital values, and applies the digital values to the communication circuit 24 through the insulating element 25.

The communication circuit 24 is connected to the plurality of thermistors 11 of Fig. 1. This causes the communication circuit 24 to acquire the temperature of the battery module 100 based on output signals from the thermistors 11.

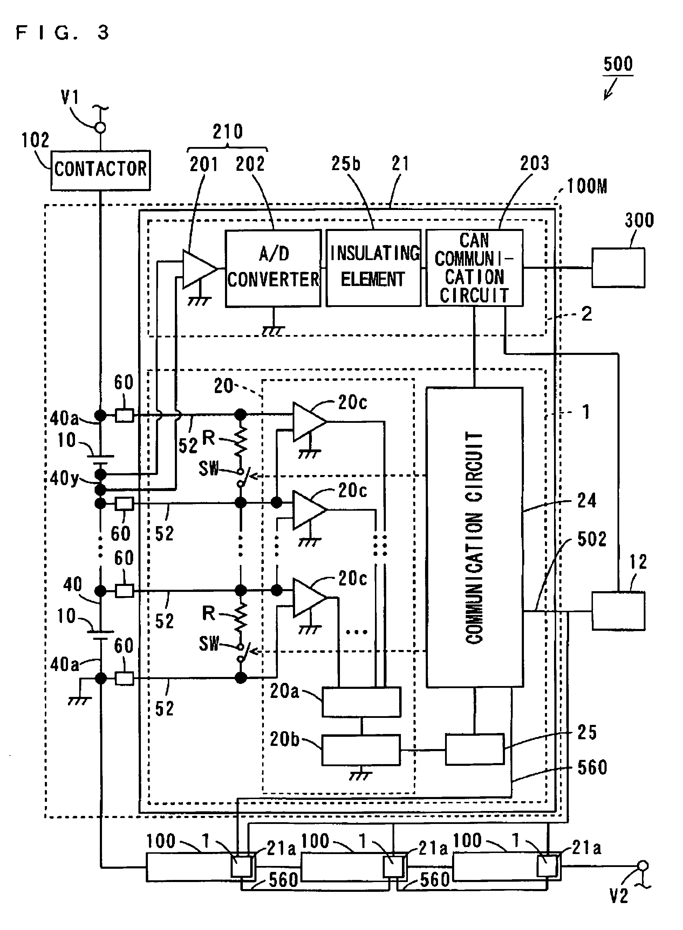

Fig. 3 is a block diagram showing the configuration of the main circuit board 21 of Fig. 1. The main circuit board 21 is different from the auxiliary circuit board 21 a in the following points.

The control-related circuit 2 as well as the cell characteristics detecting circuit 1 of Fig. 2 is mounted on the main circuit board 21. In the present embodiment, the control-related circuit 2 includes a current detecting circuit 210, an insulating element 25b and a CAN (Controller Area Network) communication circuit 203. The current detecting circuit 210 includes an amplifying circuit 201 and an A/D converter 202.

The amplifying circuit 201 of the current detecting circuit 210 amplifies a voltage between two positions obtained from one bus bar 40 (a voltage/current bus bar 40y, described below) of the battery module 100M. The A/D converter 202 converts.the output voltage from the amplifying circuit 201 into digital values, and applies the digital values to the CAN communication circuit 203 through the insulating element 25b.

The CAN communication circuit 203 includes a CPU, a memory and an interface circuit, and has a CAN communication function and an operating function. The non-driving battery 12 of the electric vehicle is connected to the CAN communication circuit 203 through a DC-DC converter, not shown. The non-driving battery 12 is used as a power source of the CAN communication circuit 203.

The CAN communication circuit 203 calculates a current flowing through the plurality of battery cells 10 based on the digital values applied from the A/D converter 202 and a resistance between two positions of the voltage/current bus bar 40y. Details of calculation of the current will be described below.

The communication circuit 24 of the cell characteristics detecting circuit 1 and the CAN communication circuit 203 of the control-related circuit 2 are connected to communicate with each other.

The control-related circuit 2 has a current detecting function for detecting the current flowing through the plurality of battery cells 10 and a communication function for performing the CAN communication as functions related to control of the battery modules 100M, 100 in the present embodiment.

As shown in Figs. 2 and 3, the communication circuit 24 of the auxiliary circuit board 21a and the communication circuit 24 of the main circuit board 21 are connected to each other through harnesses 560. This allows the communication circuit 24 of each of the battery modules 100M, 100 to communicate with the communication circuit 24 of another battery module 100M, 100.

The communication circuit 24 of each battery module 100 applies the terminal voltage of each battery cell 10 and the temperature of the battery module 100 to the communication circuit 24 of the battery module 100M. The communication circuit 24 of the battery module 100M applies the cell characteristics of the plurality of battery modules 100M, 100 to the CAN communication circuit 203. The CAN communication circuit 203 applies the cell characteristics of the plurality of battery modules 100M, 100 and the value of the current applied from the current detecting circuit 210 to the main controller 300 through the bus 104 of Fig. 1 by CAN communication.

Hereinafter, the terminal voltage, temperature and current are referred to as cell information.

The CAN communication circuit 203 calculates a charged capacity of each battery cell 10 based on the cell information, and performs charge/discharge control of each battery module 100M, 100 based on the charged capacity.

The main controller 300 detects abnormality of each battery module 100M, 100 based on the cell information. The abnormality of the battery module 100M, 100 includes overdischarge, overcharge or abnormal temperature of the battery cells 10, for example.

When detecting the abnormality of the battery module 100M, 100, the main controller 300 turns off the contactor 102. Since the current does not flow through each battery module 100M, 100 in the case of an occurrence of the abnormality, the battery modules 100M, 100 are prevented from being abnormally heated.

The main controller 300 controls power of the electric vehicle (a rotational speed of the motor, for example) based on the charged capacity of each battery module 100M, 100. When the charged capacity of each battery module 100M, 100 decreases, the main controller 300 controls a power generating system, not shown, connected to the power supply line 501 to cause each battery module 100M, 100 to be charged.

The motor connected to the power supply line 501, for example, functions as the power generating system in the present embodiment. In this case, the motor converts electric power supplied from the battery system 500 into mechanical power for driving drive wheels, not shown, at the time of acceleration of the electric vehicle. The motor generates regenerated electric power at the time of deceleration of the electric vehicle. Each battery module 100M, 100 is charged with the regenerated electric power.

### (2) Details of the Battery Module

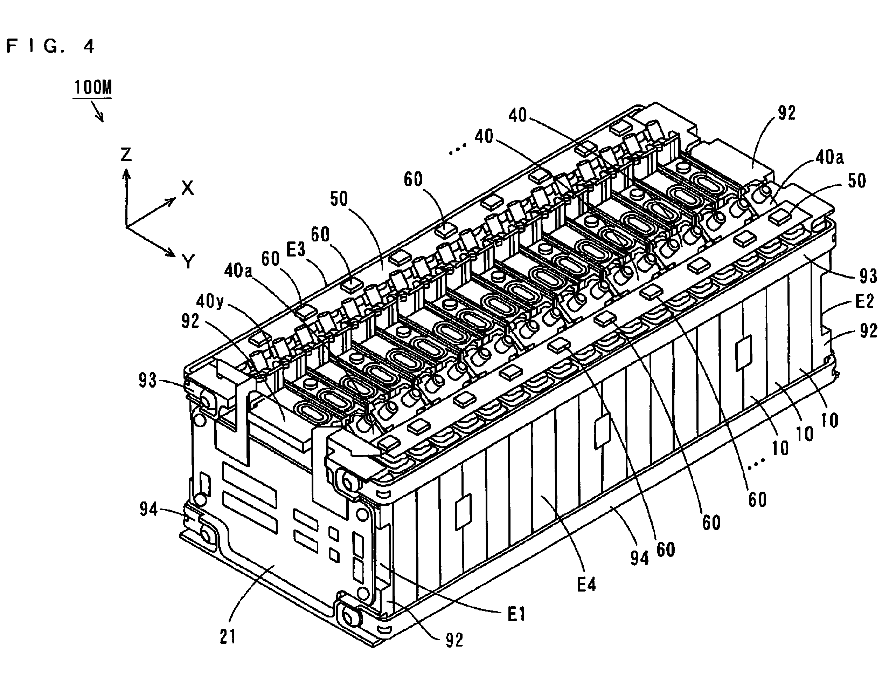

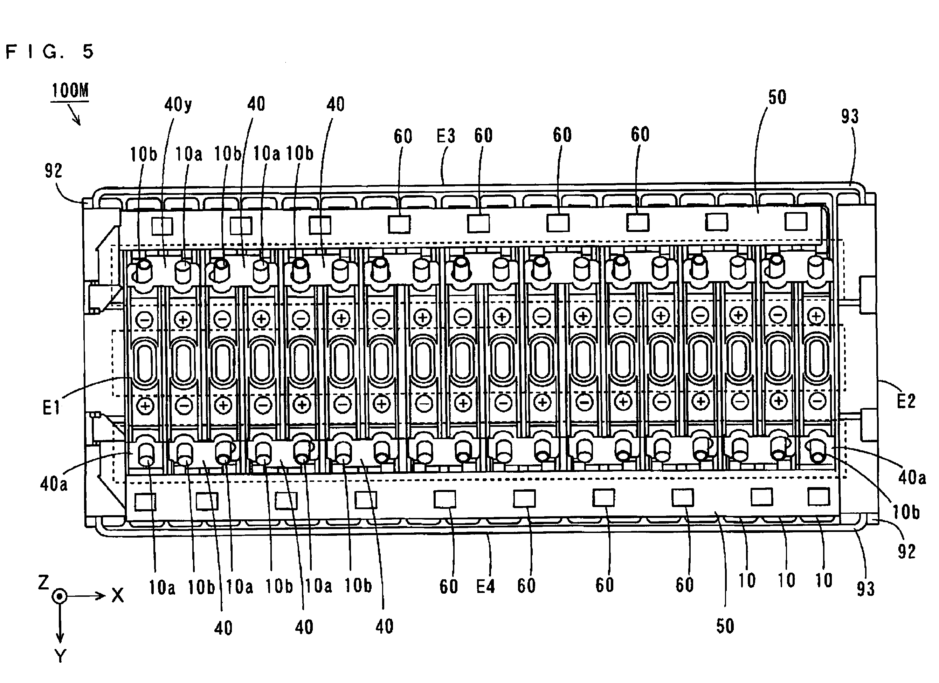

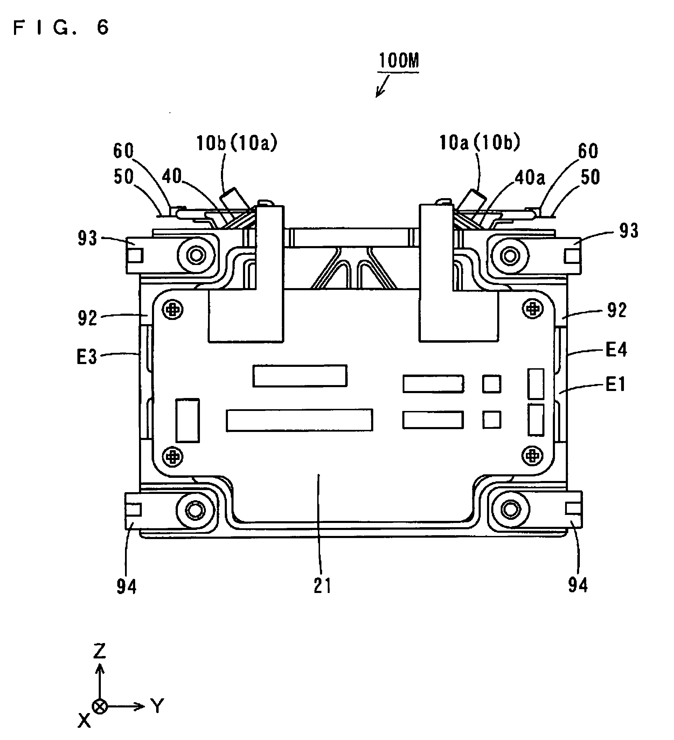

Description is made of details of the battery modules 100M, 100. Fig. 4 is an external perspective view of the battery module 100M, Fig. 5 is a plan view of the battery module 100M, and Fig. 6 is an end view of the battery module 100M. The battery modules 100 each have the same configuration as the battery module 100M except for including the auxiliary circuit board 21a instead of the main circuit board 21, and including the bus bar 40 instead of the voltage/current bus bar 40y.

In Figs. 4 to 6 and Figs.8 to 10 described below, three directions that are perpendicular to one another are defined as an X-direction, a Y-direction and a Z-direction as indicated by the arrows X, Y, Z. The X-direction and the Y-direction are parallel to a horizontal plane, and the Z-direction is perpendicular to the horizontal plane in this example. A direction in which the arrow Z points is the upward direction.

As shown in Figs. 4 to 6, the plurality of battery cells 10 each having a flat and substantially rectangular parallelepiped shape are arranged to line up in the X-direction in the battery module 100M. In this state, the plurality of battery cells 10 are integrally fixed by a pair of end surface frames 92, a pair of upper end frames 93 and a pair of lower end frames 94.

Each of the pair of end surface frames 92 has a substantially plate shape, and is arranged parallel to the Y-Z plane. The pair of upper end frames 93 and the pair of lower end frames 94 are arranged to extend in the X-direction.

Connection portions for connecting the pair of upper end frames 93 and the pair of lower end frames 94 thereto are formed at four corners of each of the pair of end surface frames 92. The pair of upper end frames 93 is attached to the upper connection portions of the pair of end surface frames 92, and the pair of lower end frames 94 is attached to the lower connection portions of the pair of end surface frames 92 while the plurality of battery cells 10 are arranged between the pair of end surface frames 92. Accordingly, the plurality of battery cells 10 are integrally fixed while being arranged to line up in the X-direction.

The battery module 100M has end surfaces E1, E2 on the pair of end surface frames 92, respectively, as end surfaces at both ends in the X-direction. The battery module 100M has side surfaces E3, E4 along the Y-direction.

The main circuit board 21 is attached to the end surface E1 of the one end surface frame 92.

Here, the plurality of battery cells 10 each have a plus electrode 10a and a minus electrode 10b arranged on an upper surface portion to line up along the Y-direction. Each of the electrodes 10a, 10b is provided to be inclined and project upward (see Fig. 6).

In the following description, the battery cell 10 adjacent to the end surface frame 92 to which the main circuit board 21 is not attached to the battery cell 10 adjacent to the end surface frame 92 to which the main circuit board 21 is attached are referred to as a first battery cell 10 to an eighteenth battery cell 10.

In the battery module 100M, the battery cells 10 are arranged such that the positional relationship between the plus electrode 10a and the minus electrode 10b of each battery cell 10 in the Y-direction is opposite to that of the adjacent battery cell 10, as shown in Fig. 5.

Thus, in two adjacent battery cells 10, the plus electrode 10a of one battery cell 10 is in close proximity to the minus electrode 10b of the other battery cell 10, and the minus electrode 10b of the one battery cell 10 is in close proximity to the plus electrode 10a of the other battery cell 10. In this state, the bus bar 40 is attached to the two electrodes being in close proximity to each other. This causes the plurality of battery cells 10 to be connected in series.

More specifically, the common bus bar 40 is attached to the plus electrode 10a of the first battery cell 10 and the minus electrode 10b of the second battery cell 10. The common bus bar 40 is attached to the plus electrode 10a of the second battery cell 10 and the minus electrode 10b of the third battery cell 10. Similarly, the common bus bar 40 is attached to the plus electrode 10a of each of the odd numbered battery cells 10 and the minus electrode 10b of each of the even numbered battery cells 10 adjacent thereto. The common bus bar 40 is attached to the plus electrode 10a of each of the even numbered battery cells 10 and the minus electrode 10b of each of the odd numbered battery cells 10 adjacent thereto.

The bus bar 40a for connecting the power supply line 501 (see Fig. 1) from the exterior is attached to each of the minus electrode 10b of the first battery cell 10 and the plus electrode 10a of the eighteenth battery cell 10.

A long-sized flexible printed circuit board (hereinafter abbreviated as an FPC board) 50 extending in the X-direction is connected in common to the plurality of bus bars 40 on the one end side of the plurality of battery cells 10 in the Y-direction. Similarly, a long-sized FPC board 50 extending in the X-direction is connected in common to the plurality of bus bars 40, 40a on the other end side of the plurality of battery cells 10 in the Y-direction.

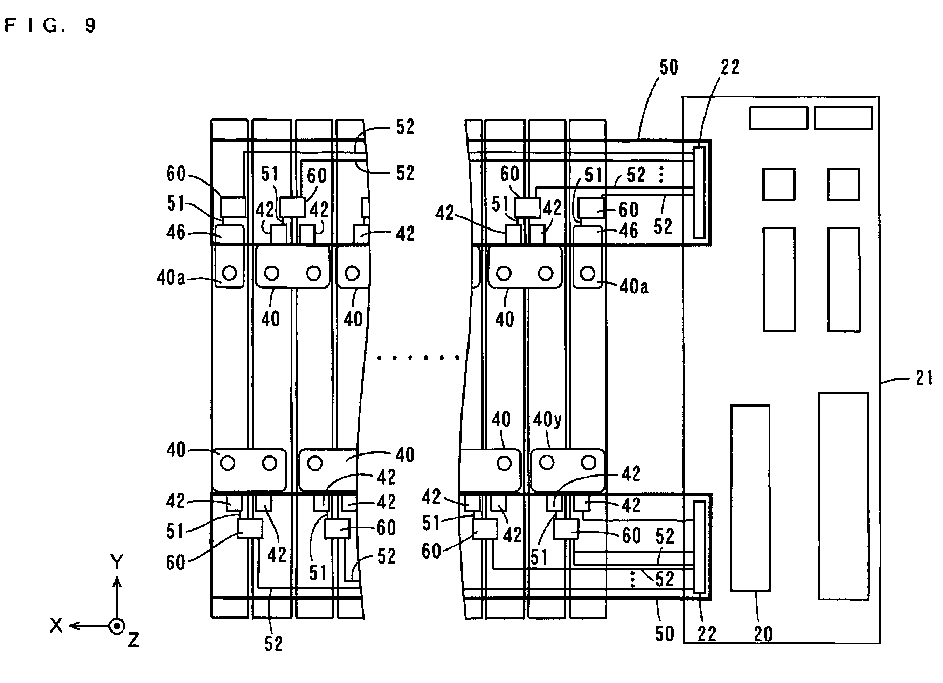

The FPC board 50 having bending characteristics and flexibility mainly includes a plurality of conductor lines 51, 52 (see Fig. 9, described below) formed on an insulating layer. Examples of the material for the insulating layer constituting the FPC board 50 include polyimide, and examples of the material for the conductor lines 51, 52 (see Fig. 9, described below) include copper. The PTC elements 60 are arranged in close proximity to the bus bars 40, 40a, respectively, on the FPC boards 50.

Each FPC board 50 is bent inward at a right angle and further bent downward at an upper end portion of the end surface frame 92 (the end surface frame 92 to which the main circuit board 21 is attached) to be connected to the main circuit board 21.

### (3) The Configurations of the Bus Bars and the FPC Boards

Next, description is made of details of the configurations of the bus bars 40, 40a and the FPC boards 50. In the following paragraphs, the bus bar 40 for connecting the plus electrode 10a and the minus electrode 10b of two adjacent battery cells 10 is referred to as the bus bar for two electrodes 40, and the bus bar 40a for connecting the plus electrode 10a or the minus electrode 10b of one battery cell 10 and the power supply line 501 is referred to as the bus bar for one electrode 40a.

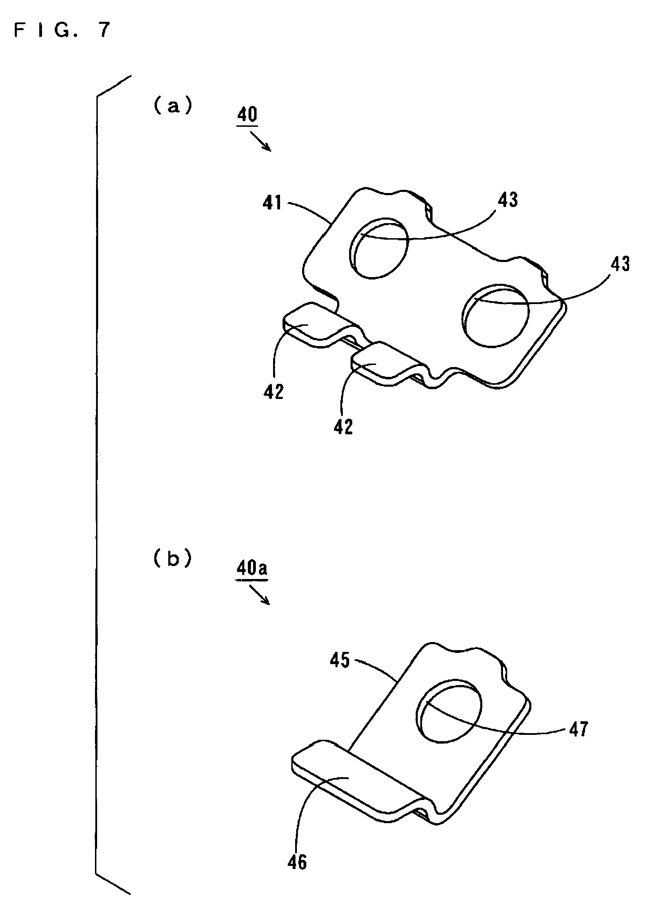

Fig. 7 (a) is an external perspective view of the bus bar for two electrodes 40, and Fig. 7 (b) is an external perspective view of the bus bar for one electrode 40a.

As shown in Fig. 7 (a), the bus bar for two electrodes 40 includes a base portion 41 having a substantially rectangular shape and a pair of attachment portions 42 that is bent and extends from one side of the base portion 41 toward one surface side. A pair of electrode connection holes 43 is formed in the base portion 41.

As shown in Fig. 7 (b), the bus bar for one electrode 40a includes a base portion 45 having a substantially square shape and an attachment portion 46 that is bent and extends from one side of the base portion 45 toward one surface side. An electrode connection hole 47 is formed in the base portion 45.

In the present embodiment, the bus bars 40, 40a are each composed of tough pitch copper having a nickel-plated surface, for example.

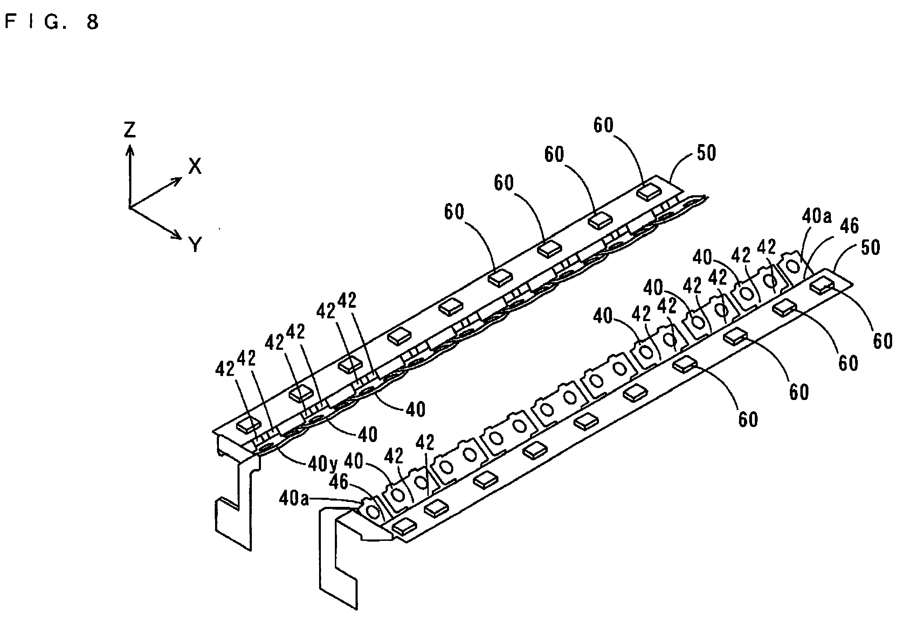

Fig. 8 is an external perspective view of the FPC boards 50 to which the plurality of bus bars 40, 40a, the voltage/current bus bar 40y and the plurality of PTC elements 60 are attached. As shown in Fig. 8, the attachment portions 42 of the plurality of bus bars 40, the attachment portion 42 of the voltage/current bus bar 40y and the attachment portions 46 of the bus bars 40a are attached to the two FPC boards 50 at spacings along the X-direction. The plurality of PTC elements 60 are attached to the two FPC boards 50 at the same spacings as the spacings between the plurality of bus bars 40, 40a and the voltage/current bus bar 40y.

The two FPC boards 50 having the plurality of bus bars 40, 40a, the voltage/current bus bar 40y and the plurality of PTC elements 60 attached thereto in the foregoing manner are attached to the plurality of battery cells 10 that are integrally fixed by the end surface frames 92 (see Fig. 4), the upper end frames 93 (see Fig. 4) and the lower end frames 94 (see Fig. 4) during the manufacture of the battery modules 100M, 100.

During the mounting, the plus electrode 10a and the minus electrode 10b of the adjacent battery cells 10 are fitted in the electrode connection holes 43 formed in each of the bus bars 40 and the voltage/current bus bar 40y. A male thread is formed at each of the plus electrodes 10a and the minus electrodes 10b. With each of the bus bars 40 and the voltage/current bus bar 40y fitted with the plus electrode 10a and minus electrode 10b of the adjacent battery cells 10, the male threads of the plus electrodes 10a and the minus electrodes 10b are screwed in nuts (not shown).

Similarly, the plus electrode 10a of the eighteenth battery cell 10 and the minus electrode 10b of the first battery cells 10 are fitted in the electrode connection holes 47 formed in the bus bars 40a, respectively. With the bus bars 40a fitted with the plus electrode 10a and minus electrode 10b, respectively, the male threads of the plus electrode 10a and the minus electrode 10b are screwed in nuts (not shown).

In this manner, the plurality of bus bars 40, 40a and the voltage/current bus bar 40y are attached to the plurality of battery cells 10 while the FPC boards 50 are held in a substantially horizontal attitude by the plurality of bus bars 40, 40a and the voltage/current bus bar 40y.

### (4) Connection between the Bus Bars and the Voltage Detecting Circuit

Description is made of connection between the bus bars 40, 40a and the voltage detecting circuit 20. Fig. 9 is a schematic plan view for explaining the connection between the bus bars 40, 40a and the voltage detecting circuit 20. In this example, description is made of the connection between the bus bars 40, 40a and the voltage detecting circuit 20 in the main circuit board 21 of the battery module 100M.

As shown in Fig. 9, each FPC board 50 is provided with the plurality of conductor lines 51, 52 that correspond to the plurality of bus bars 40, 40a, respectively. Each conductor line 51 is provided to extend parallel to the Y-direction between the attachment portion 42, 46 of the bus bar 40, 40a and the PTC element 60 arranged in the vicinity of the bus bar 40, 40a. Each conductor line 52 is provided to extend parallel to the X-direction between the PTC element 60 and one end of the FPC board 50.

One end of each conductor line 51 is provided to be exposed on a lower surface of the FPC board 50. The one end of each conductor line 51 exposed on the lower surface is electrically connected to the attachment portion 42, 46 of the bus bar 40, 40a by soldering or welding, for example. Accordingly, the FPC board 50 is fixed to each of the bus bars 40, 40a.

The other end of each conductor line 51 and one end of each conductor line 52 are provided to be exposed on an upper surface of the FPC board 50. A pair of terminals (not shown) of the PTC element 60 is connected to the other end of each conductor line 51 and the one end of each conductor line 52 by soldering, for example.

Each of the PTC elements 60 is preferably arranged in a region between both ends in the X-direction of the corresponding bus bar 40, 40a. When stress is applied to the FPC board 50, a region of the FPC board 50 between the adjacent bus bars 40, 40a is easily deflected. However, the region of the FPC board 50 between the both ends of each of the bus bars 40, 40a is kept relatively flat because it is fixed to the bus bar 40, 40a. Therefore, each of the PTC elements 60 is arranged within the region of the FPC board 50 between both the ends of each of the bus bars 40, 40a, so that connectivity between the PTC element 60 and the conductor lines 51, 52 is sufficiently ensured. Moreover, the effect of deflection of the FPC board 50 on each of the PTC elements 60 (e.g., a change in the resistance value of the PTC element 60) is suppressed.

A plurality of connection terminals 22 are provided in the main circuit board 21 corresponding to the plurality of conductor lines 52, respectively, of the FPC boards 50. The connection terminals 22 are electrically connected to the voltage detecting circuit 20. The other ends of the conductor lines 52 of the FPC boards 50 are connected to the corresponding connection terminals 22 by soldering or welding, for example. Note that the main circuit board 21 and the FPC boards 50 may not be connected by soldering or welding. For example, connecters may be used for connecting the main circuit board 21 and the FPC boards 50.

In this manner, each of the bus bars 40, 40a is electrically connected to the voltage detecting circuit 20 via the PTC element 60. This causes the terminal voltage of each battery cell 10 to be detected.

Connection between the auxiliary circuit board 21a and the FPC boards 50 of the battery module 100 is the same as the connection between the main circuit board 21 and the FPC boards 50 shown in Fig. 9 except that the connection between the voltage/current bus bar 40y and the voltage detecting circuit 20, described below, is not included.

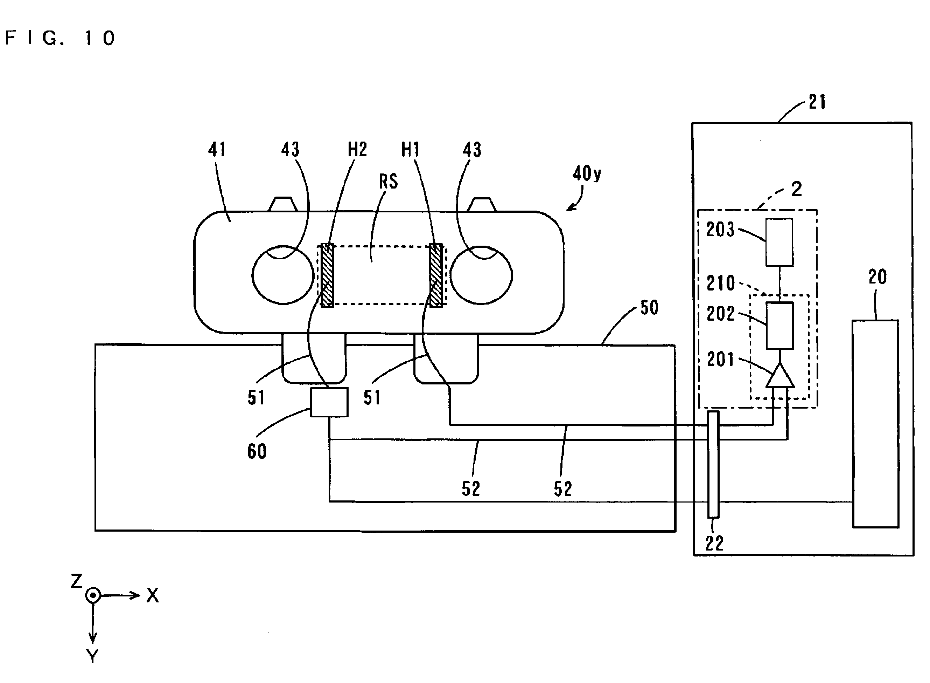

Fig. 10 is an enlarged plan view showing the voltage/current bus bar 40y and the FPC board 50 in the battery module 100M. As shown in Fig. 10, the main circuit board 21 includes the control-related circuit 2 in the battery module 100M (see Fig. 3). The control-related circuit 2 includes the current detecting circuit 210, and the current detecting circuit 210 includes the amplifying circuit 201 and the A/D converter 202.

A pair of solder traces H1, H2 is formed in parallel with each other at a regular spacing on the base portion 41 of the voltage/current bus bar 40y. The solder trace H1 is arranged between the two electrode connection holes 43 to be close to one electrode connection hole 43, and the solder trace H2 is arranged between the electrode connection holes 43 to be close to the other electrode connection hole 43. Resistance formed between the solder traces H1, H2 of the voltage/current bus bar 40y is referred to as shunt resistance RS for current detection.

The solder trace H1 of the voltage/current bus bar 40y is connected to one input terminal of the amplifying circuit 201 of the current detecting circuit 210 through the conductor lines 51, 52 and the connection terminal 22. Similarly, the solder trace H2 of the voltage/current bus bar 40y is connected to the other input terminal of the amplifying circuit 201 through the conductor line 51, the PTC element 60, the conductor line 52 and the connection terminal 22.

In the present embodiment, the memory included in the CAN communication circuit 203 previously stores a value of the shunt resistance RS between the solder traces H1, H2 of the voltage/current bus bar 40y. The CPU of the CAN communication circuit 203 detects the voltage between the solder traces H1, H2 based on the digital value output from the A/D converter 202.

The CAN communication circuit 203 calculates a value of the current flowing through the voltage/current bus bar 40y by dividing the voltage between the solder traces H1, H2 by the value of the shunt resistance RS stored in the memory. In this manner, the value of the current flowing through the plurality of battery cells 10 (see Fig. 1) is detected.

### (5) Example of the Configuration of the Printed Circuit Board

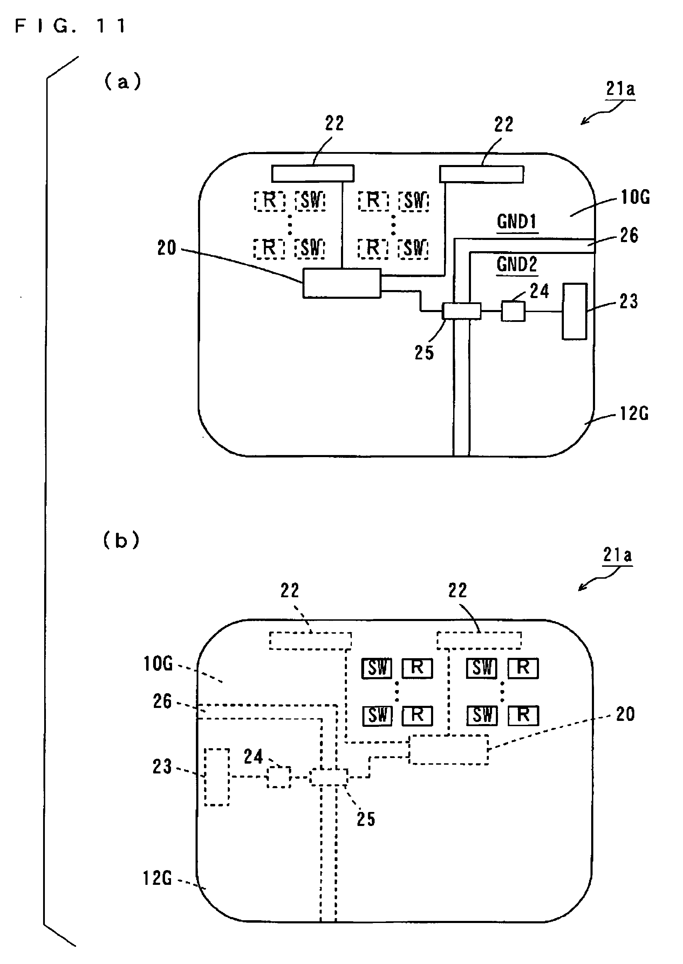

Next, description is made of one example of the configuration of the auxiliary circuit board 21a. Fig. 11 is a schematic plan view showing one example of the configuration of the auxiliary circuit board 21a. The auxiliary circuit board 21a has a substantially rectangular shape, and has one surface and the other surface. (a) and (b) in Fig. 11 show the one surface and the other surface of the auxiliary circuit board 21a, respectively.

As shown in Fig. 11 (a), the voltage detecting circuit 20, the communication circuit 24 and the insulating element 25 are mounted on the one surface of the auxiliary circuit board 21a. In addition, the connection terminals 22 and a connector 23 are formed on the one surface of the auxiliary circuit board 21a. As shown in Fig. 11 (b), the plurality of resistors R and the plurality of switching elements SW are mounted on the other surface of the auxiliary circuit board 21a.

The plurality of resistors R on the other surface of the auxiliary circuit board 21a are arranged above a position corresponding to the voltage detecting circuit 20. This allows heat generated in the resistors R to be efficiently released. Moreover, the heat generated in the resistors R can be prevented from being transmitted to the voltage detecting circuit 20. This prevents an occurrence of malfunctions and deterioration of the voltage detecting circuit 20 to be caused by heat.

The auxiliary circuit board 21a has a first mounting region 10G, a second mounting region 12G and a strip-shaped insulating region 26.

The second mounting region 12G is formed at one corner of the auxiliary circuit board 21a. The insulating region 26 is formed to extend along the second mounting region 12G. The first mounting region 10G is formed in the remaining part of the auxiliary circuit board 21a. The first mounting region 10G and the second mounting region 12G are separated from each other by the insulating region 26. Thus, the first mounting region 10G and the second mounting region 12G are electrically insulated from each other by the insulating region 26.

The voltage detecting circuit 20 is mounted and the connection terminals 22 are formed on the first mounting region 10G. The voltage detecting circuit 20 and each connection terminal 22 are electrically connected through a connecting line on the auxiliary circuit board 21a. The plurality of battery cells 10 (see Fig. 1) of the battery module 100 are connected to the voltage detecting circuit 20 as the power source of the voltage detecting circuit 20. A ground pattern GND1 is formed on part of the first mounting region 10G not including the mounting region of the voltage detecting circuit 20, the formation regions of the connection terminals 22 and the formation region of the connecting line. The ground pattern GND1 is held at a reference potential of the battery module 100.

The communication circuit 24 is mounted and the connector 23 is formed on the second mounting region 12G, and the communication circuit 24 and the connector 23 are electrically connected through a plurality of connecting lines on the auxiliary circuit board 21a. The harness 560 of Fig. 1 is connected to the connector 23. The non-driving battery 12 (see Fig. 1) included in the electric vehicle is connected to the communication circuit 24 as the power source of the communication circuit 24. A ground pattern GND2 is formed on part of the second mounting region 12G not including the mounting region of the communication circuit 24, the formation region of the connector 23 and the formation region of the plurality of connecting lines. The ground pattern GND2 is held at a reference potential of the non-driving battery 12.

The insulating element 25 is mounted over the insulating region 26. The insulating element 25 electrically insulates the ground pattern GND1 and the ground pattern GND2 from each other while transmitting a signal between the voltage detecting circuit 20 and the communication circuit 24. For example, a digital isolator, a photocoupler or the like can be used as the insulating element 25. In the present embodiment, a digital isolator is used as the insulating element 25.

In this manner, the voltage detecting circuit 20 and the communication circuit 24 are electrically insulated from each other while being connected to communicate with each other by the insulating element 25. Thus, the plurality of battery cells 10 can be used as the power source of the voltage detecting circuit 20, and the non-driving battery 12 (see Fig. 1) can be used as the power source of the communication circuit 24. As a result, each of the voltage detecting circuit 20 and the communication circuit 24 can be stably and independently operated.

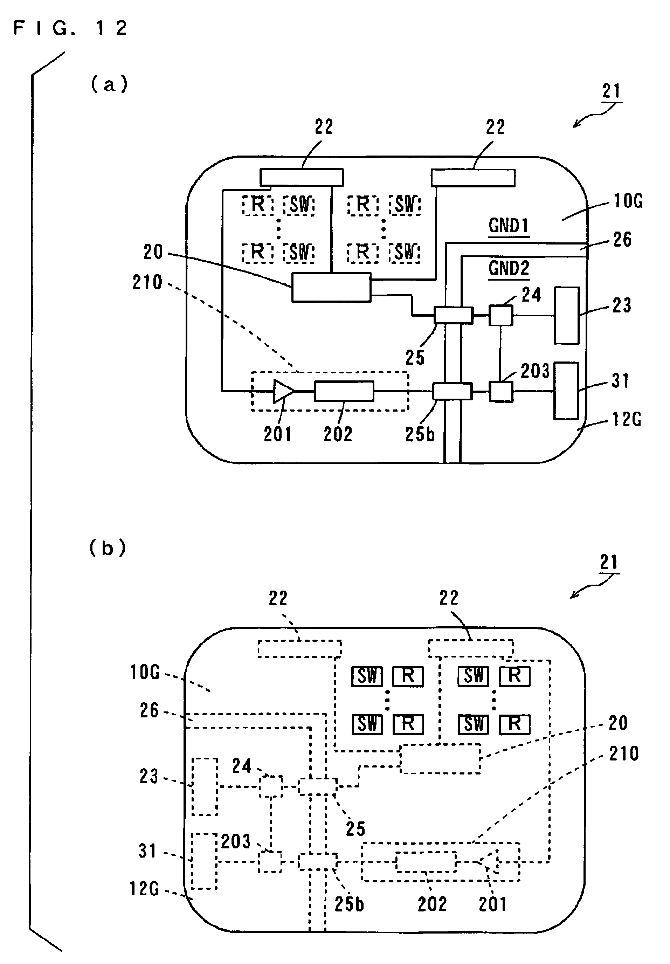

Next, description is made of one example of the configuration of the main circuit board 21. The main circuit board 21 is described by referring to differences from the auxiliary circuit board 21 a. Fig. 12 is a schematic plan view showing one example of the configuration of the main circuit board 21. The main circuit board 21 has a substantially rectangular shape, and has one surface and the other surface. (a) and (b) in Fig. 12 show the one surface and the other surface of the main circuit board 21, respectively.

As shown in Fig. 12 (a), the voltage detecting circuit 20, the communication circuit 24, the insulating element 25, the current detecting circuit 210, the insulating element 25b and the CAN communication circuit 203 are mounted on the one surface of the main circuit board 21. The connection terminals 22 and the connectors 23, 31 are formed on the one surface of the main circuit board 21. As shown in Fig. 12 (b), the plurality of resistors R and the plurality of switching elements SW are mounted on the other surface of the main circuit board 21.

Similarly to the auxiliary circuit board 21 a, the plurality of resistors R on the other surface of the main circuit board 21 are arranged above a position corresponding to the voltage detecting circuit 20. This allows heat generated in the resistors R to be efficiently released. Moreover, the heat generated in the resistors R can be prevented from being transmitted to the voltage detecting circuit 20. This prevents an occurrence of malfunctions and deterioration of the voltage detecting circuit 20 to be caused by heat.

The connection terminals 22 are arranged in the vicinity of an upper end of the main circuit board 21. This reduces the length of each of the FPC boards 50 (see Fig. 10) connected to the connection terminals 22.

In addition to the voltage detecting circuit 20 and the connection terminals 22, the current detecting circuit 210 is formed on the first mounting region 10G, and the current detecting circuit 210 and the connection terminal 22 are electrically connected through connecting lines on the main circuit board 21. The plurality of battery cells 10 (see Fig. 1) of the battery module 100 are connected to the current detecting circuit 210 as a power source of the current detecting circuit 210. The ground pattern GND1 is formed on part of the first mounting region 10G not including the mounting regions of the voltage detecting circuit 20 and the current detecting circuit 210, the formation regions of the connection terminals 22 and the formation region of the connecting lines. The ground pattern GND1 is held at the reference potential of the battery module 100.

In addition to the communication circuit 24 and the connector 23, the CAN communication circuit 203 and the connector 31 are formed on the second mounting region 12G, and the CAN communication circuit 203 and the connector 31 are electrically connected through a plurality of connecting lines on the main circuit board 21. The connector 31 is connected to the bus 104 of Fig. 1. The non-driving battery 12 (see Fig. 1) included in the electric vehicle is connected to the CAN communication circuit 203 as the power source of the CAN communication circuit 203. The ground pattern GND2 is formed on part of the second mounting region 12G not including the mounting regions of the communication circuit 24 and the CAN communication circuit 203, the formation regions of the connectors 23, 31 and the formation region of the plurality of connecting lines. The ground pattern GND2 is held at the reference potential of the non-driving battery 12.

The insulating element 25b is mounted over the insulating region 26. The insulating element 25b electrically insulates the ground pattern GND1 and the ground pattern GND2 from each other while transmitting a signal between the current detecting circuit 210 and the CAN communication circuit 203. For example, a digital isolator, a photocoupler or the like can be used as the insulating element 25b. In the present embodiment, a digital isolator is used as the insulating element 25b.

### (6) Equalization of Voltages of the Battery Cells

The CAN communication circuit 203 calculates the charged capacity of each battery cell 10 from the cell information of each battery cell 10 in the battery modules 100M, 100. Here, when detecting that a charged capacity of one battery cell 10 is larger than each of charged capacities of the other battery cells 10, the CAN communication circuit 203 turns on the switching element SW (see Figs. 2 and 3) connected to the battery cell 10 having the larger charged capacity through the communication circuit 24.

Thus, charges stored in the battery cell 10 are discharged through the resistor R (see Figs. 2 and 3). When the charged capacity of the battery cell 10 decreases to be substantially equal to each of the charged capacities of the other battery cells 10, the CAN communication circuit 203 turns off the switching element SW connected to the battery cell 10.

In this manner, charged capacities of all the battery cells 10 are kept substantially equal. This prevents part of the battery cells 10 from being excessively charged or discharged. As a result, deterioration of the battery cells 10 can be prevented.

The plurality of resistors R are distributed to be provided on the main circuit board 21 and the plurality of auxiliary circuit boards 21 a. This allows heat generated by discharge of the battery cells 10 of the plurality of battery modules 100M, 100 to be efficiently released. This prevents deterioration of the cell characteristics detecting circuit 1 and the control-related circuit 2 of the main circuit board 21 and the cell characteristics detecting circuits 1 of the auxiliary circuit boards 21a.

### (7) Connection and Wiring among the Battery Modules

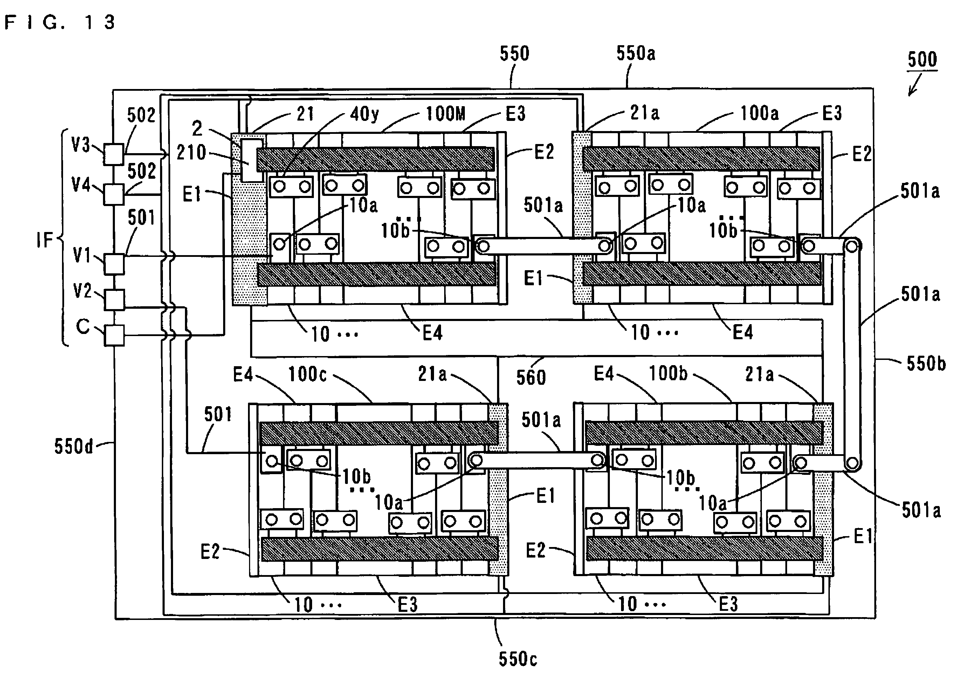

Next, description is made of connection and wiring among the battery modules 100M, 100. Fig. 13 is a schematic plan view showing one example of connection and wiring among the battery modules 100M, 100.

As shown in Fig. 13, the three battery modules 100 are referred to as battery modules 100a, 100b, 100c for distinction.

The main circuit board 21 and the voltage/current bus bar 40y are provided in the battery module 100M. The auxiliary circuit boards 21a are provided in the battery modules 100a to 100c, respectively.

A casing 550 has side walls 550a, 550b, 550c, 550d. The side walls 550a, 550c are parallel to each other, and the side walls 550b, 550d are parallel to each other and perpendicular to the side walls 550a, 550c. The four battery modules 100M, 100a to 100c are arranged to form two rows and two columns within the casing 550.

More specifically, the end surface E2 of the battery module 100M and the end surface E1 of the battery module 100a are arranged to face each other, and the end surface E1 of the battery module 100c and the end surface E2 of the battery module 100b are arranged to face each other. The side surface E4 of the battery module 100M and the side surface E4 of the battery module 100c are arranged to face each other, and the side surface E4 of the battery module 100a and the side surface E4 of the battery module 100b are arranged to face each other. The end surface E1 of the battery module 100M and the end surface E2 of the battery module 100c are arranged to be directed to the side wall 550d, and the end surface E2 of the battery module 100a and the end surface E1 of the battery module 100b are arranged to be directed to the side wall 550b. An external interface IF including a communication terminal C and voltage terminals V1 to V4 is provided on the side wall 550d.

The communication circuit 24 (see Fig. 3) of the main circuit board 21 and the communication circuits 24 (see Fig. 2) of the auxiliary circuit boards 21a are connected to one another through the harnesses 560. A minus electrode 10b having the lowest potential in the battery module 100M and a plus electrode 10a having the highest potential in the battery module 100a are connected through a bus bar 501 a. A minus electrode 10b having the lowest potential in the battery module 100a and a plus electrode 10a having the highest potential in the battery module 100b are connected through a bus bar 501a. A minus electrode 10b having the lowest potential in the battery module 100b and a plus electrode 10a having the highest potential in the battery module 100c are connected through a bus bar 501 a.

A plus electrode 10a having the highest potential in the battery module 100M is connected to the voltage terminal V1 through the power supply line 501. A minus electrode 10b having the lowest potential in the battery module 100c is connected to the voltage terminal V2 through the power supply line 501. In this case, the motor or the like of the electric vehicle is connected between the voltage terminals V1, V2, so that electric power generated in the battery modules 100M, 100a to 100c connected in series can be supplied to the motor or the like.

The CAN communication circuit 203 of the control-related circuit 2 of the main circuit board 21 is connected to the main controller 300 of Fig. 1 through the bus 104 via the communication terminal C. This allows the CAN communication circuit 203 of the main circuit board 21 and the main controller 300 to communicate with each other.

The DC-DC converter, not shown, of the main circuit board 21 is connected to the non-driving battery 12 of Fig. 1 through the power supply line 502 via the voltage terminals V3, V4. This causes the electric power to be supplied to the communication circuit 24 and the CAN communication circuit 203 of the main circuit board 21 (see Fig. 3).

The DC-DC converter, not shown, of the auxiliary circuit board 21 a is connected to the non-driving battery 12 of Fig. 1 through the power supply line 502 via the voltage terminals V3, V4. This causes the electric power to be supplied to the communication circuit (see Fig. 2) of the auxiliary circuit board 21a.

### (8) Effects

In the battery system 500 according to the present embodiment, the main circuit board 21 provided in the battery module 100M includes the control-related circuit 2, and the control-related circuit 2 includes the current detecting circuit 210. Thus, charge/discharge of the battery modules 100M, 100 is controlled based on the current detected by the current detecting circuit 210 of the control-related circuit 2.

Therefore, a current detecting unit for detecting the current flowing through the battery modules 100M, 100 need not be separately provided in the battery system 500. This allows wiring of the battery system 500 to be simplified and allows the battery system 500 to be reduced in size.

The main controller 300 may not have the current detecting function, thus reducing burdens on the processing of the main controller 300.

The main circuit board 21 including the control-related circuit 2 is provided in the battery module 100M having the voltage/current bus bar 40y. That is, the main circuit board 21 having the current detecting circuit 210 is arranged closer than the auxiliary circuit boards 21a to the voltage/current bus bar 40y. This shortens the wiring connecting the control-related circuit 2 and the voltage/current bus bar 40y.

The main circuit board 21 is composed of the common rigid printed circuit board including the cell characteristics detecting circuit 1 and the control-related circuit 2. In this case, the wiring between the cell characteristics detecting circuit 1 and the control-related circuit 2 can be formed on the main circuit board 21. This allows the wiring of the battery system 500 to be further simplified and allows the battery system 500 to be further reduced in size.

### [2] Second Embodiment

Description will be made of a battery system according to a second embodiment by referring to differences from the battery system 500 according to the first embodiment.

### (1) Configuration of Main Circuit Board

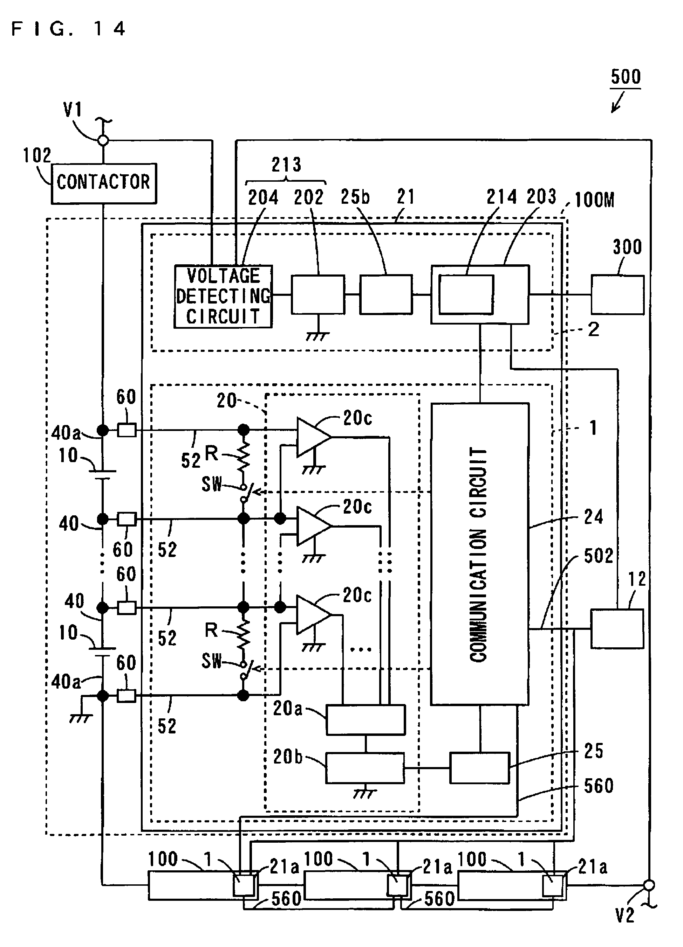

Fig. 14 is a block diagram showing the configuration of a main circuit board 21 according to the second embodiment. Similarly to the first embodiment, the control-related circuit 2 as well as the cell characteristics detecting circuit 1 of Fig. 2 is mounted on the main circuit board 21. In the present embodiment, the control-related circuit 2 includes a total voltage detecting circuit 213, the insulating element 25b and a CAN communication circuit 203. The total voltage detecting circuit 213 includes a voltage detecting circuit 204 and the A/D converter 202, and the CAN communication circuit 203 includes an electric leakage detecting circuit 214.

In the present embodiment, the control-related circuit 2 has a total voltage detecting function for detecting the total voltage of the battery system 500 and an electric leakage detecting function for detecting the presence/absence of electric leakage in the battery system 500 as functions related to control of the battery modules 100M, 100.

The voltage detecting circuit 204 of the total voltage detecting circuit 213 includes a voltage-dividing circuit and an amplifying circuit, and divides and amplifies a difference between a voltage at the voltage terminal V1 and a voltage at the voltage terminal V2 (a voltage difference between the plus electrode having the highest potential and the minus electrode having the lowest potential in the battery system 500; hereinafter referred to as a total voltage). The A/D converter 202 converts the output voltage from the voltage detecting circuit 204 into digital values, and applies the digital values to the CAN communication circuit 203 through the insulating element 25b.

The CAN communication circuit 203 calculates a value of the total voltage of the battery system 500 based on the digital values applied from the A/D converter 202. The electric leakage detecting circuit 214 detects the presence/absence of electric leakage in the battery system 500 based on the calculated value of the total voltage.

The CAN communication circuit 203 applies an electric leakage detecting signal indicating the value of the total voltage and the presence/absence of electric leakage to the main controller 300 through the bus 104 of Fig. 1 by the CAN communication.

### (2) Example of the Configuration of the Main Circuit Board

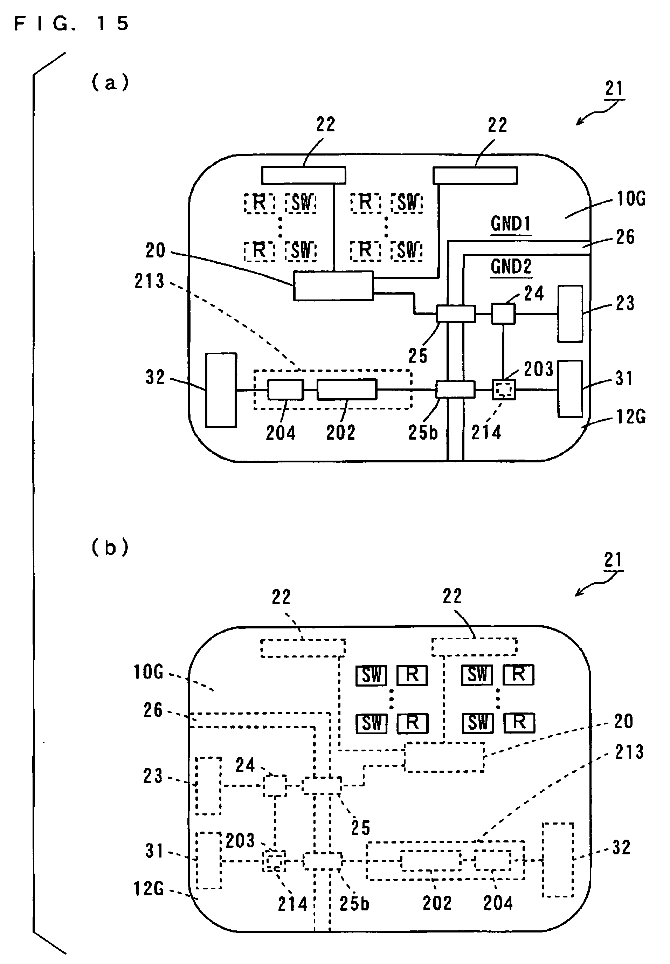

Next, description is made of one example of the configuration of the main circuit board 21. Fig. 15 is a schematic plan view showing the one example of the configuration of the main circuit board 21 in the present embodiment. (a) and (b) in Fig. 15 show one surface and the other surface of the main circuit board 21, respectively.

The main circuit board 21 of Fig. 15 is different from the main circuit board 21 of Fig. 12 in the following points.

As shown in Fig. 15 (a), the total voltage detecting circuit 213 instead of the current detecting circuit 210 of Fig. 12 (a), and the CAN communication circuit 203 including the electric leakage detecting circuit 214 instead of the CAN communication circuit 203 of Fig. 12 (a) are mounted on the one surface of the main circuit board 21. In addition, a connector 32 is formed on the mounting region 10G on the one surface of the main circuit board 21. As shown in Fig. 15 (b), the configuration of the other surface of the main circuit board 21 is the same as that of the main circuit board 21 shown in Fig. 12 (b).

The total voltage detecting circuit 213 and the connector 32 are electrically connected through a plurality of connecting lines on the main circuit board 21. The connector 32 is connected to the voltage terminals V1, V2 of Fig. 14. The plurality of battery cells 10 (see Fig. 1) of the battery module 100 are connected to the total voltage detecting circuit 213 as the power source of the total voltage detecting circuit 213.

### (3) Connection and Wiring among the Battery Modules

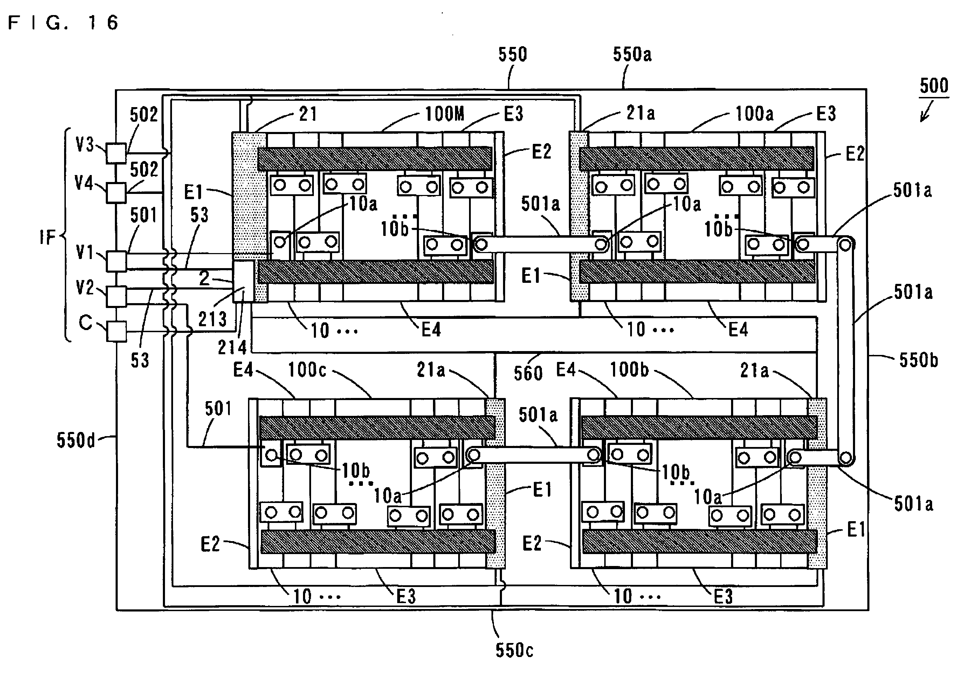

Next, description is made of connection and wiring among the battery modules 100M, 100. Fig. 16 is a schematic plan view showing one example of connection and wiring among the battery modules 100M, 100 in the present embodiment.

As shown in Fig. 16, the three battery modules 100 are referred to as the battery modules 100a, 100b, 100c for distinction. The four battery modules 100M, 100a to 100c are arranged to form two rows and two columns within the casing 550. The external interface IF including the communication terminal C and the voltage terminals V1 to V4 is provided on the side wall 550d of the casing 550. Connection and wiring among the battery modules 100M, 100a to 100c and the voltage terminals V1 to V4 are the same as those in the first embodiment.

In the present embodiment, one input terminal of the voltage detecting circuit 204 (see Fig. 14) of the total voltage detecting circuit 213 and the voltage terminal V1 are connected through a conductor line 53. The other input terminal of the voltage detecting circuit 204 (see Fig. 14) of the total voltage detecting circuit 213 and the voltage terminal V2 are connected through a conductor line 53. The CAN communication circuit 203 including the electric leakage detecting circuit 214 is connected to the main controller 300 of Fig. 1 through the bus 104 via the communication terminal C.

### (4) Effects

In the battery system 500 according to the present embodiment, the main circuit board 21 provided in the battery module 100M includes the control-related circuit 2, and the control-related circuit 2 includes the total voltage detecting circuit 213 and the electric leakage detecting circuit 214. Thus, the contactor 102 is controlled to be turned on and off based on the total voltage detected by the total voltage detecting circuit 213 of the control-related circuit 2 and the presence/absence of electric leakage detected by the electric leakage detecting circuit 214 of the control-related circuit 2.

Accordingly, a total voltage detecting unit for detecting the total voltage and an electric leakage detecting unit for detecting the presence/absence of electric leakage need not be separately provided in the battery system 500. This allows the wiring of the battery system 500 to be simplified and allows the battery system 500 to be reduced in size.

The main controller 300 may not have the total voltage detecting function and the electric leakage detecting function, thus reducing burdens on the processing of the main controller 300.

The main circuit board 21 provided in the battery module 100M is arranged in the vicinity of the voltage terminals V1, V2 and the communication terminal C. That is, the main circuit board 21 including the total voltage detecting circuit 213 and the electric leakage detecting circuit 214 is arranged closer than the auxiliary circuit boards 21a to the voltage terminals V1, V2 and the communication terminal C. This shortens the wiring (conductor lines 53) connecting the control-related circuit 2 and the voltage terminals V1, V2 and the wiring connecting the control related circuit 2 and the communication terminal C.

### [3] Third Embodiment

Description will be made of a battery system according to a third embodiment by referring to differences from the battery system 500 according to the first embodiment.

### (1) Configuration of Main Circuit Board

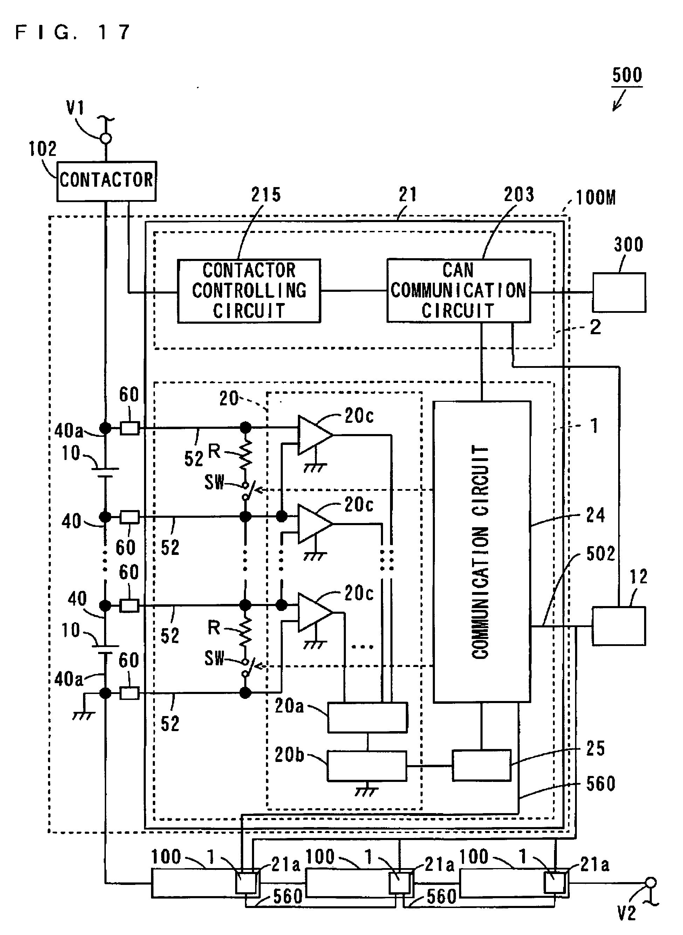

Fig. 17 is a block diagram showing the configuration of a main circuit board 21 in the third embodiment. Similarly to the first embodiment, the control-related circuit 2 as well as the cell characteristics detecting circuit 1 of Fig. 2 is mounted on the main circuit board 21. In the present embodiment, the control-related circuit 2 includes a contactor controlling circuit 215 and the CAN communication circuit 203.

In the present embodiment, the control-related circuit 2 has a contactor controlling function for controlling the contactor 102 to be turned on and off as a function related to control of the battery modules 100M, 100.

The main controller 300 applies the cell information of the plurality of battery modules 100M, 100 to the contactor controlling circuit 215 through the CAN communication circuit 203. The contactor controlling circuit 215 controls the contactor 102 to be turned on and off based on the cell information of the battery modules 100M, 100.

### (2) Example of the Configuration of the Main Circuit Board

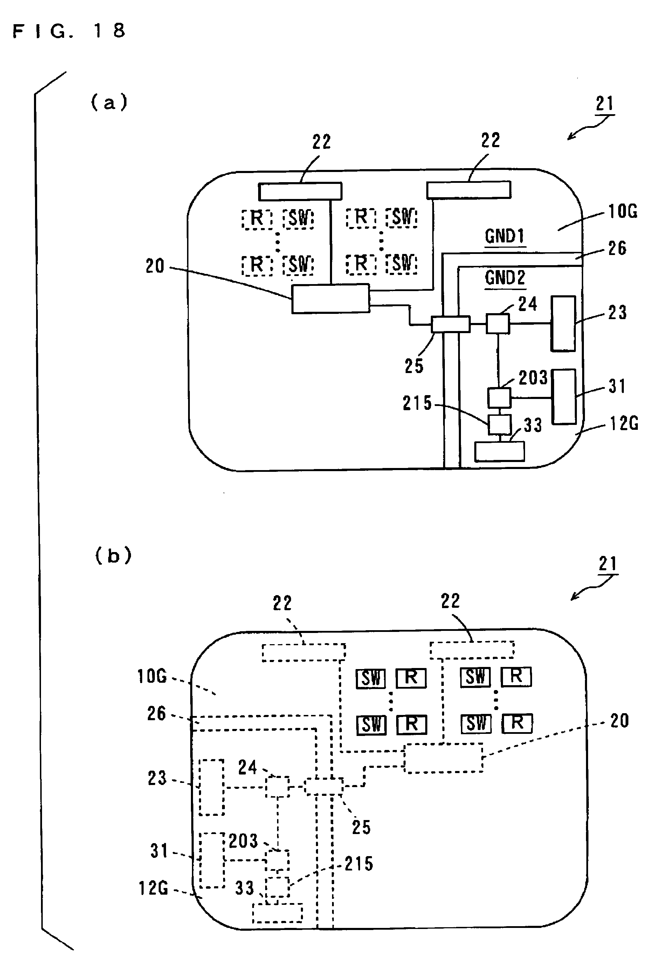

Next, description is made of one example of the configuration of the main circuit board 21. Fig. 18 is a schematic plan view showing the one example of the configuration of the main circuit board 21 in the third embodiment. (a) and (b) in Fig. 18 show one surface and the other surface of the main circuit board 21 ,respectively.

The main circuit board 21 of Fig. 18 is different from the main circuit board 21 of Fig. 12 in the following points.

As shown in Fig. 18 (a), the current detecting circuit 210 and the insulating element 25b of Fig. 12 (a) are not mounted on the one surface of the main circuit board 21, and the contactor controlling circuit 215 is additionally mounted on the second mounting region 12G on the one surface of the main circuit board 21. Moreover, a connector 33 is formed on the second mounting region 12G on the one surface of the main circuit board 21. As shown in Fig. 18 (b), the configuration of the other surface of the main circuit board 21 is the same as that of the main circuit board 21 shown in Fig. 12 (b).

The contactor controlling circuit 215 and the CAN communication circuit 203 are electrically connected through a plurality of connecting lines on the main circuit board 21. The contactor controlling circuit 215 and the connector 33 are electrically connected through a plurality of connecting lines on the main circuit board 21. The connector 33 is connected to the contactor 102 of Fig 17. The non-driving battery 12 (see Fig. 1) is connected to the contactor controlling circuit 215 as a power source of the contactor controlling circuit 215.

### (3) Connection and Wiring among the Battery Modules

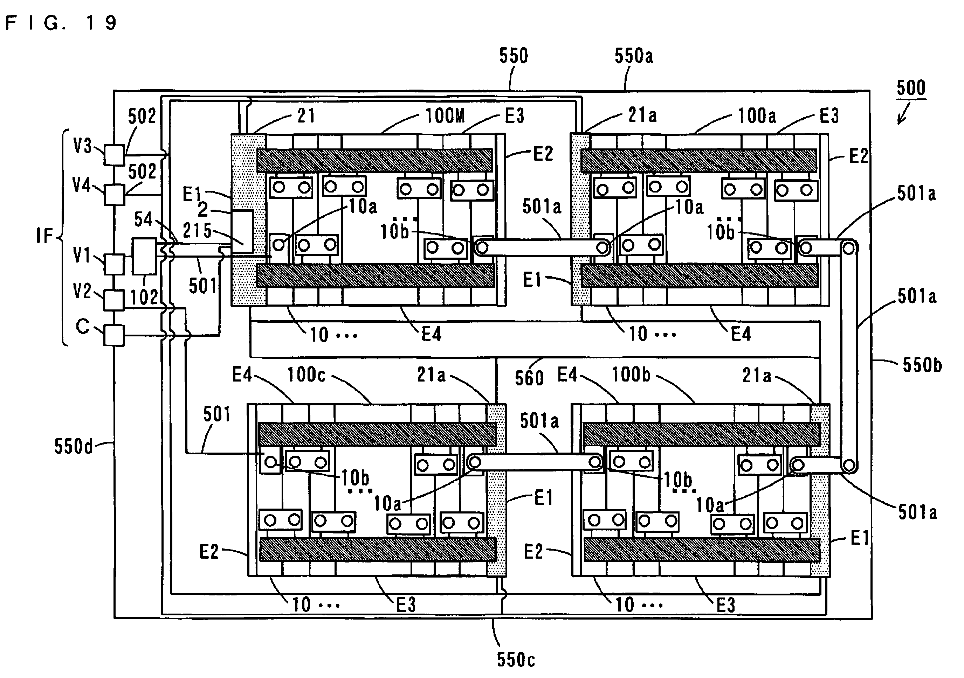

Next, description is made of connection and wiring among the battery modules 100M, 100. Fig. 19 is a schematic plan view showing one example of connection and wiring among the battery modules 100M, 100 in the present embodiment.

As shown in Fig. 19, the three battery modules 100 are referred to as the battery modules 100a, 100b, 100c for distinction. The four battery modules 100M, 100a to 100c are arranged to form two rows and two columns within the casing 550. The external interface IF including the communication terminal C and the voltage terminals V1 to V4 is provided on the side wall 550d of the casing 550.

Connection and wiring among the battery modules 100M, 100a to 100c, the communication terminal C and the voltage terminals V1 to V4 are the same as those in the first embodiment except that the contactor 102 is inserted between the plus electrode 10a having the highest potential in the battery module 100M and the voltage terminal V1.

The contactor controlling circuit 215 is connected to the contactor 102 by a conductor line 54 in the present embodiment. Accordingly, the control-related circuit 2 can control the contactor 102 to be turned on and off.

### (4) Effects

In the battery system 500 according to the present embodiment, the main circuit board 21 provided in the battery module 100M includes the control-related circuit 2, and the control-related circuit 2 includes the contactor controlling circuit 215. Thus, the contactor 102 is controlled to be turned on and off.

Accordingly, a contactor controlling unit need not be separately provided in the battery system 500. This allows the wiring of the battery system 500 to be simplified and allows the battery system 500 to be reduced in size.

The main controller 300 may not have the contactor controlling function, thus reducing burdens on the processing of the main controller 300.

The main circuit board 21 provided in the battery module 100M is arranged in the vicinity of the contactor 102. That is, the main circuit board 21 including the contactor controlling circuit 215 is arranged closer than the auxiliary circuit boards 21a to the contactor 102. This shortens the wiring (conductor line 54) connecting the control-related circuit 2 and the contactor 102.

### [4] Fourth Embodiment

Description will be made of a battery system according to a fourth embodiment by referring to differences from the battery system 500 according to the first embodiment.

### (1) Configuration of Main Circuit Board

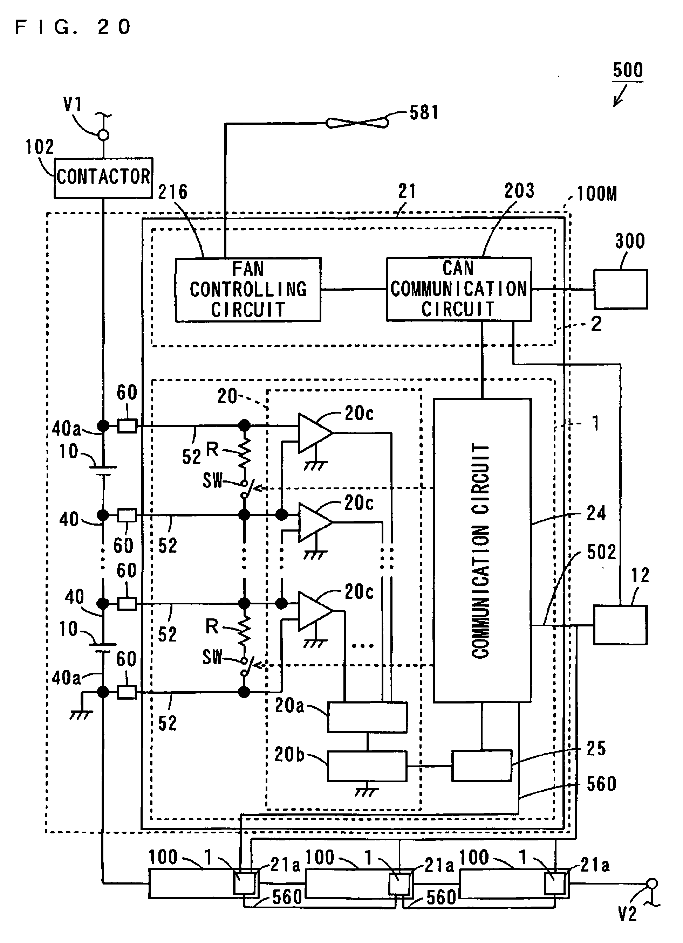

Fig. 20 is a block diagram showing the configuration of a main circuit board 21 in the fourth embodiment. Similarly to the first embodiment, the control-related circuit 2 as well as the cell characteristics detecting circuit 1 of Fig. 2 is mounted on the main circuit board 21. In the present embodiment, the control-related circuit 2 includes a fan controlling circuit 216 and the CAN communication circuit 203.

As shown in Fig. 20, the battery system 500 further includes a fan 581 for releasing heat from the battery modules 100M, 100 in the present embodiment. The control-related circuit 2 has a fan controlling function for controlling the fan 581 to be turned on and off or controlling a rotational speed of the fan 581 as a function related to control of the battery modules 100M, 100.

The main controller 300 applies the cell information of the plurality of battery modules 100M, 100 to the fan controlling circuit 216 through the CAN communication circuit 203. The fan controlling circuit 216 controls the fan 581 to be turned on and off or controls the rotational speed of the fan 581 based on the cell information of the battery modules 100M, 100.

### (2) Example of the Configuration of the Main Circuit Board

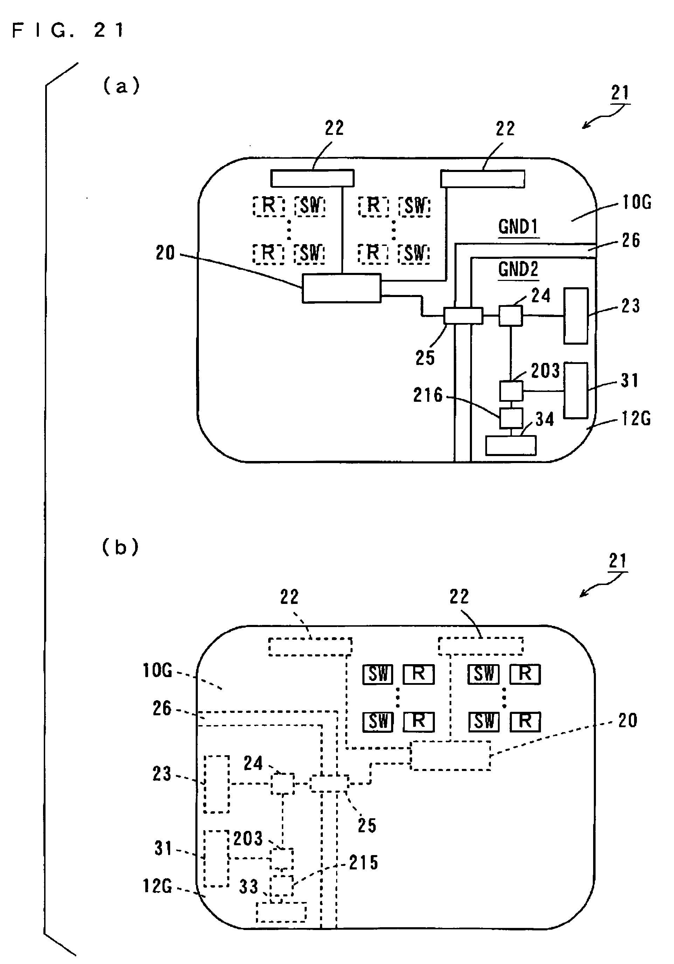

Next, description is made of one example of the configuration of the main circuit board 21. Fig. 21 is a schematic plan view showing the one example of the configuration of the main circuit board 21 in the fourth embodiment. (a) and (b) in Fig. 21 show one surface and the other surface of the main circuit board 21, respectively.

The main circuit board 21 of Fig. 21 is different from the main circuit board 21 of Fig. 12 in the following points.

As shown in Fig. 21 (a), the current detecting circuit 210 and the insulating element 25b of Fig. 12 (a) are not mounted on the one surface of the main circuit board 21, and the fan controlling circuit 216 is additionally mounted on the second mounting region 12G on the one surface of the main circuit board 21. Moreover, a connector 34 is formed on the second mounting region 12G on the one surface of the main circuit board 21. As shown in Fig. 21 (b), the configuration of the other surface of the main circuit board 21 is the same as that of the main circuit board 21 shown in Fig. 12 (b).

The fan controlling circuit 216 and the CAN communication circuit 203 are electrically connected through a plurality of connecting lines on the main circuit board 21. The fan controlling circuit 216 and the connector 34 are electrically connected through a plurality of connecting lines on the main circuit board 21. The connector 34 is connected to the fan 581 of Fig. 20. The non-driving battery 12 (see Fig. 1) is connected to the fan controlling circuit 216 as a power source of the fan controlling circuit 216.

### (3) Connection and Wiring among the Battery Modules

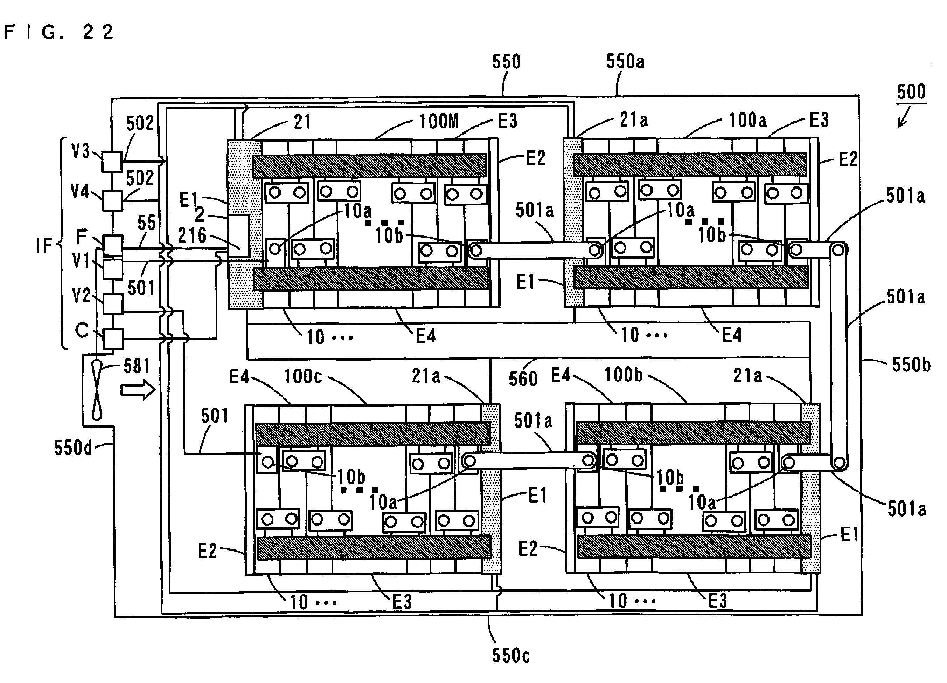

Next, description is made of connection and wiring among the battery modules 100M, 100. Fig. 22 is a schematic plan view showing one example of connection and wiring among the battery modules 100M, 100 in the present embodiment.

As shown in Fig. 22, the three battery modules 100 are referred to as the battery modules 100a, 100b, 100c for distinction. The four battery modules 100M, 100a to 100c are arranged to form two rows and two columns within the casing 550. The external interface IF including the communication terminal C and the voltage terminals V1 to V4 is provided on the side wall 550d of the casing 550. Connection and wiring among the battery modules 100M, 100a to 100c, the communication terminal C and the voltage terminals V1 to V4 are the same as those in the first embodiment.

In the present embodiment, a fan terminal F is additionally provided in the external interface IF. The fan 581 is connected to the fan terminal F. The fan controlling circuit 216 is connected to the fan terminal F by a conductor line 55. Accordingly, the control-related circuit 2 can control the fan 581 to be turned on and off or control the rotational speed of the fan 581.

### (4) Effects

In the battery system 500 according to the present embodiment, the main circuit board 21 provided in the battery module 100M includes the control-related circuit 2, and the control-related circuit 2 includes the fan controlling circuit 216. Thus, the fan 581 is controlled to be turned on and off or the rotational speed of the fan 581 is controlled.

Accordingly, a fan controlling unit need not be separately provided in the battery system 500. This allows the wiring of the battery system 500 to be simplified and allows the battery system 500 to be reduced in size.

The main controller 300 may not have the fan controlling function, thus reducing burdens on the processing of the main controller 300.

The main circuit board 21 provided in the battery module 100M is arranged in the vicinity of the fan terminal F. That is, the main circuit board 21 including the fan controlling circuit 216 is arranged closer than the auxiliary circuit boards 21 a to the fan terminal F. This shortens the wiring (conductor line 55) connecting the control-related circuit 2 and the fan terminal F.

### [5] Fifth Embodiment

Description will be made of a battery system according to a fifth embodiment by referring to differences from the battery system 500 according to the first embodiment.

### (1) Configuration of Main Circuit Board

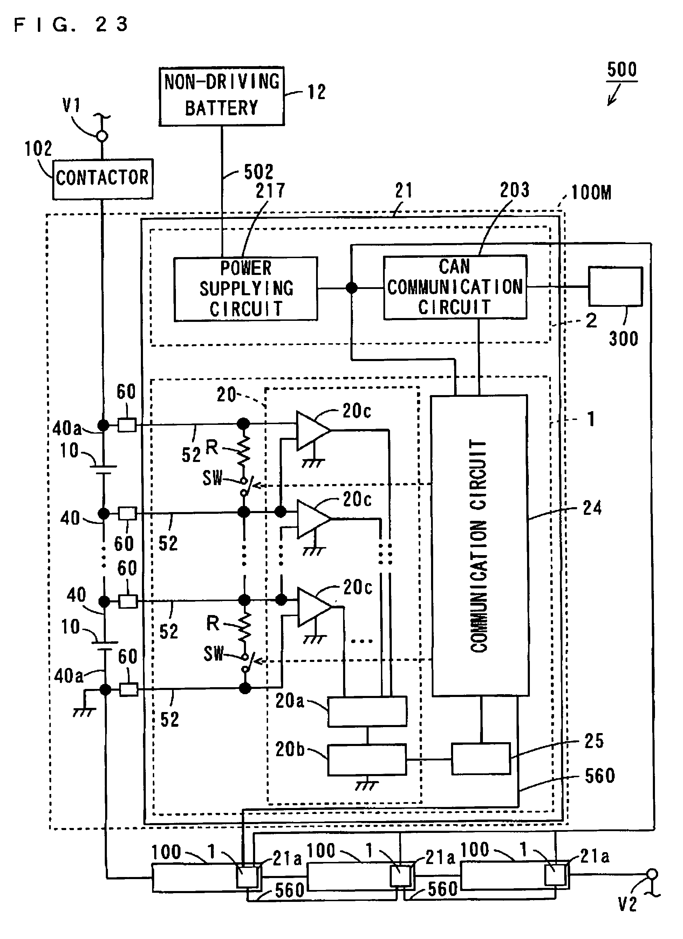

Fig. 23 is a block diagram showing the configuration of a main circuit board 21 in the fifth embodiment. Similarly to the first embodiment, the control-related circuit 2 as well as the cell characteristics detecting circuit 1 of Fig. 2 is mounted on the main circuit board 21. In the present embodiment, the control-related circuit 2 includes a power supplying circuit 217 and the CAN communication circuit 203.

In the present embodiment, the control-related circuit 2 has a power supplying function for supplying electric power to the CAN communication circuit 203 of the battery module 100M and the communication circuits 24 of the battery modules 100M, 100 as a function related to control of the battery modules 100M, 100.

The power supplying circuit 217 includes a DC-DC converter, and steps down the voltage output from the non-driving battery 12. The stepped down voltage is applied to the CAN communication circuit 203 and the communication circuit 24 of the battery module 100M and the communication circuits 24 of the battery modules 100.

### (2) Example of the Configuration of the Main Circuit Board

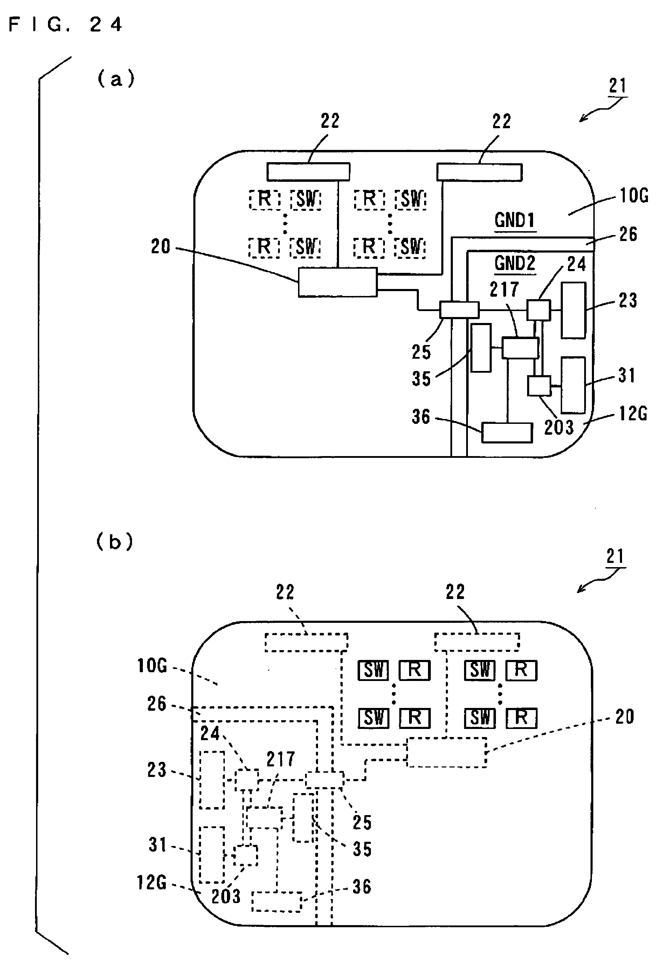

Next, description is made of one example of the configuration of the main circuit board 21. Fig. 24 is a schematic plan view showing the one example of the configuration of the main circuit board 21 in the fifth embodiment. (a) and (b) in Fig. 24 show one surface and the other surface of the main circuit board 21, respectively.

The main circuit board 21 of Fig. 24 is different from the main circuit board 21 of Fig. 12 in the following points.

As shown in Fig. 24 (a), the current detecting circuit 210 and the insulating element 25b of Fig. 12 (a) are not mounted on the one surface of the main circuit board 21, and the power supplying circuit 217 is additionally mounted on the second mounting region 12G on the one surface of the main circuit board 21. Moreover, connectors 35, 36 are formed on the second mounting region 12G on the one surface of the main circuit board 21. As shown in Fig. 24 (b), the configuration of the other surface of the main circuit board 21 is the same as that of the main circuit board 21 shown in Fig. 12 (b).

The power supplying circuit 217 and the CAN communication circuit 203 are electrically connected through a plurality of connecting lines on the main circuit board 21. The power supplying circuit 217 and the communication circuit 24 are electrically connected through a plurality of connecting lines on the main circuit board 21. The power supplying circuit 217 and the connector 36 are electrically connected through a plurality of connecting lines on the main circuit board 21. The connector 35 is connected to the non-driving battery 12 of Fig 23. The connector 36 is connected to the auxiliary circuit board 21a of each battery module 100 of Fig. 23.

### (3) Connection and Wiring among the Battery Modules

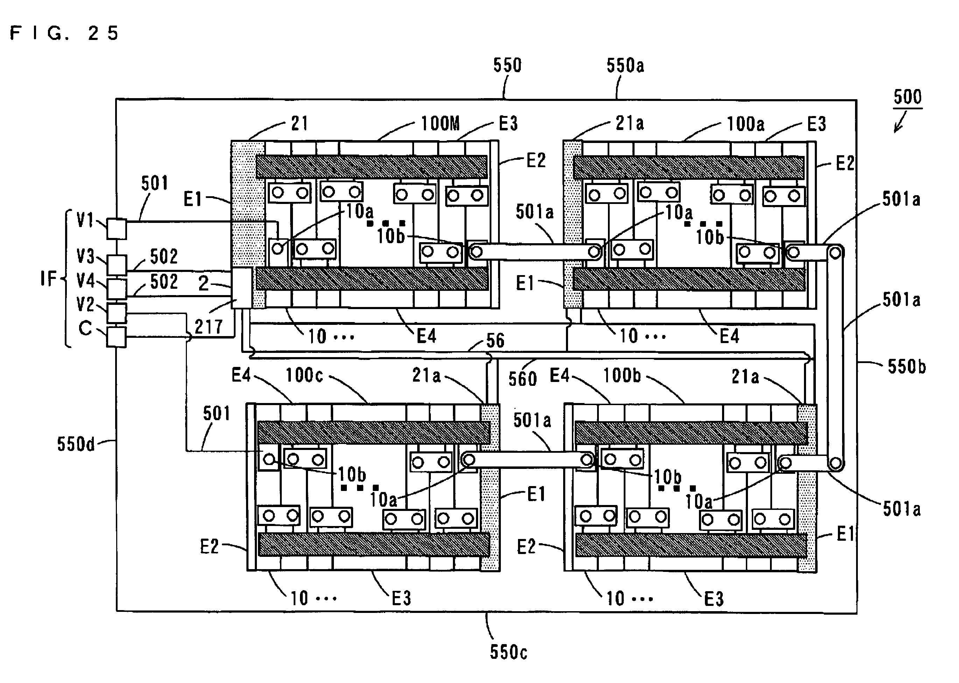

Next, description is made of connection and wiring among the battery modules 100M, 100. Fig. 25 is a schematic plan view showing one example of connection and wiring among the battery modules 100M, 100 in the present embodiment.

As shown in Fig. 25, the three battery modules 100 are referred to as the battery modules 100a, 100b, 100c for distinction. The four battery modules 100M, 100a to 100c are arranged to form two rows and two columns within the casing 550. The external interface IF including the communication terminal C and the voltage terminals V1 to V4 is provided on the side wall 550d of the casing 550. Connection and wiring among the battery modules 100M, 100a to 100c, the communication terminal C and the voltage terminals V1, V2 are the same as those in the first embodiment.

In the present embodiment, the non-driving battery 12 of Fig. 23 is connected to the voltage terminals V3, V4. The connector 35 (see Fig. 24) of the power supplying circuit 217 is connected to the voltage terminals V3, V4 by the power supply lines 502. The connector 36 (see Fig. 24) of the power supplying circuit 217 is connected to the auxiliary circuit board 21a of each battery module 100 by conductor lines 56. Accordingly, the power supplying circuit 217 can supply electric power to the CAN communication circuit 203 and the communication circuit 24 of the battery module 100M and the communication circuits 24 of the battery modules 100.

### (4) Effects

In the battery system 500 according to the present embodiment, the main circuit board 21 provided in the battery module 100M includes the control-related circuit 2, and the control-related circuit 2 includes the power supplying circuit 217. Thus, electric power is supplied to the CAN communication circuit 203 of the battery module 100M and the communication circuits 24 of the battery modules 100M, 100.

Accordingly, a power supplying unit need not be separately provided in each auxiliary circuit board 21a. This allows the wiring of the battery system 500 to be simplified and allows the battery system 500 to be reduced in size.

The main circuit board 21 provided in the battery module 100M is arranged in the vicinity of the voltage terminals V3, V4. That is, the main circuit board 21 including the power supplying circuit 217 is arranged closer than the auxiliary circuit boards 21 a to the voltage terminals V3, V4. This shortens the wiring (power supply lines 502) connecting the control-related circuit 2 and the voltage terminals V3, V4.

### [6] Sixth Embodiment

Description will be made of a battery system according to a sixth embodiment by referring to differences from the battery system 500 according to the first embodiment.

### (1) Configuration of Main Circuit Board

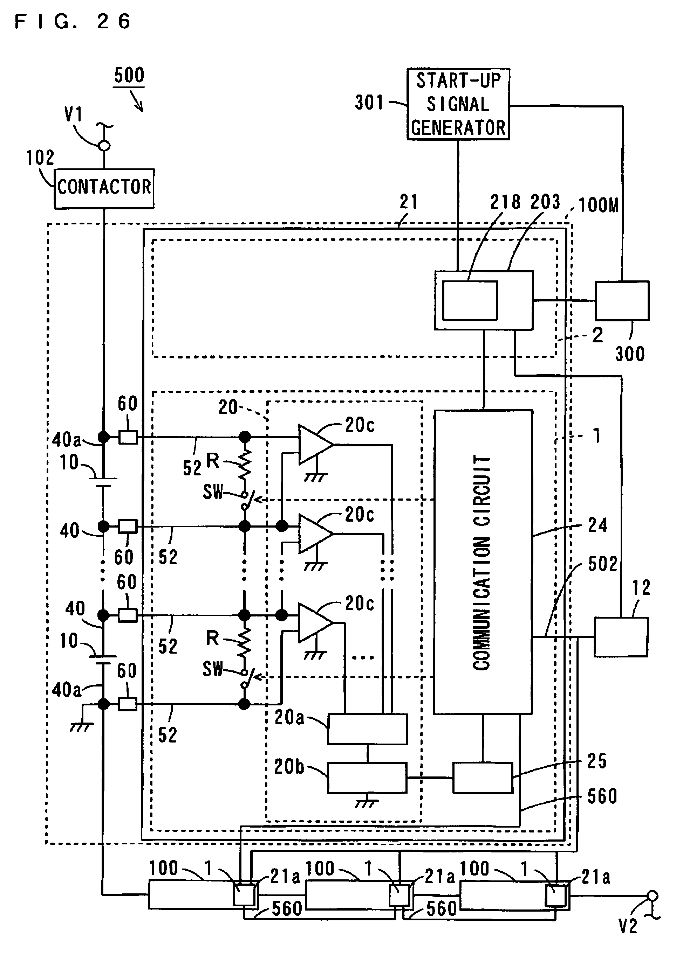

Fig. 26 is a block diagram showing the configuration of a main circuit board 21 in the sixth embodiment. Similarly to the first embodiment, the control-related circuit 2 as well as the cell characteristics detecting circuit 1 of Fig. 2 is mounted on the main circuit board 21. In the present embodiment, the control-related circuit 2 includes a CAN communication circuit 203. The CAN communication circuit 203 includes a vehicle start-up detecting circuit 218.

As shown in Fig. 26, the electric vehicle includes a start-up signal generator 301 that generates a start-up signal at the time of start-up. The control-related circuit 2 has a vehicle start-up detecting function for detecting the start-up of the electric vehicle as a function related to control of the battery modules 100M, 100.

The vehicle start-up detecting circuit 218 detects the start-up signal generated by the start-up signal generator 301. When the start-up signal is detected, the CAN communication circuit 203 starts up the communication circuits 24 of the battery modules 100M, 100.

### (2) Example of the Configuration of the Main Circuit Board

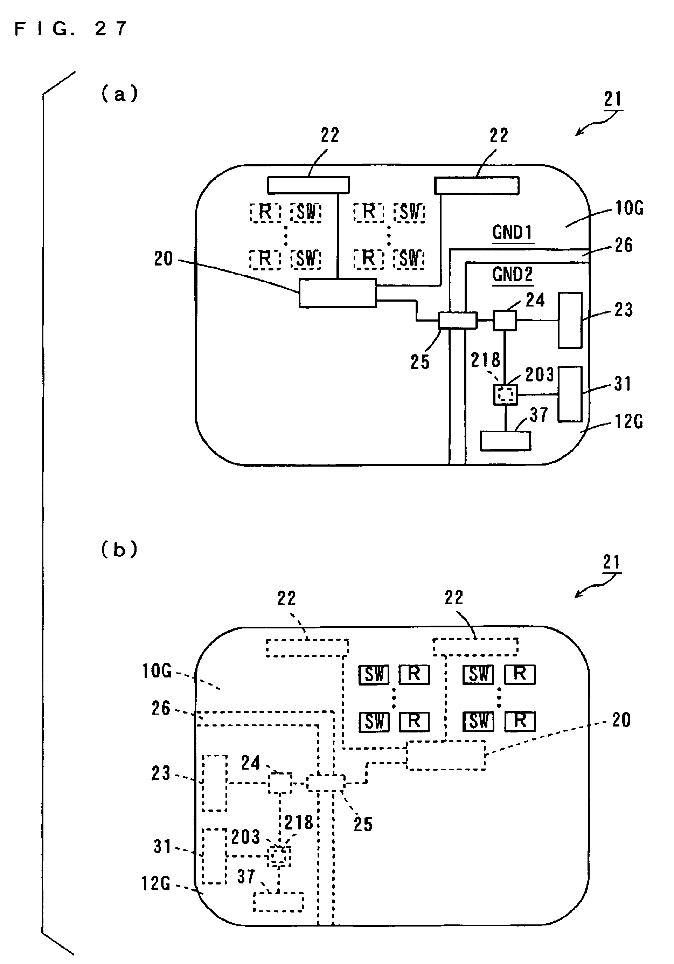

Next, description is made of one example of the configuration of the main circuit board 21. Fig. 27 is a schematic plan view showing the one example of the configuration of the main circuit board 21 in the sixth embodiment. (a) and (b) in Fig. 27 show one surface and the other surface of the main circuit board 21, respectively.

The main circuit board 21 of Fig. 27 is different from the main circuit board 21 of Fig. 12 in the following points.

As shown in Fig. 27 (a), the current detecting circuit 210 and the insulating element 25b of Fig. 12 (a) are not mounted on the one surface of the main circuit board 21, and the CAN communication circuit 203 including the vehicle start-up detecting circuit 218 instead of the CAN communication circuit 203 of Fig. 3 (a) is mounted on the second mounting region 12G on the one surface of the main circuit board 21. Moreover, a connector 37 is additionally formed on the second mounting region 12G on the one surface of the main circuit board 21. As shown in Fig. 27 (b), the configuration of the other surface of the main circuit board 21 is the same as that of the main circuit board 21 shown in Fig. 12 (b).

The CAN communication circuit 203 and the connector 37 are electrically connected through a plurality of connecting lines on the main circuit board 21. The connector 37 is connected to the start-up signal generator 301 of Fig. 26.

### (3) Connection and Wiring among the Battery Modules

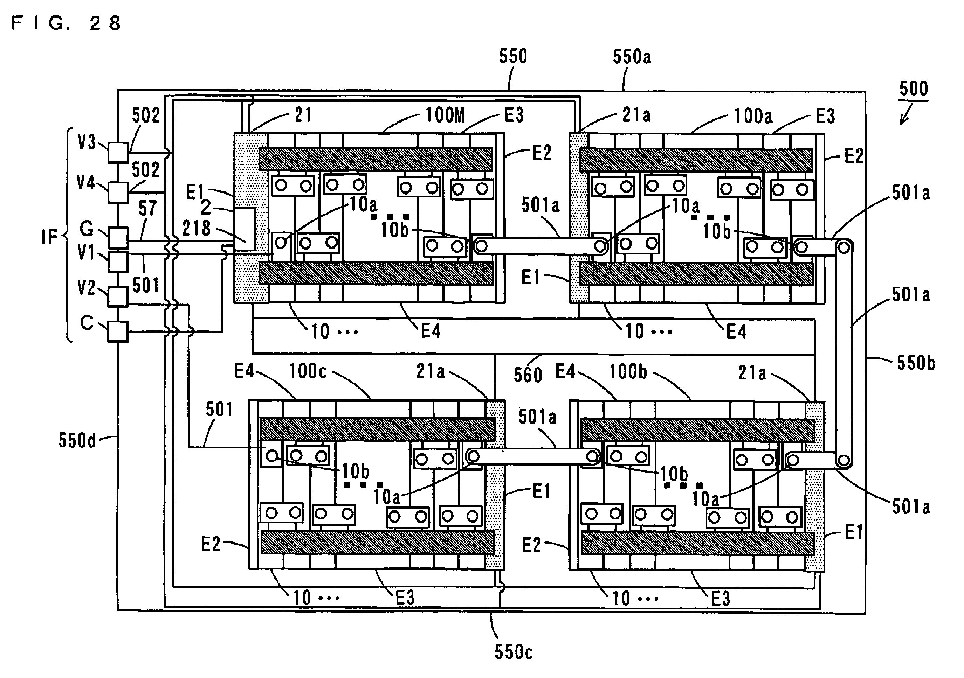

Next, description is made of connection and wiring among the battery modules 100M, 100. Fig. 28 is a schematic plan view showing one example of connection and wiring among the battery modules 100M, 100 in the present embodiment.

As shown in Fig. 28, the three battery modules 100 are referred to as the battery modules 100a, 100b, 100c for distinction. The four battery modules 100M, 100a to 100c are arranged to form two rows and two columns within the casing 550. The external interface IF including the communication terminal C and the voltage terminals V1 to V4 is provided on the side wall 550d of the casing 550. Connection and wiring among the battery modules 100M, 100a to 100c, the communication terminal C and the voltage terminals V1 to V4 are the same as those in the first embodiment.

In the present embodiment, a vehicle start-up terminal G is additionally provided in the external interface IF. The start-up signal generator 301 of Fig. 26 is connected to the vehicle start-up terminal G. The vehicle start-up detecting circuit 218 is connected to the vehicle start-up terminal G by a conductor line 57. Accordingly, the vehicle start-up detecting circuit 218 can detect the start-up detecting signal.

### (4) Effects

In the battery system 500 according to the present embodiment, the main circuit board 21 provided in the battery module 100M includes the control-related circuit 2, and the control-related circuit 2 includes the vehicle start-up detecting circuit 218. Thus, the start-up of the electric vehicle is detected.

Accordingly, a vehicle start-up detecting unit need not be separately provided in the battery system 500. This allows the wiring of the battery system 500 to be simplified and allows the battery system 500 to be reduced in size.

The main circuit board 21 provided in the battery module 100M is arranged in the vicinity of the vehicle start-up terminal G. That is, the main circuit board 21 including the vehicle start-up detecting circuit 218 is arranged closer than the auxiliary circuit boards 21a to the vehicle start-up terminal G. This shortens the wiring (conductor line 57) connecting the control-related circuit 2 and the vehicle start-up terminal G.

### [7] Seventh Embodiment

Description will be made of a battery system according to a seventh embodiment by referring to differences from the battery system 500 according to the first embodiment.

### (1) Connection and Wiring among the Battery Modules

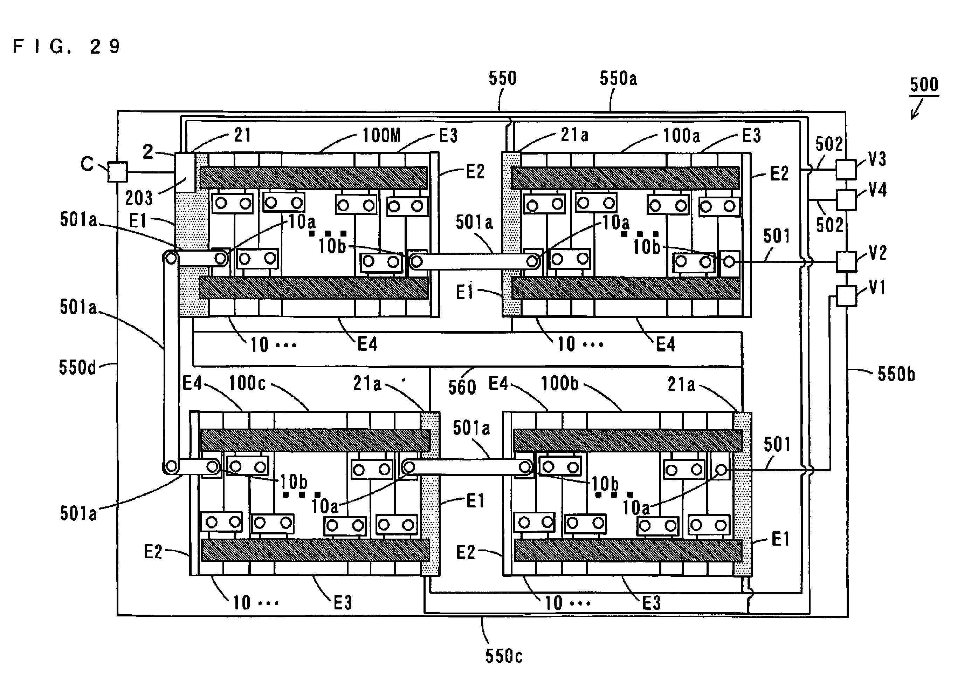

Fig. 29 is a schematic plan view showing one example of connection and wiring among the battery modules 100M, 100 in the present embodiment. Similarly to the first embodiment, the control-related circuit 2 as well as the cell characteristics detecting circuit 1 of Fig. 2 is mounted on the main circuit board 21. In the present embodiment, the control-related circuit 2 includes the CAN communication circuit 203.

As shown in Fig. 29, the three battery modules 100 are referred to as the battery modules 100a, 100b, 100c for distinction. The four battery modules 100M, 100a to 100c are arranged to form two rows and two columns within the casing 550.

The communication terminal C is provided on the side wall 550d of the casing 550. The voltage terminals V1 to V4 are provided on the side wall 550b. Connection and wiring among the communication terminal C and the voltage terminals V3, V4 are the same as those in the first embodiment.

In the present embodiment, the minus electrode 10b having the lowest potential in the battery module 100b and the plus electrode 10a having the highest potential in the battery module 100c are connected through the bus bar 501a. The minus electrode 10b having the lowest potential in the battery module 100c and the plus electrode 10a having the highest potential in the battery module 100M are connected through the bus bar 501a. The minus electrode 10b having the lowest potential in the battery module 100M and the plus electrode 10a having the highest potential in the battery module 100a are connected through the bus bar 501 a.

The plus electrode 10a having the highest potential in the battery module 100b is connected to the voltage terminal V1 through the power supply line 501. The minus electrode 10b having the lowest potential in the battery module 100a is connected to the voltage terminal V2 through the power supply line 501. In this case, the motor or the like of the electric vehicle is connected between the voltage terminals V1, V2, so that electric power generated in the battery modules 100M, 100a to 100c connected in series can be supplied to the motor or the like.

### (2) Effects

In the battery system 500 according to the present embodiment, the main circuit board 21 provided in the battery module 100M includes the control-related circuit 2, and the control-related circuit 2 includes the CAN communication circuit 203. Thus, communication can be performed between the communication circuits 24 of the battery modules 100M, 100 and the main controller 300 of the electric vehicle via the CAN communication circuit 203.

Accordingly, a CAN communication unit need not be separately provided in the battery system 500. This allows the wiring of the battery system 500 to be simplified and allows the battery system 500 to be reduced in size.

The main circuit board 21 provided in the battery module 100M is arranged in the vicinity of the communication terminal C. That is, the main circuit board 21 including the CAN communication circuit 203 is arranged closer than the auxiliary circuit boards 21 a to the communication terminal C. This shortens the wiring connecting the control-related circuit 2 and the communication terminal C.

In the battery system 500 according to the present embodiment, the control-related circuit 2 of the main circuit board 21 is arranged to be spaced apart from the voltage terminals V1, V2 for charging/discharging the battery modules 100M, 100. This improves noise immunity of the control-related circuit 2.

### [8] Eighth Embodiment

While the battery system 500 according to the first embodiment includes one battery module 100M, the present invention is not limited to this. The battery system 500 may include two or more battery modules 100M.

Description will be made of a battery system according to an eighth embodiment by referring to differences from the battery system 500 according to the first embodiment.

### (1) Connection and Wiring among the Battery Modules

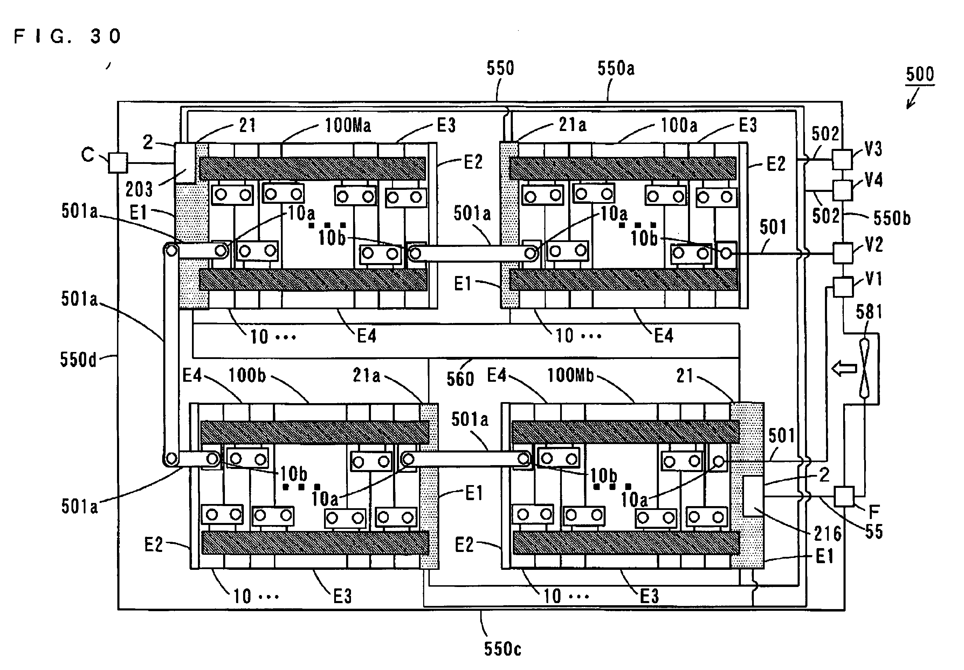

Fig. 30 is a schematic plan view showing one example of connection and wiring among the battery modules 100M, 100 in the eighth embodiment. The battery system according to the present embodiment includes two battery modules 100M, two battery modules 100 and the fan 581.

As shown in Fig. 30, the two battery modules 100M are referred to as battery modules 100Ma, 100Mb for distinction. The two battery modules 100 are referred to as battery modules 100a, 100b for distinction. The four battery modules 100Ma, 100Mb, 100a, 100b are arranged to form two rows and two columns within the casing 550.

The main circuit board 21 is provided in each of the battery modules 100Ma, 100Mb. The auxiliary circuit board 21a is provided in each of the battery modules 100a, 100b. The control-related circuit 2 as well as the cell characteristics detecting circuit 1 of Fig. 2 is mounted on each main circuit board 21. In the present embodiment, the control-related circuit 2 of the main circuit board 21 of the battery module 100Ma includes the CAN communication circuit 203. The control-related circuit 2 of the main circuit board 21 of the battery module 100Mb includes the fan controlling circuit 216.

The communication terminal C is provided on the side wall 550d of the casing 550. The voltage terminals V1 to V4 and the fan terminal F are provided on the side wall 550b. Connection and wiring among the communication terminal C and the voltage terminals V3, V4 are the same as those in the first embodiment.

In the present embodiment, the minus electrode 10b having the lowest potential in the battery module 100Mb and the plus electrode 10a having the highest potential in the battery module 100b are connected through the bus bar 501 a. The minus electrode 10b having the lowest potential in the battery module 100b and the plus electrode 10a having the highest potential in the battery module 100Ma are connected through the bus bar 501a. The minus electrode 10b having the lowest potential in the battery module 100Ma and the plus electrode 10a having the highest potential in the battery module 100a are connected through the bus bar 501 a.

The plus electrode 10a having the highest potential in the battery module 100Mb is connected to the voltage terminal V1 through the power supply line 501. The minus electrode 10b having the lowest potential in the battery module 100a is connected to the voltage terminal V2 by the power supply line 501. In this case, the motor or the like of the electric vehicle is connected between the voltage terminals V1, V2, so that electric power generated in the battery modules 100Ma, 100Mb, 100a, 100b connected in series can be supplied to the motor or the like.

The fan 581 is connected to the fan terminal F. The fan controlling circuit 216 is connected to the fan terminal F through the conductor line 55. Accordingly, the control-related circuit 2 can control the fan 581 to be turned on and off or control the rotational speed of the fan 581.

### (2) Effects

In the battery system 500 according to the present embodiment, the main circuit board 21 provided in the battery module 100Ma includes the control-related circuit 2, and the control-related circuit 2 includes the CAN communication circuit 203. Thus, communication can be performed between the communication circuits 24 of the battery modules 100Ma, 100Mb, 100a, 100b and the main controller 300 of the electric vehicle via the CAN communication circuit 203.

The main circuit board 21 provided in the battery module 100Mb includes the control-related circuit 2, and the control-related circuit 2 includes the fan controlling circuit 216. Thus, the fan 581 is controlled to be turned on and off or the rotational speed of the fan 581 is controlled.

Accordingly, a CAN communication unit and a fan controlling unit need not be separately provided in the battery system 500. This allows the wiring of the battery system 500 to be simplified and allows the battery system 500 to be reduced in size.

The main controller 300 may not have the fan controlling function, thus reducing burdens on the processing of the main controller 300.

The main circuit board 21 provided in the battery module 100Ma is arranged in the vicinity of the communication terminal C. That is, the main circuit board 21 including the CAN communication circuit 203 is arranged closer than the auxiliary circuit boards 21a to the communication terminal C. This shortens the wiring connecting the control-related circuit 2 and the communication terminal C.

The main circuit board 21 provided in the battery module 100Mb is arranged in the vicinity of the fan terminal F. That is, the main circuit board 21 including the fan controlling circuit 216 is arranged closer than the auxiliary circuit boards 21 to the fan terminal F. This shortens the wiring (conductor line 55) connecting the control-related circuit 2 and the fan terminal F.

In the battery system 500 according to the present embodiment, the control-related circuit 2 of the main circuit board 21 included in the battery module 100Ma is arranged to be spaced apart from the voltage terminals V1, V2 for charging/discharging the battery modules 100Ma, 100Mb, 100a, 100b. This improves noise immunity of the CAN communication circuit 203.

### [9] Ninth Embodiment

Description will be made of a battery system according to a ninth embodiment by referring to differences from the battery system 500 according to the eighth embodiment.

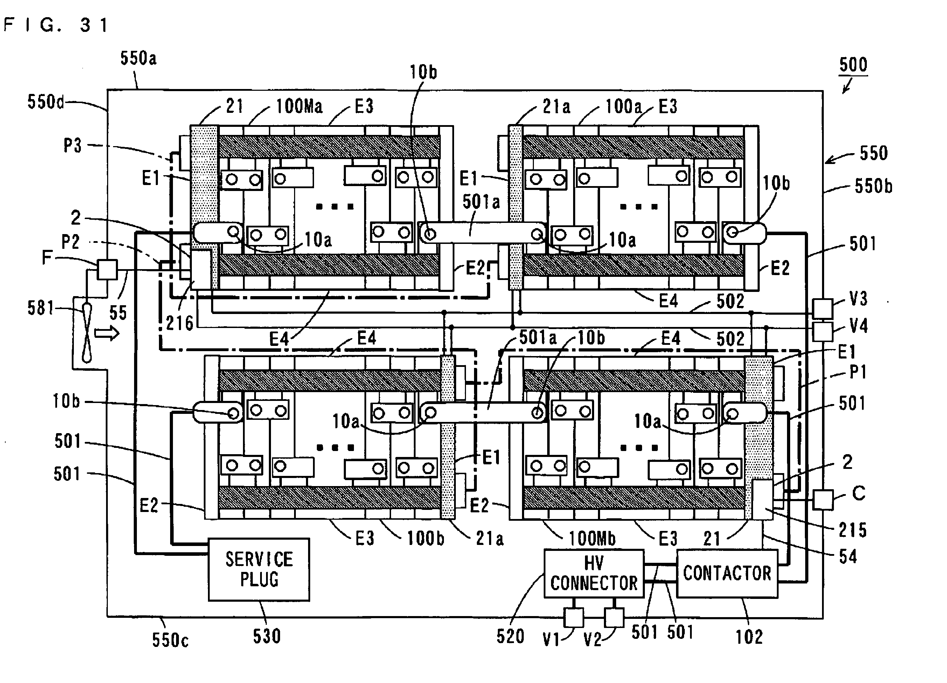

Fig. 31 is a schematic plan view showing one example of connection and wiring among the battery modules 100M, 100 in the ninth embodiment. The battery system 500 according to the present embodiment includes the four battery modules 100Ma, 100Mb, 100a, 100b, the contactor 102, an HV (High Voltage) connector 520, a service plug 530 and the fan 581.

In the present embodiment, the control-related circuit 2 of the main circuit board 21 of the battery module 100Ma includes the fan controlling circuit 216. The control-related circuit 2 of the main circuit board 21 of the battery module 100Mb includes the CAN communication circuit 203 and the contactor controlling circuit 215.

The service plug 530, the HV connector 520 and the contactor 102 are arranged to line up in this order from the side wall 550d to the side wall 550b in a region between the side surfaces E3 and the side wall 550c of the battery modules 100b, 100Mb. The HV connector 520 includes the voltage terminals V1, V2. The voltage terminals V3, V4 and the communication terminal C are provided on the side wall 550b of the casing 550. The voltage terminals V1, V2 of the HV connector 520 are provided on the side wall 550c. The fan terminal F is provided on the side wall 550d.

The minus electrode 10b having the lowest potential in the battery module 100Mb and the plus electrode 10a having the highest potential in the battery module 100b are connected through the bus bar 501 a. The minus electrode 10b having the lowest potential in the battery module 100Ma and the plus electrode 10a having the highest potential in the battery module 100a are connected through the bus bar 501 a. The minus electrode 10b having the lowest potential in the battery module 100b is connected to the service plug 530 through the power supply line 501, and the plus electrode 10a having the highest potential in the battery module 100Ma is connected to the service plug 530 through the power supply line 501.

The service plug 530 is turned off by a worker during maintenance of the battery system 500, for example. When the service plug 530 is turned off, the series circuit composed of the battery modules 100Mb, 100b and the series circuit composed of the battery modules 100Ma, 100a are electrically separated from each other. In this case, the current path among the four battery modules 100Ma, 100Mb, 100a, 100b is cut off. This provides a high degree of safety during maintenance.

The contactor 102 as well as the service plug 530 are turned off by a worker during maintenance of the battery system 500. In this case, the current path among the four battery modules 100Ma, 100Mb, 100a, 100b is reliably cut off. This sufficiently provides a high degree of safety during maintenance. When the battery modules 100Ma, 100Mb, 100a, 100b have equal voltages, the total voltage of the series circuit composed of the battery modules 100Ma, 100b is equal to the total voltage of the series circuit composed of the battery modules 100Ma, 100a. This prevents a high voltage from being generated in the battery system 500 during maintenance.

The plus electrode 10a having the highest potential in the battery module 100Mb is connected to the voltage terminal V1 of the HV connector 520 through the power supply line 501 via the contactor 102. The minus electrode 10b having the lowest potential in the battery module 100a is connected to the voltage terminal V2 of the HV connector 520 through the power supply line 501 via the contactor 102. In this case, the motor or the like of the electric vehicle is connected between the voltage terminals V1, V2, so that electric power generated in the battery modules 100Ma, 100Mb, 100a, 100b connected in series can be supplied to the motor or the like.

The communication circuit 24 (see Fig. 3) of the main circuit board 21 of the battery module 100Mb and the communication circuit 24 (see Fig. 2) of the auxiliary circuit board 21a of the battery module 100b are connected to each other through a communication line P1. The communication circuit 24 of the auxiliary circuit board 21a of the battery module 100b and the communication circuit 24 of the main circuit board 21 of the battery module 100Ma are connected to each other through a communication line P2. The communication circuit 24 of the main circuit board 21 of the battery module 100Ma and the communication circuit 24 of the auxiliary circuit board 21 a of the battery module 100a are connected to each other through a communication line P3. The communication lines P1 to P3 constitute a bus.

The main circuit board 21 provided in the battery module 100Mb is arranged in the vicinity of the communication terminal C and the contactor 102. The CAN communication circuit 203 of the main circuit board 21 of the battery module 100Mb is connected to the communication terminal C through a conductor line. This allows for communication between the control-related circuit 2 and the main controller 300. The contactor controlling circuit 215 of the main circuit board 21 of the battery module 100Mb is connected to the contactor 102 through the conductor line 54. Thus, the control-related circuit 2 can control the contactor 102 to be turned on and off.

The main circuit board 21 provided in the battery module 100Ma is arranged in the vicinity of the fan terminal F. The fan 581 is connected to the fan terminal F. The fan controlling circuit 216 of the main circuit board 21 of the battery module 100Ma is connected to the fan terminal F through the conductor line 55. Accordingly, the control-related circuit 2 can control the fan 581 to be turned on and off or control the rotational speed of the fan 581.

In the battery system 500 according to the present embodiment, the main circuit board 21 provided in the battery module 100Ma is arranged in the vicinity of the fan terminal F. Thus, the main circuit board 21 including the fan controlling circuit 216 is arranged closer than the auxiliary circuit boards 21a to the fan terminal F. This shortens the wiring (conductor line 55) connecting the control-related circuit 2 and the fan terminal F.

The main circuit board 21 provided in the battery module 100Mb is arranged in the vicinity of the communication terminal C and the contactor 102. Thus, the main circuit board 21 including the CAN communication circuit 203 and the contactor controlling circuit 215 can be arranged closer than the auxiliary circuit boards 21a to the communication terminal C and the contactor 102. This shortens the wiring connecting the control-related circuit 2 and the communication terminal C and the wiring (conductor line 54) connecting the control-related circuit 2 and the contactor 102.

### [10] Tenth Embodiment

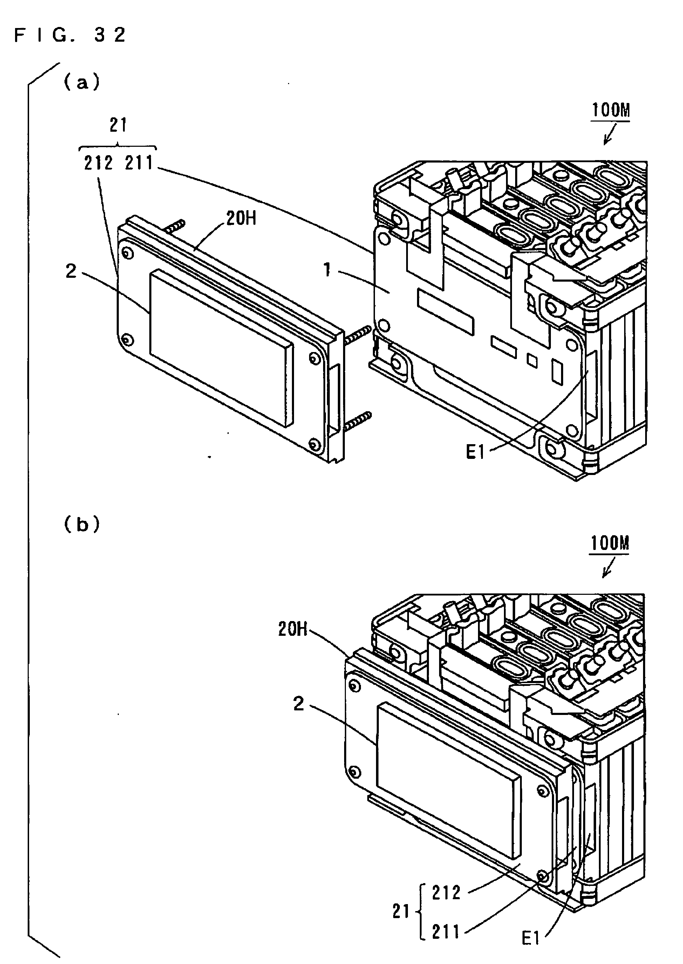

Description will be made of a battery system according to a tenth embodiment by referring to differences from the battery system 500 according to the first embodiment. Fig. 32 is an external perspective view of an end of the battery module 100M in the tenth embodiment.

As shown in Fig. 32 (a), a main circuit board 21 of the battery module 100M is composed of a first main circuit board 211 and a second main circuit board 212. The cell characteristics detecting circuit 1 is mounted on the first main circuit board 211. The control-related circuit 2 is mounted on the second main circuit board 212.

As shown in Fig. 32 (a), the first main circuit board 211 is attached to the end surface E1 of the battery module 100M. The second main circuit board 212 is held by a holder 20H.

As shown in Fig. 32 (b), the holder 20H is attached to the end surface E1 of the battery module 100M. Thus, the first main circuit board 211 and the second main circuit board 212 can be mounted to overlap each other on the end surface E1 of the battery module 100M. In this case, the control-related circuit 2 having many functions can be mounted on the second main circuit board 212. For example, the control-related circuit 2 may include at least two or all of the current detecting circuit 210, the total voltage detecting circuit 213, the electric leakage detecting circuit 214, the contactor controlling circuit 215, the fan controlling circuit 216, the power supplying circuit 217 and the vehicle start-up detecting circuit 218.

### [11] Eleventh Embodiment

Description will be made of a battery system according to an eleventh embodiment by referring to differences from the battery system 500 according to the tenth embodiment.

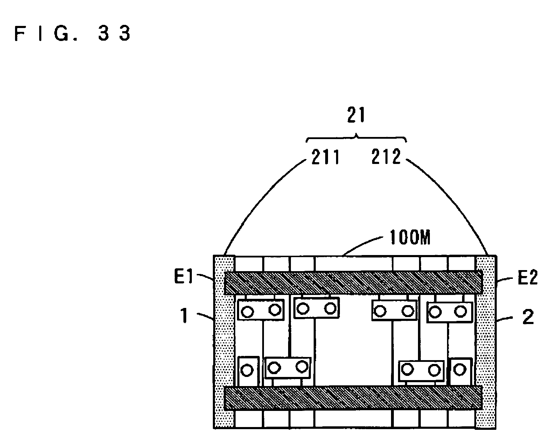

Fig. 33 is a plan view of the battery module 100M in the eleventh embodiment. Similarly to the tenth embodiment, the main circuit board 21 of the battery module 100M is composed of the first main circuit board 211 and the second main circuit board 212. The cell characteristics detecting circuit 1 is mounted on the first main circuit board 211. The control-related circuit 2 is mounted on the second main circuit board 212.

The first main circuit board 211 is attached to the end surface E1 of the battery module 100M. The second main circuit board 212 is attached to the end surface E2 of the battery module 100M. Also in this case, the control-related circuit 2 having many functions can be mounted on the second main circuit board 212. For example, the control-related circuit 2 may include at least two or all of the current detecting circuit 210, the total voltage detecting circuit 213, the electric leakage detecting circuit 214, the contactor controlling circuit 215, the fan controlling circuit 216, the power supplying circuit 217 and the vehicle start-up detecting circuit 218.

### [12] Twelfth Embodiment

Description will be made of a battery module according to a twelfth embodiment by referring to differences from the battery module 100 of the battery system 500 according to the first embodiment.

### (1) Configuration of the Battery Module

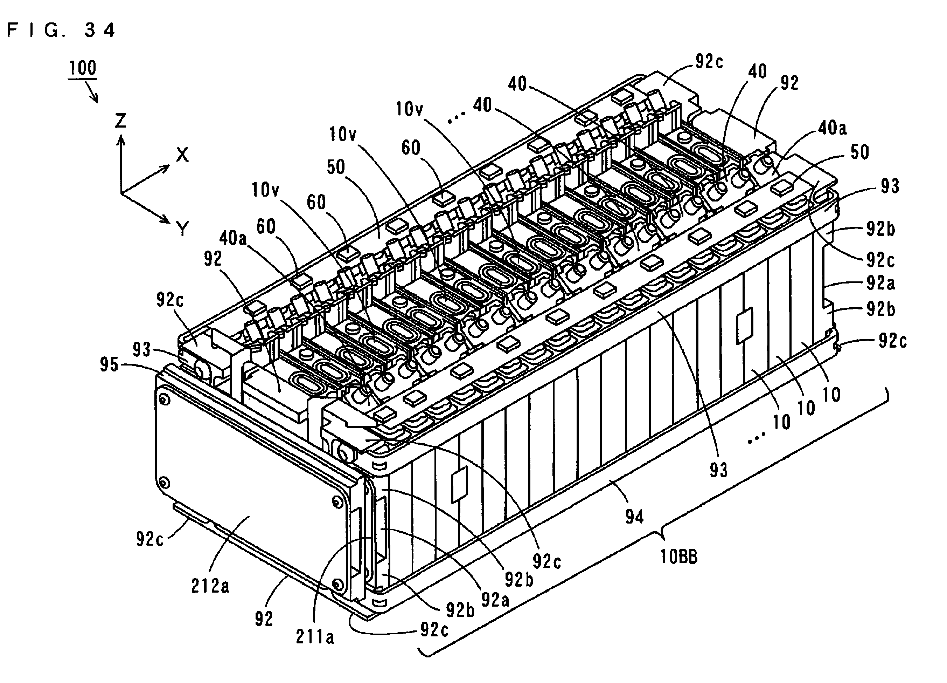

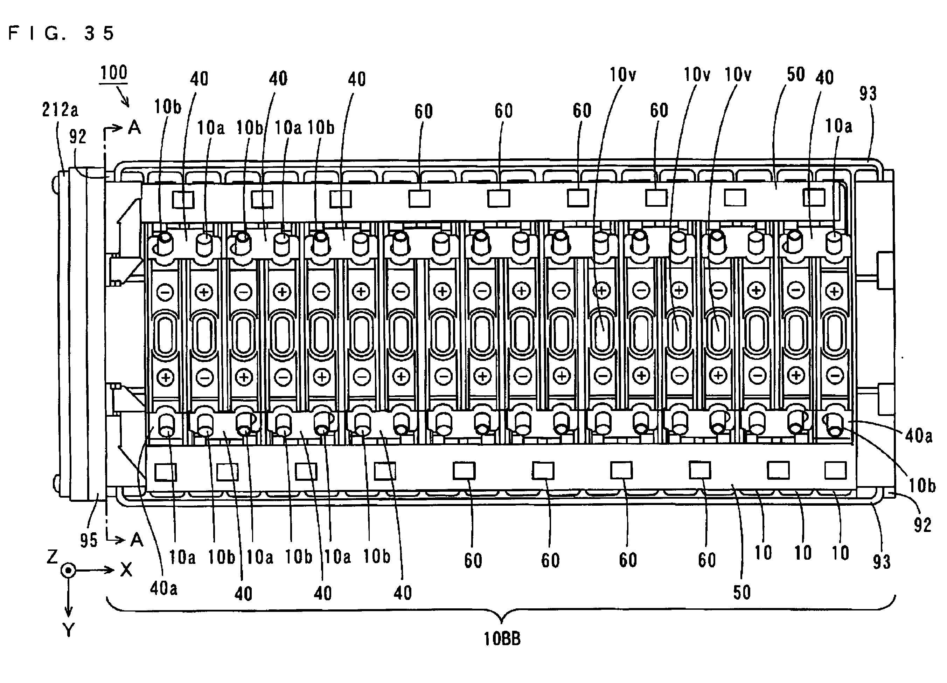

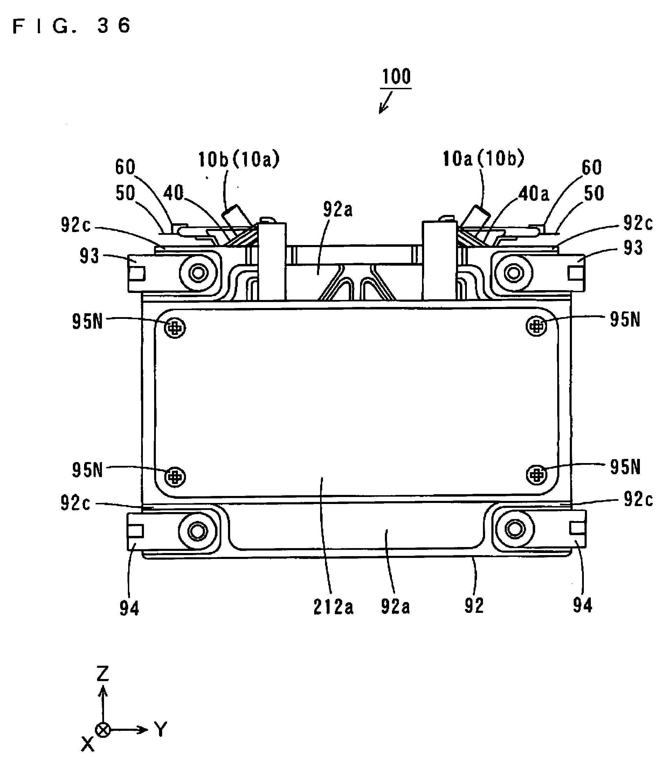

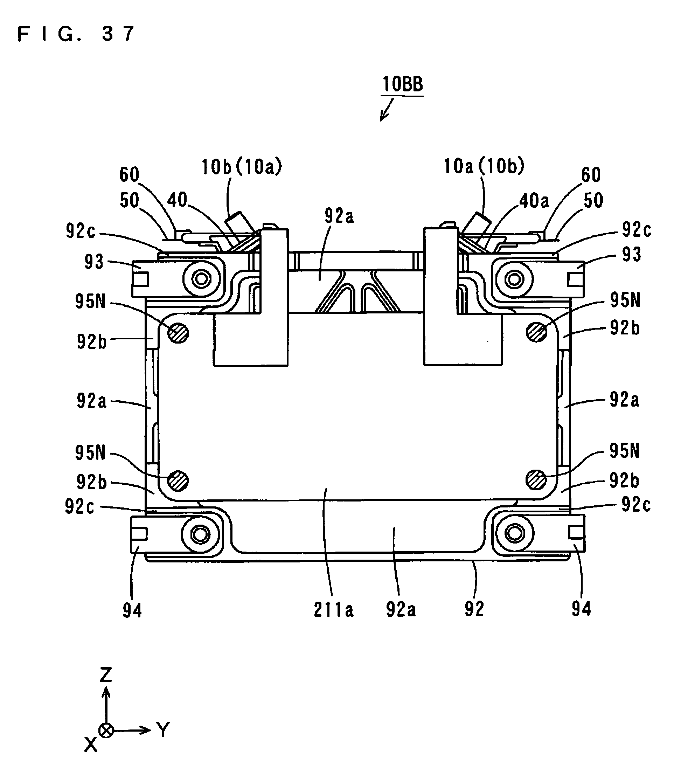

Description is made of the configuration of the battery module 100 according to the twelfth embodiment. Fig. 34 is an external perspective view of the battery module 100 according to the twelfth embodiment, Fig. 35 is a plan view of the battery module 100 of Fig. 34, Fig. 36 is an end view of the battery module 100 of Fig. 34, and Fig. 37 is a vertical sectional view taken along the line A-A of Fig. 35.

As shown in Figs. 34 and 35, Each of the battery cells 10 has a gas vent valve 10v at the center of its upper surface portion. When internal pressure of the battery cell 10 rises to a value, gas in the battery cell 10 is exhausted through the gas vent valve 10v of the battery cell 10. This prevents excessive rise in the internal pressure of the battery cell 10.

A battery block 10BB having a substantially rectangular parallelepiped shape is composed of the plurality of battery cells 10, the pair of end surface frames 92, the pair of upper end frames 93 and the pair of lower end frames 94. The battery block 10BB has an upper surface that is parallel to the XY plane. The battery block 10BB has one end surface and the other end surface that are parallel to the YZ plane. The battery block 10BB has one side surface and the other side surface that are parallel to the XZ plane.

The pair of end surface frames 92 has one surface and the other surface that are parallel to the YZ plane. As shown in Figs. 34, 36 and 37, a flat portion 92a, four board attachment portions 92b and four connection portions 92c are provided on the one surface of the pair of end surface frames 92. The connection portions 92c are provided at four corners of the flat portion 92a. The board attachment portions 92b are provided below the upper connection portions 92c and above the lower connection portions 92c of the flat portion 92a.

With the plurality of battery cells 10 arranged between the other surfaces of the pair of end surface frames 92, the pair of upper end frames 93 is attached to the upper connection portions 92c of the pair of end surface frames 92, and the pair of lower end frames 94 is attached to the lower connection portions 92c of the pair of end surface frames 92. Accordingly, the plurality of battery cells 10 are integrally fixed while being stacked in the X-direction. In this case, the one surfaces of the pair of end surface frames 92 constitute one end surface and the other end surface of the battery block 10BB, respectively.

A first printed circuit board 211a, a board holder 95 and a second printed circuit board 212a are attached to the one end surface frame 92 of the battery block 10BB to be parallel to the end surface frame 92 and line up in the X-direction (the direction in which the plurality of battery cells 10 are stacked). Here, the board holder 95 has one surface and the other surface that are parallel to the YZ plane. The other surface of the board holder 95 is opposite to the one surface of the one end surface frame 92. The second printed circuit board 212a is attached to the one surface of the board holder 95.

Thus, the first printed circuit board 211a is provided on the one end surface that is perpendicular to the X-direction of the battery block 10BB, and the second printed circuit board 212a is provided on the one surface of the board holder 95 that is parallel to the one end surface of the battery block 10BB to be stacked on the first printed circuit board 211 a. In this manner, the first printed circuit board 211a and the second printed circuit board 212a are provided on different planes. Details of the first printed circuit board 211a and the second printed circuit board 212a will be described below.

As described above, the first printed circuit board 211a and the second printed circuit board 212a are provided to be stacked on the one end surface of the battery block 10BB. In this case, the battery module 100 can be prevented from increasing in size in the Y-direction and the Z-direction. Therefore, the battery modules 100 can be arranged without difficulty even though there is limited space in the Y-direction and the Z-direction for arranging the battery modules 100. This improves design flexibility of a battery system 500 and the electric vehicle including the battery system 500.

The end surface frame 92 constitutes the one end surface of the battery block 10BB. This allows the first printed circuit board 211a and the second printed circuit board 212a to be reliably fixed to the end surface frame 92.

For example, if the first and second printed circuit boards 211a, 212a are provided in any of the upper surface, the one side surface and the other side surface of the battery block 10BB, screw holes to be used for attachment of the first and second printed circuit boards 211a, 212a need to be formed in any of the upper surface, the one side surface and the other side surface of the battery block 10BB. If the number of the plurality of battery cells 10 of each battery module 100 is changed, the size of the battery block 10BB in the X-direction is changed. Therefore, another screw hole must be formed in any of the upper surface, the one side surface and the other side surface of the battery block 10BB.

Meanwhile, the size of the one end surface of the battery block 10BB to which the first and second printed circuit boards 211a, 212a are attached does not change in the present embodiment. Therefore, another screw hole to be used for attachment of the first and second printed circuit boards 211a, 212a need not be formed even when the number of the plurality of battery cells 10 is changed. Accordingly, the battery modules 100 of different specifications can be manufactured using common components.

If the first printed circuit board 211a and the second printed circuit board 212a are provided on the upper surface of the battery block 10BB, the gas vent valve 10v of each battery cell 10 is covered with the first printed circuit board 211a and the second printed circuit board 212a. In this case, the upper surface of the battery block 10BB needs to be configured to smoothly introduce gas exhausted from the gas vent valve 10v of each battery cell 10 to the outside.

In the battery module 100 according to the present embodiment, the first printed circuit board 211a and the second printed circuit board 212a are not provided on the upper surface of the battery clock 10BB. Therefore, the upper surface of the battery block 10BB need not be configured to introduce gas exhausted from the gas vent valve 10v of each battery cell 10 to the outside.

Each FPC board 50 is bent inward at a right angle and further bent downward at the upper end portion of the end surface frame 92 (the end surface frame 92 to which the first and second printed circuit boards 211a, 212a are attached) to be connected to the first printed circuit board 211a in the present embodiment. The first printed circuit board 211a and the second printed circuit board 212a are connected to each other through connecting lines that are not shown.

### (2) Attachment Configuration of the First and Second Printed Circuit Boards

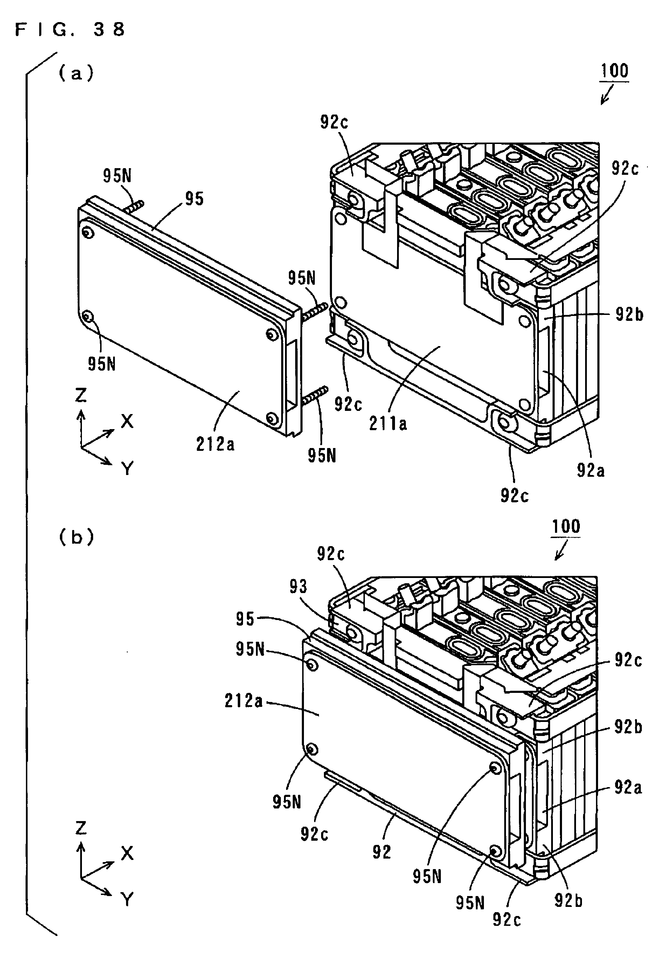

Fig. 38 is a diagram showing the attachment configuration of the first and second printed circuit boards 211a, 212a. The first and second printed circuit boards 211a, 212a have substantially the same rectangular shape. Through holes (not shown) are formed at four corners of the first printed circuit board 211a and four corners of the second printed circuit board 212a. Screw holes (not shown) are formed at the four board attachment portions 92b of the end surface frame 92.

The board holder 95 has a substantially rectangular shape that is almost the same as the shape of each of the first and second printed circuit boards 211a, 212a. Through holes (not shown) are formed at four corners of the board holder 95.

As shown in Fig. 38 (a), the first printed circuit board 211a is aligned on the end surface frame 92 such that the through holes formed at the four corners of the first printed circuit board 211a overlap the screw holes formed at the four board attachment portions 92b.

The second printed circuit board 212a is aligned on the board holder 95 such that the four through holes of the second printed circuit board 212a overlap and the four through holes of the board holder 95, and screws 95N are inserted in the four through holes of the second printed circuit board 212a and the four through holes of the board holder 95. This causes tip portions of the four screws 95N to project from the four through holes of the board holder 95.

The four screws 95N projecting from the board holder 95 are attached to the screw holes of the board attachment portions 92b through the four through holes of the first printed circuit board 211a. This causes the first printed circuit board 211a, the board holder 95 and the second printed circuit board 212a to be fixed to the end surface frame 92 as shown in Fig. 38 (b).

While the board holder 95 is used for fixing the second printed circuit board 212a to the end surface frame 92 in the above-described example, the present invention is not limited to this. The second printed circuit board 212a may be attached to the end surface frame 92 without using the board holder 95. For example, the screws 95N are inserted in the four through holes of the second printed circuit board 212a. In this state, the four screws 95N projecting from the second printed circuit board 212a are attached to the screw holes of the board attachment portions 92b thorough the four through holes of the first printed circuit board 211 a.

In this case, the first and second printed circuit boards 211a, 212a are fixed to the one end surface frame 92 in a simplified manner. Since the board holder 95 is not attached to the end surface frame 92, the battery module 100 is prevented from increasing in size in the X-direction (the direction in which the plurality of battery cells 10 are stacked).

When the board holder 95 is not used, washers may be inserted at portions of the four screws 95N between the first printed circuit board 211a and the second printed circuit board 212a as spacers, for example.

### (3) Examples of the Configurations of the First and Second Printed Circuit Boards

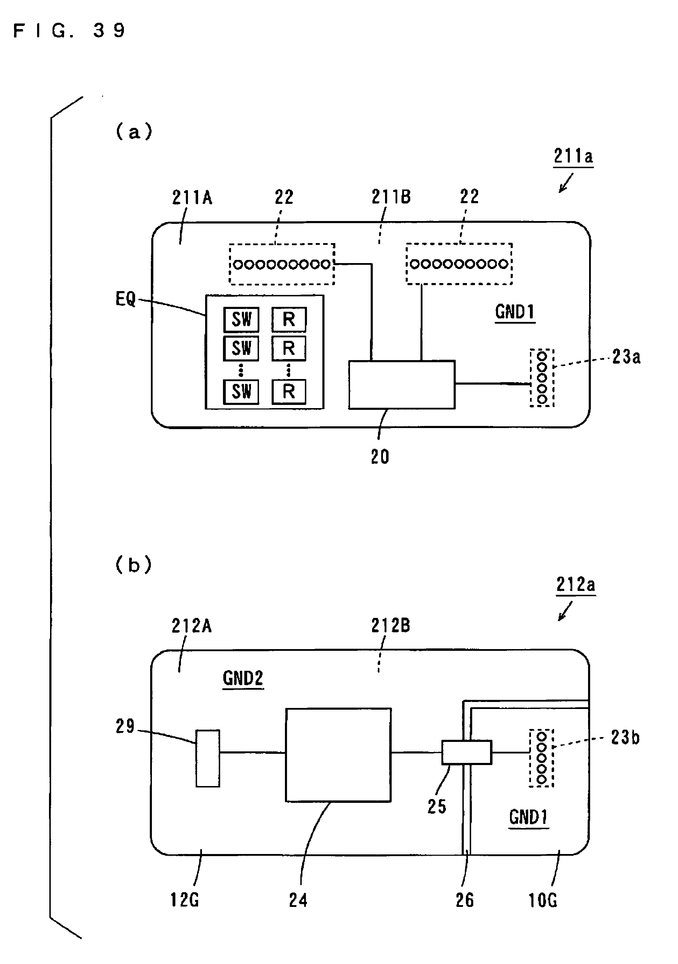

Description will be made of examples of the configurations of the first and second printed circuit boards 211a, 212a. Fig. 39 (a) is a schematic plan view of the first printed circuit board 211a, and Fig. 39 (b) is a schematic plan view of the second printed circuit board 212a.

As shown in Fig. 39 (a), the first printed circuit board 211a has one surface 211A and the other surface 211 B. The voltage detecting circuit 20 is mounted on the one surface 211A of the first printed circuit board 211a.

The plurality of connection terminals 22, 23a are formed on the one surface 211A of the first printed circuit board 211a. In addition, an equalization circuit EQ composed of a plurality of resistors R and a plurality of switching elements SW is mounted on the one surface 211A of the first printed circuit board 211 a.

The voltage detecting circuit 20, the equalization circuit EQ and the plurality of connecting terminals 22, 23a are electrically connected through a plurality of connecting lines. The plurality of battery cells 10 (see Fig. 34) of the battery module 100 are connected to the voltage detecting circuit 20 as the power source of the voltage detecting circuit 20.

A ground pattern GND1 is formed in a portion excluding the mounting regions of the voltage detecting circuit 20 and the equalization circuit EQ and the formation regions of the plurality of connection terminals 22, 23a and the connecting lines. The ground pattern GND1 is held at the reference potential of the battery module 100.

As shown in Fig. 39 (b), the second printed circuit board 212a has one surface 212A and the other surface 212B. The second printed circuit board 212a has a first mounting region 10G, a second mounting region 12G and a strip-shaped insulating region 26 on the one surface 212A.

The first mounting region 10G is formed at one corner of the second printed circuit board 212a. The insulating region 26 is formed to extend along the first mounting region 10G. The second mounting region 12G is formed in the remaining part of the second printed circuit board 212a. The first mounting region 10G and the second mounting region 12G are separated from each other by the insulating region 26. Thus, the first mounting region 10G and the second mounting region 12G are electrically insulated from each other by the insulating region 26.

A plurality of connection terminals 23b are formed in the first mounting region 10G. The connection terminals 23b and the connection terminals 23a of the first printed circuit board 211 a are electrically connected through the FPC boards including the connecting lines, for example. A ground pattern GND1 is formed on part of the first mounting region 10G not including the formation region of the connection terminals 23a and the formation region of the connecting lines. The ground pattern GND1 is held at the reference potential of the battery module 100.

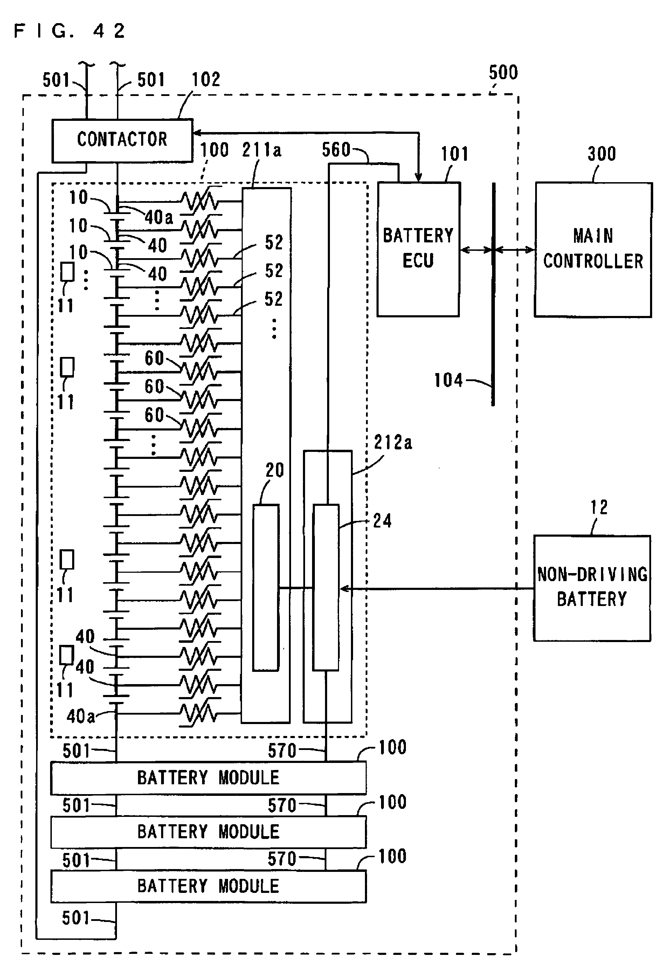

The communication circuit 24 and a connector 29 are mounted on the second mounting region 12G. The communication circuit 24 and the connector 29 are electrically connected through a plurality of connecting lines on the second printed circuit board 212a. A communication line 570 (see Fig. 42, described below) is connected to the connector 29. The non-driving battery 12 (see Fig. 42, described below) included in the electric vehicle is connected to the communication circuit 24 as the power source of the communication circuit 24. A ground pattern GND2 is formed on part of the second mounting region 12G not including the mounting regions of the communication circuit 24 and the connector 29 and the formation region of the plurality of connecting lines. The ground pattern GND2 is held at the reference potential of the non-driving battery 12.

The insulating element 25 is mounted over the insulating region 26. The insulating element 25 electrically insulates the ground pattern GND1 and the ground pattern GND2 from each other while transmitting a signal between the communication circuit 24 and the connection terminals 23b.

In this manner, the voltage detecting circuit 20 of the first printed circuit board 211a and the communication circuit 24 of the second printed circuit board 212a are electrically insulated from each other while being connected to communicate with each other by the insulating element 25. Thus, the plurality of battery cells 10 can be used as the power source of the voltage detecting circuit 20, and the non-driving battery 12 (see Fig. 42, described below) can be used as the power source of the communication circuit 24. As a result, each of the voltage detecting circuit 20 and the communication circuit 24 can be stably and independently operated.

The voltage detecting circuit 20 and the communication circuit 24 that have the different power sources are mounted on the first and second printed circuit boards 211a, 212a, respectively. In this case, the two ground patterns GND1, GND2 that have the different reference potentials need not be formed in at least one (the first printed circuit board 211a in this example) of the first and second printed circuit boards 211a, 212a. Therefore, the mounting region of the electronic components is enlarged in the one printed circuit board, and the one printed circuit board is easily manufactured.

Part of the configuration of the voltage detecting circuit 20 may be mounted in the first mounting region 10G of the second printed circuit board 212a. In this case, the mounting region of the voltage detecting circuit 20 can be further enlarged in the first printed circuit board 211 a.

While the two ground patterns GND1, GND2 are formed on the second printed circuit board 212a in the example of Fig. 39, the two ground patterns GND1, GND2 may be formed on the first printed circuit board 211a. In this case, the first mounting region 10G, the second mounting region 12G and the insulating region 26 are formed on the first printed circuit board 211a, and the insulating element 25 is mounted over the insulating region 26.

### (4) Connection between the Bus Bar and the First Printed Circuit Board

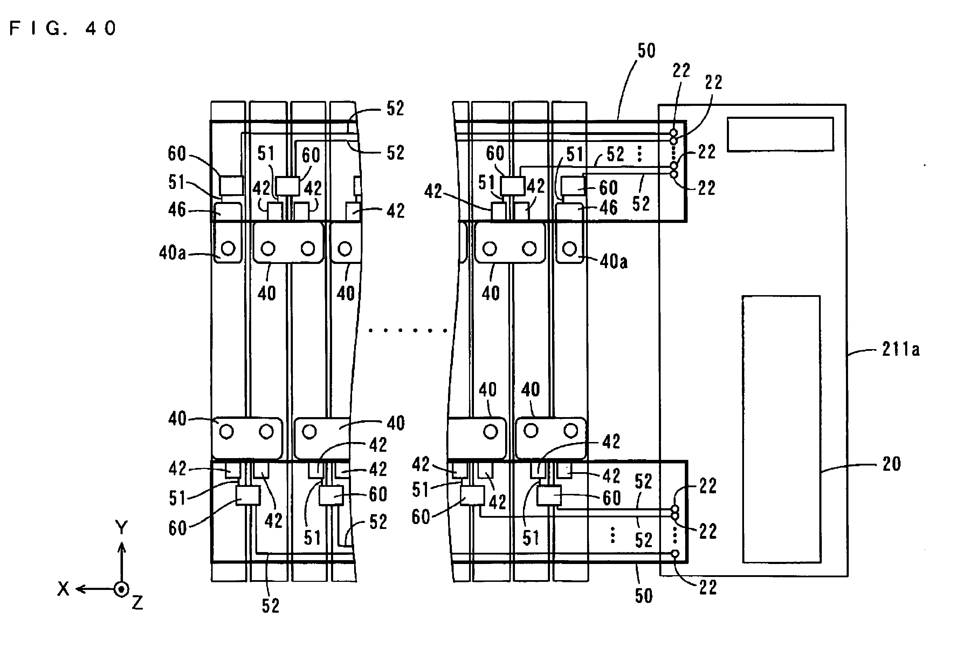

Next, description is made of connection between the bus bars 40, 40a and the first printed circuit board 211a. Fig. 40 is a schematic plan view for explaining connection between the bus bars 40, 40a and the first printed circuit board 211 a.

As shown in Fig. 40, the voltage detecting circuit 20 and the plurality of connection terminals 22 corresponding to the plurality of conductor lines 52, respectively, of the FPC boards 50 are provided in the first printed circuit board 211a. The plurality of connection terminals 22 and the voltage detecting circuit 20 are electrically connected on the first printed circuit board 211a. The other ends of the conductor lines 52 of the FPC boards 50 are connected to the corresponding connection terminals 22 by soldering or welding, for example. In this manner, the bus bars 40, 40a are electrically connected to the voltage detecting circuit 20 through the PTC elements 60. Accordingly, voltages between the terminals of the battery cells 10 are detected.

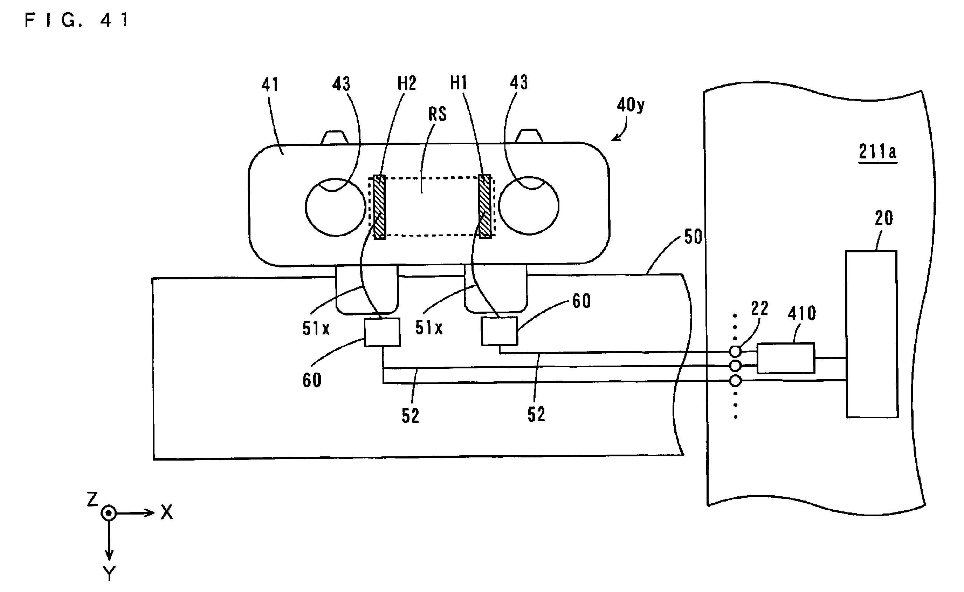

One of the plurality of bus bars 40 in at least one battery module 100 is used as the voltage/current bus bar 40y. Fig. 41 is an enlarged plan view showing the voltage/current bus bar 40y and the FPC board 50. As shown in Fig. 41, the first printed circuit board 211a further includes an amplifying circuit 410.

The solder trace H1 of the voltage/current bus bar 40y is connected to one input terminal of the amplifying circuit 410 on the first printed circuit board 211a through a conductor line 51x, the PTC element 60, the conductor line 52 and the connection terminal 22. Similarly, the solder trace H2 of the voltage/current bus bar 40y is connected to the other input terminal of the amplifying circuit 410 through a conductor line 51x, the PTC element 60, the conductor line 52 and the connection terminal 22. An output terminal of the amplifying circuit 410 is connected to the voltage detecting circuit 20 through a conductor line. Thus, the voltage detecting circuit 20 detects the voltage between the solder traces H1, H2 based on the output voltage from the amplifying circuit 410.

Here, the communication circuit 24 (see Fig. 39 (b)) is provided on the second printed circuit board 212a (see Fig. 34). The voltage detected by the voltage detecting circuit 20 of the first printed circuit board 211a is applied to the communication circuit 24 of the second printed circuit board 212a.

The communication circuit 24 calculates the value of the current flowing through the voltage/current bus bar 40y by dividing the voltage between the solder traces H1, H2 applied from the voltage detecting circuit 20 by the value of the shunt resistance RS stored in the memory. In this manner, the value of the current flowing through the battery modules 100 is detected.

While the resistance formed between the solder traces H1, H2 in the voltage/current bus bar 40y is used as the shunt resistance RS for current detection in the foregoing example, the present invention is not limited to this. A resistance formed between the pair of attachment portions 42 in the bus bar for two electrodes 40 of Fig. 7 (a) may be used as the shunt resistance RS for current detection. In this case, a value of the shunt resistance RS between the pair of attachment portions 42 is previously stored in the memory of the communication circuit 24. The communication circuit 24 divides the voltage between the pair of attachment portions 42 applied from the voltage detecting circuit 20 by the value of the shunt resistance RS stored in the memory. Accordingly, the value of the current flowing through the battery modules 100 is detected.

### (5) Configuration of the Battery System

Fig. 42 is a block diagram showing the configuration of a battery system using the battery module 100 of Fig. 34. As shown in Fig. 42, the battery system 500 includes the plurality of battery modules 100 (four in this example), a battery ECU (Electronic Control Unit) 101 and the contactor 102. The plurality of battery modules 100 are connected to the battery ECU 101 through the communication lines 570 in the battery system 500. The battery ECU 101 is connected to the main controller 300 of the electric vehicle through the bus 104.

The plurality of battery modules 100 of the battery system 500 are connected to one another through the power supply lines 501. Each battery module 100 includes the plurality of battery cells 10, the first printed circuit board 211a, the second printed circuit board 212a and the plurality of (four in this example) thermistors 11. All the battery cells 10 of the plurality of battery modules 100 are connected in series in the battery system 500. The power supply line 501 connected to the plus electrode 10a having the highest potential in the plurality of battery modules 100 and the power supply line 501 connected to the minus electrode 10b having the lowest potential in the plurality of battery modules 100 are connected to the load such as the motor or the like of the electric vehicle via the contactor 102.

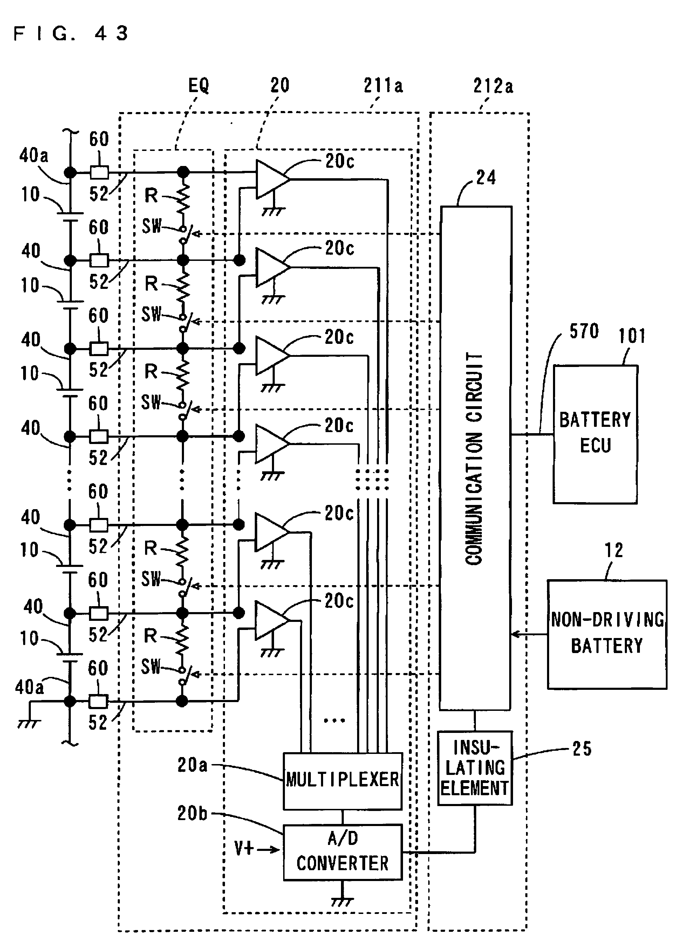

Fig. 43 is a block diagram for explaining details of the configurations of the first and second printed circuit boards 211a, 212a. As described above, the first printed circuit board 211a includes the voltage detecting circuit 20 and the equalization circuit EQ, and the second printed circuit board 212a includes the communication circuit 24 and the insulating element 25. The voltage detecting circuit 20 includes the multiplexer 20a, the A/D converter 20b and the plurality of differential amplifiers 20c. The equalization circuit EQ includes the plurality of resistors R and the plurality of switching elements SW.

The communication circuit 24 of each battery module 100 and the battery ECU 101 are connected in series through the communication line 570. This allows the communication circuit 24 of each battery module 100 to communicate with another battery module 100 and the battery ECU 101. A harness, for example, is used as the communication line 570.

As shown in Fig. 43, the series circuit composed of the resistor R and the switching element SW is connected between two adjacent bus bars 40, 40a as the equalization circuit EQ. The battery ECU 101 controls the switching element SW to be turned on and off via the communication circuit 24. Thus, equalization processing is performed on the plurality of battery cells 10. The switching element SW is turned off in a normal state.

The communication circuit 24 of each battery module 100 applies the cell information to another battery module 100 or the battery ECU 101.

The battery ECU 101 calculates the charged capacity of each battery cell 10 based on the cell information applied from the communication circuit 24 of each battery module 100, for example, and performs charge/discharge control of each battery module 100 based on the charged capacity. The battery ECU 101 detects abnormality of each battery module 100 based on the cell information applied from the communication circuit 24 of each battery module 100. The abnormality of the battery module 100 includes overdischarge, overcharge or abnormal temperature of the battery cells 10, for example.

While the battery ECU 101 calculates the charged capacity of each battery cell 10 and detects overdischarge, overcharge and abnormal temperature, for example, of the battery cells 10 in the present embodiment, the present invention is not limited to this. The communication circuit 24 of each battery module 100 may calculate the charged capacity of each battery cell 10 and detect overdischarge, overcharge and abnormal temperature, for example, of the battery cells 10, and may apply the result to the battery ECU 101. The communication circuit 24 may control the equalization circuit EQ to perform the equalization processing.

As shown in Fig. 42, the contactor 102 is inserted in the power supply lines 501 connected to the battery modules 100. When detecting the abnormality of the battery modules 100, the battery ECU 101 turns off the contactor 102. Since the current does not flow through each battery module 100 in the case of an occurrence of the abnormality, the battery modules 100 are prevented from being abnormally heated. While the battery ECU 101 controls the contactor 102 to be turned on and off in the present embodiment, the present invention is not limited to this. The communication circuit 24 may control the contactor 102 to be turned on and off.

The battery ECU 101 is connected to the main controller 300 via the bus 104. The charged capacity of each battery module 100 (the charged capacities of the battery cells 10) is applied from the battery ECU 101 to the main controller 300.

The communication circuit 24 may have a function of calculating information such as an SOH (State of Health: life of the battery cells 10) and an SOC (State of Charge) based on the detection result of the voltage detecting circuit 20 in the present embodiment. In this case, the communication circuit 24 transmits the calculated SOH and SOC to the battery ECU 101.

### (6) First Example of Arrangement of the Battery System

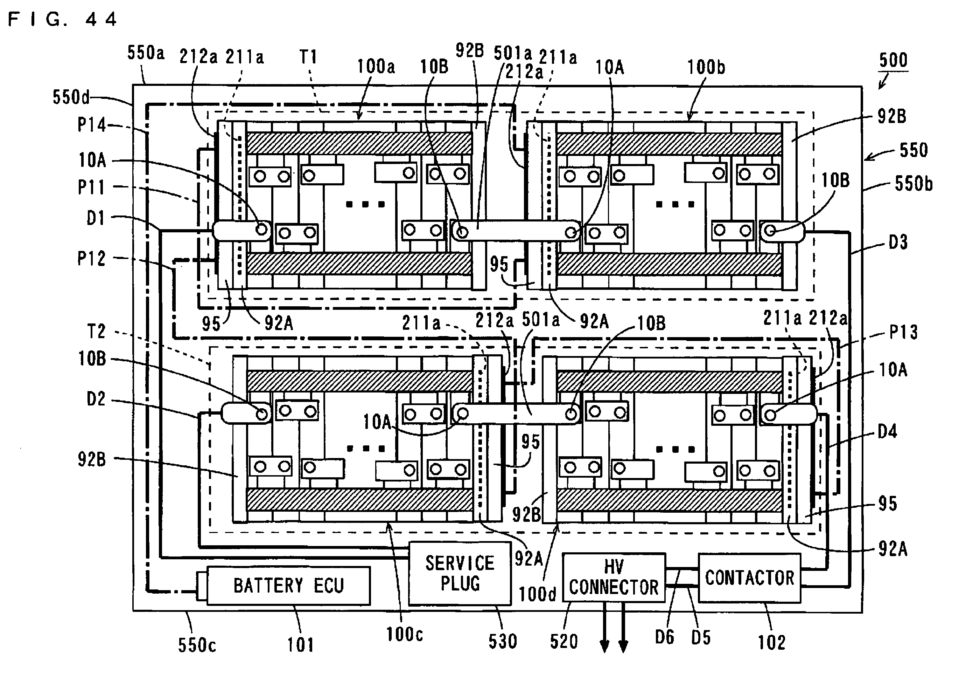

Fig. 44 is a schematic plan view showing a first example of arrangement of the battery system 500 according to the twelfth embodiment.

The battery system 500 of Fig. 44 includes the four battery modules 100, the battery ECU 101, the contactor 102, the HV connector 520 and the service plug 530. Each battery module 100 has the same configuration as the battery module 100 of Fig. 34.

In the following description, the four battery modules 100 are referred to as battery modules 100a, 100b, 100c, 100d, respectively. In the pairs of end surface frames 92 provided in the battery modules 100a, 100b, 100c, 100d, respectively, the end surface frame 92 to which the first and second printed circuit boards 211 a, 212a and the board holder 95 are attached is referred to as an end surface frame 92A, and the end surface frame 92 to which the first and second printed circuit boards 211a, 212a are not attached is referred to as an end surface frame 92B.

The battery modules 100a, 100b, 100c, 100d, the battery ECU 101, the contactor 102, the HV connector 520 and the service plug 530 are housed in the box-shaped casing 550.

Within the casing 550, the battery modules 100a, 100b are arranged to line up in a row at a spacing. In this case, the battery modules 100a, 100b are arranged such that the end surface frame 92B of the battery module 100a and the end surface frame 92A of the battery module 100b face each other.

The battery modules 100c, 100d are arranged to line up in a row at a spacing. In this case, the battery modules 100c, 100d are arranged such that the end surface frame 92A of the battery module 100c and the end surface frame 92B of the battery module 100d face each other.

Hereinafter, the battery modules 100a, 100b arranged to line up in a row are referred to as a module row T1, and the battery modules 100c, 100d arranged to line up in a row are referred to as a module row T2.

The module row T1 is arranged along the side wall 550a, and the module row T2 is arranged parallel to the module row T1 within the casing 550. The end surface frame 92A of the battery module 100a in the module row T1 is directed to the side wall 550d, and the end surface frame 92B of the battery module 100b is directed to the side wall 550b. The end surface frame 92B of the battery module 100c in the module row T2 is directed to the side wall 550d, and the end surface frame 92A of the battery module 100d is directed to the side wall 550b.

The battery ECU 101, the service plug 530, the HV connector 520 and the contactor 102 are arranged to line up in this order from the side wall 550d toward the side wall 550b in a region between the module row T2 and the side wall 550c.

In each of the battery modules 100a, 100b, 100c, 100d, the potential of the plus electrode 10a (Fig. 36) of the battery cell 10 adjacent to the end surface frame 92A is the highest, and the potential of the minus electrode 10b (Fig. 35) of the battery cell 10 adjacent to the end surface frame 92B is the lowest. Hereinafter, the plus electrode 10a having the highest potential in each of the battery modules 100a to 100d is referred to as a high potential electrode 10A, and the minus electrode 10b having the lowest potential in each of the battery modules 100a to 100d is referred to as a low potential electrode 10B.

The low potential electrode 10B of the battery module 100a and the high potential electrode 10A of the battery module 100b are connected to each other through the strip-shaped bus bar 501 a as the power supply line 501 connecting the battery modules 100 of Fig. 42. The high potential electrode 10A of the battery module 100c and the low potential electrode 10B of the battery module 100d are connected to each other through the strip-shaped bus bar 501a as the power supply line 501 connecting the battery modules 100 of Fig. 42. Instead of the bus bar 501a, another connecting member such as a harness or a lead wire may be used.

The high potential electrode 10A of the battery module 100a is connected to the service plug 530 through a power supply line D1 as the power supply line 501 connecting the battery modules 100 of Fig. 42, and the low potential electrode 10B of the battery module 100c is connected to the service plug 530 through a power supply line D2 as the power supply line 501 connecting the battery modules 100 of Fig. 42. With the service plug 530 turned on, the battery modules 100a, 100b, 100c, 100d are connected in series. In this case, the potential of the high potential electrode 10A of the battery module 100d is the highest, and the potential of the low potential electrode 10B of the battery module 100b is the lowest.

The low potential electrode 10B of the battery module 100b is connected to the contactor 102 through a power supply line D3 as the power supply line 501 connecting the battery modules 100 and the contactor 102 of Fig. 42, and the high potential electrode 10A of the battery module 100d is connected to the contactor 102 through a power supply line D4 as the power supply line 501 connecting the battery modules 100 and the contactor 102 of Fig. 42. The contactor 102 is connected to the HV connector 520 through power supply lines D5, D6 as the power supply lines 501 outwardly extending from the contactor 102 of Fig. 42. The HV connector 520 is connected to the load such as the motor of the electric vehicle.

With the contactor 102 turned on, the battery module 100b is connected to the HV connector 520 through the power supply lines D3, D5 while the battery module 100d is connected to the HV connector 520 through the power supply lines D4, D6. Accordingly, electric power is supplied from the battery modules 100a, 100b, 100c, 100d to the load. Moreover, with the contactor 102 turned on, the battery modules 100a, 100b, 100c, 100d are charged.

When the contactor 102 is turned off, connection between the battery module 100b and the HV connector 520 and connection between the battery module 100d and the HV connector 520 are cut off.

The second printed circuit board 212a (Fig. 34) of the battery module 100a and the second printed circuit board 212a of the battery module 100b are connected to each other through a communication line P11. The second printed circuit board 212a of the battery module 100a and the second printed circuit board 212a of the battery module 100c are connected to each other through a communication line P12. The second printed circuit board 212a of the battery module 100c and the second printed circuit board 212a of the battery module 100d are connected to each other through a communication line P13. The second printed circuit board 212a of the battery module 100b is connected to the battery ECU 101 through a communication line P14. The communication lines P11 to P14 correspond to the communication lines 570 of Fig. 42. The communication lines P11 to P14 constitute a bus.

The cell information detected by the voltage detecting circuit 20 of the battery module 100a is applied to the battery ECU 101 through the communication lines P11, P14. A control signal is applied from the battery ECU 101 to the second printed circuit board 212a of the battery module 100a through the communication lines P14, P11.

The cell information detected by the voltage detecting circuit 20 of the battery module 100b is applied to the battery ECU 101 through the communication line P14. A control signal is applied from the battery ECU 101 to the second printed circuit board 212a of the battery module 100b through the communication line P14.

The cell information detected by the voltage detecting circuit 20 of the battery module 100c is applied to the battery ECU 101 through the communication lines P12, P11, P14. A control signal is applied from the battery ECU 101 to the second printed circuit board 212a of the battery module 100c through the communication lines P14, P11, P12.

The cell information detected by the voltage detecting circuit 20 of the battery module 100d is applied to the battery ECU 101 through the communication lines P13, P12, P11, P14. A control signal is applied from the battery ECU 101 to the second printed circuit board 212a of the battery module 100d through the communication lines P14, P11, P12 P13.

### (7) Second Example of Arrangement of the Battery System

In the battery system 500 including the plurality of battery modules 100, a part of the plurality of battery modules 100 may include the first and second printed circuit boards 211a, 212a, and the other battery modules 100 may each include only the first printed circuit board 211 a.

A part of the plurality of battery modules 100 may include the first and second printed circuit boards 211a, 212a, and a part or all of the other battery modules 100 may not include both of the first and second printed circuit boards 211a, 212a.

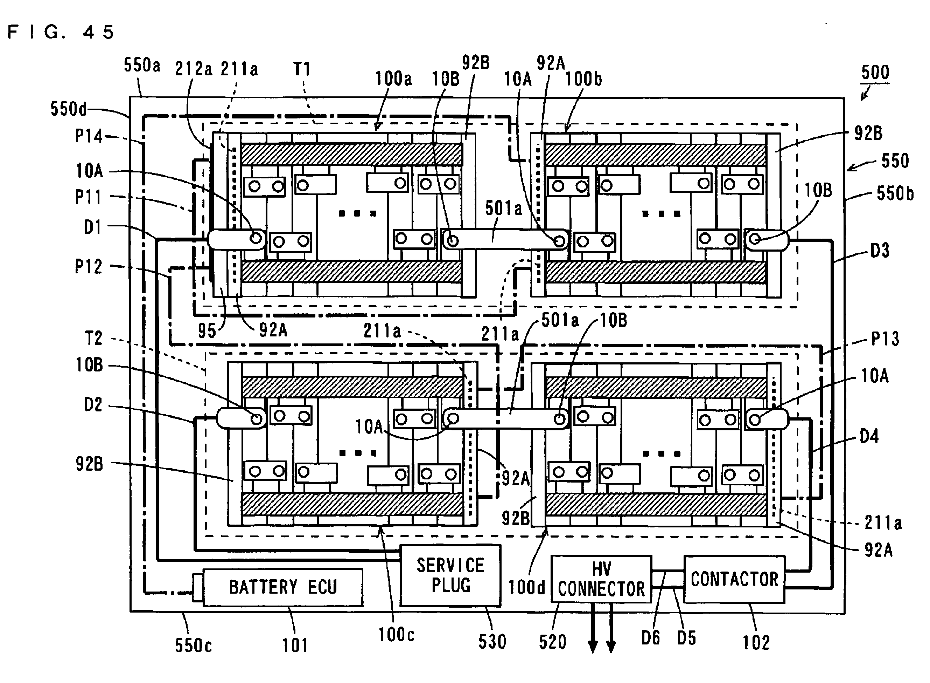

Fig. 45 is a schematic plan view showing a second example of arrangement of the battery system 500 according to the twelfth embodiment. In the example of Fig. 45, the first printed circuit board 211a and the second printed circuit board 212a are attached to the one battery module 100a of the four battery modules 100a, 100b, 100c, 100d constituting the battery system 500, and only the first printed circuit board 211a is attached to each of the other three battery modules 100b, 100c, 100d.

### (8) Third Example of Arrangement of the Battery System

While the battery system 500 includes the four battery modules 100 in the example of Fig. 42, the battery system 500 may include two battery modules 100.

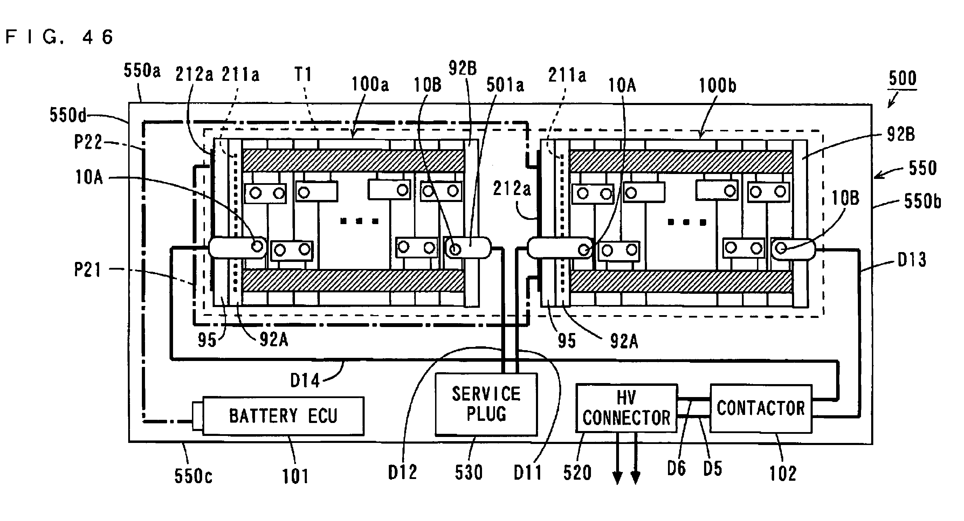

Fig. 46 is a schematic plan view showing a third example of arrangement of the battery system 500 according to the twelfth embodiment. In the example of Fig. 46, the battery system 500 includes two battery modules 100. Description is made of the third example of arrangement of the battery system 500 by referring to differences from the first example (Fig. 44) of arrangement of the battery system 500.

As shown in Fig. 46, the module row T1 is provided within the casing 550, and the module row T2 of Fig. 44 is not provided in the battery system 500. The battery ECU 101, the service plug 530, the HV connector 520 and the contactor 102 are arranged to line up in this order from the side wall 550d toward the side wall 550b in a region between the module row T1 and the side wall 550c.

The high potential electrode 10A of the battery module 100b is connected to the service plug 530 through a power supply line D11 as the power supply line 501 connecting the battery modules 100 of Fig. 42, and the low potential electrode 10B of the battery module 100a is connected to the service plug 530 through a power supply line D12 as the power supply line 501 connecting the battery modules 100 of Fig. 42.

With the service plug 530 turned on, the battery modules 100a, 100b are connected in series. In this case, the potential of the high potential electrode 10A of the battery module 100a is the highest, and the potential of the low potential electrode 10B of the battery module 100b is the lowest.

When the service plug 530 is turned off, the battery module 100a and the battery module 100b are electrically separated from each other. This prevents a high voltage from being generated in the battery system 500 during maintenance.

The low potential electrode 10B of the battery module 100b is connected to the contactor 102 through a power supply line D13 as the power supply line 501 connecting the battery modules 100 and the contactor 102 of Fig. 42, and the high potential electrode 10A of the battery module 100a is connected to the contactor 102 through a power supply line D14 as the power supply line 501 connecting the battery modules 100 and the contactor 102 of Fig. 42.

With the contactor 102 turned on, the battery module 100b is connected to the HV connector 520 through the power supply lines D13, D5 while the battery module 100a is connected to the HV connector 520 through the power supply lines D14, D6. That is, the battery modules 100a, 100b and the load connected to the HV connector 520 form a series circuit. Accordingly, electric power is supplied from the battery modules 100a, 100b to the load. Moreover, with the contactor 102 turned on, the battery modules 100a, 100b are charged.

When the contactor 102 is turned off, e connection between the battery module 100b and the HV connector 520 and connection between the battery module 100a and the HV connector 520 are cut off.

The second printed circuit board 212a (Fig. 34) of the battery module 100a and the second printed circuit board 212a of the battery module 100b are connected to each other through a communication line P21. The second printed circuit board 212a of the battery module 100b is connected to the battery ECU 101 through a communication line P22. The communication lines P21, P22 correspond to the communication lines 570 of Fig. 42. The communication lines P21, P22 constitute a bus.

The cell information detected by the voltage detecting circuit 20 of the battery module 100a is applied to the battery ECU 101 through the communication lines P21, P22. A control signal is applied from the battery ECU 101 to the second printed circuit board 212a of the battery module 100a through the communication lines P22, P21.

The cell information detected by the voltage detecting circuit 20 of the battery module 100b is applied to the battery ECU 101 through the communication line P22. A control signal is applied from the battery ECU 101 to the second printed circuit board 212a of the battery module 100b through the communication line P22.

### (9) Effects

In the battery module 100 according to the present embodiment, the first printed circuit board 211a and the second printed circuit board 212a are provided to be stacked on the one end surface of the battery block 10BB and the surface parallel thereto. In this case, the battery module 100 can be prevented from increasing in size in the Y-direction and the Z-direction. Therefore, the battery modules 100 can be arranged without difficulty even though there is limited space in the Y-direction and the Z-direction for arranging the battery modules 100. This improves design flexibility of the battery system 500 and the electric vehicle including the battery system 500.

The end surface frame 92 constitutes the one end surface of the battery block 10BB. This allows the first printed circuit board 211a and the second printed circuit board 212a to be reliably fixed to the end surface frame 92.

The two circuit boards (the first printed circuit board 211a and the second printed circuit board 212a) are provided in the battery module 100. This sufficiently enlarges the mounting region of the electronic circuits regardless of the size of the end surface of the battery module 100.

The voltage detecting circuit 20 is mounted on the first printed circuit board 211 a, and the communication circuit 24 is mounted on the second printed circuit board 212a. In this case, the first printed circuit board 211a is replaced when the number of the plurality of battery cells 10 in each battery module 100 is increased, so that the voltages between the terminals of the plurality of battery cells 10 can be detected.

For example, if the first and second printed circuit boards 211a, 212a are provided in any of the upper surface, the one side surface and the other side surface of the battery block 10BB, the screw holes to be used for attachment of the first and second printed circuit boards 211a, 212a need to be formed in any of the upper surface, the one side surface and the other side surface of the battery block 10BB. If the number of the plurality of battery cells 10 of each battery module 100 is changed, the size of the battery block 10BB in the X-direction is changed. Therefore, another screw hole must be formed in any of the upper surface, the one side surface and the other side surface of the battery block 10BB.

Meanwhile, the size of the one end surface of the battery block 10BB to which the first and second printed circuit boards 211a, 212a are attached does not change in the present embodiment. Therefore, another screw hole to be used for attachment of the first and second printed circuit boards 211a, 212a need not be formed even when the number of the plurality of battery cells 10 is changed. Accordingly, the battery modules 100 of different specifications can be manufactured using common components.

If the first printed circuit board 211a and the second printed circuit board 212a are provided on the upper surface of the battery block 10BB, the gas vent valve 10v of each battery cell 10 is covered with the first printed circuit board 211a and the second printed circuit board 212a. In this case, the upper surface of the battery block 10BB needs to be configured to smoothly introduce gas exhausted from the gas vent valve 10v of each battery cell 10 to the outside.

In the battery module 100 according to the present embodiment, the first printed circuit board 211a and the second printed circuit board 212a are not provided on the upper surface of the battery clock 10BB. Therefore, the upper surface of the battery block 10BB need not be configured to introduce gas exhausted from the gas vent valve 10v of each battery cell 10 to the outside.

The second printed circuit board 212a on which the communication circuit 24 is mounted is provided on the one surface 211A of the first printed circuit board 211a in the X-direction. In this case, the communication line 570 can be easily connected to the connector 29 of the second printed circuit board 212a.

In the X-direction, the second printed circuit board 212a may be provided on the one surface of the one end surface frame 92, and the first printed circuit board 211 a may be provided on the one surface 212A of the second printed circuit board 212a. In this case, even though the plurality of resistors R mounted on the first printed circuit board 211 a are heated, the heat is efficiently released from the plurality of resistors R.

### [13] Thirteenth Embodiment

Description will be made of a battery module according to a thirteenth embodiment by referring to differences from the battery module 100 according to the twelfth embodiment.

### (1) Configuration of the Battery Module

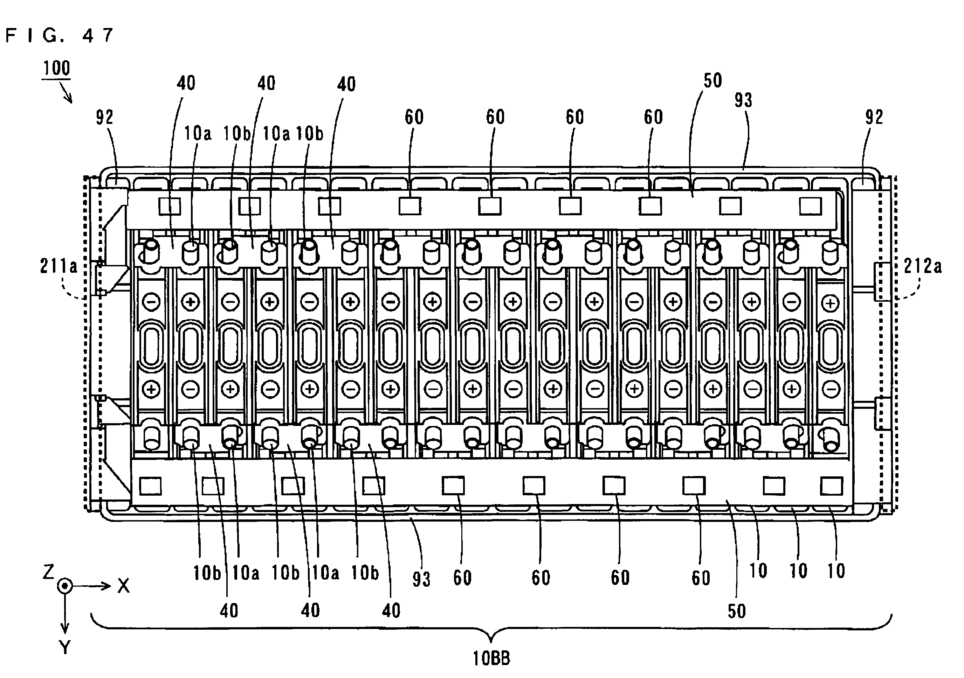

Fig. 47 is a plan view of the battery module 100 according to the thirteenth embodiment. As indicated by the thick dotted line in Fig. 47, the first printed circuit board 211a and the second printed circuit board 212a are attached to the one surfaces of the pair of end surface frames 92, respectively, which are parallel to the YZ plane in the battery module 100. Thus, the first printed circuit board 211a is provided on the one end surface of the battery block 10BB, and the second printed circuit board 212a is provided on the other end surface that is opposite to the one end surface of the battery block 10BB with the plurality of battery cells 10 therebetween. In this manner, the first printed circuit board 211a and the second printed circuit board 212a are also provided on different planes in the present embodiment.

### (2) Example of Arrangement of the Battery System

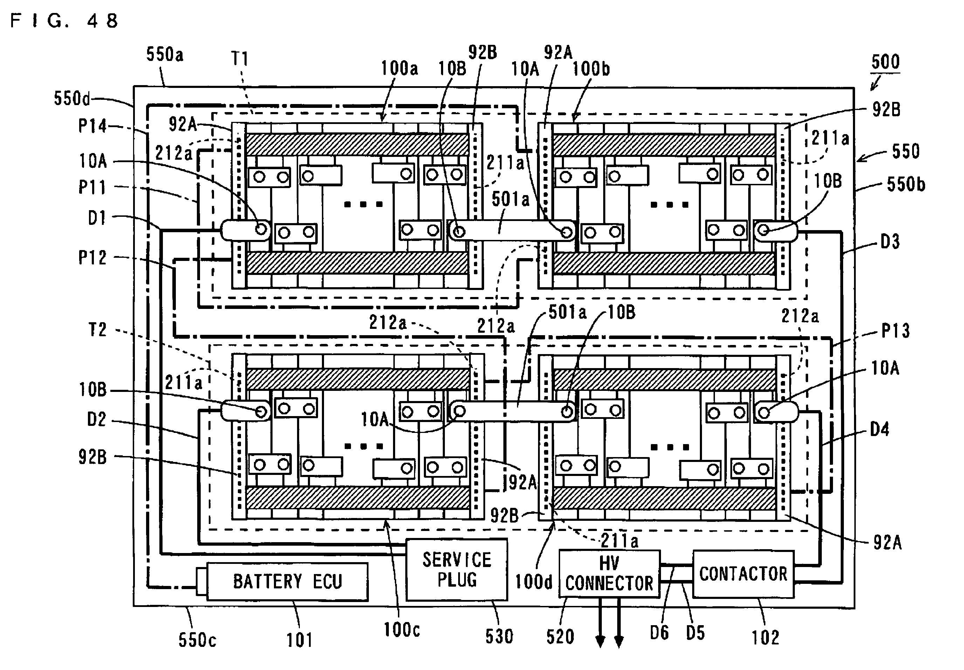

Fig. 48 is a schematic plan view showing an example of arrangement of the battery system 500 according to the thirteenth embodiment. Description will be made of the battery system 500 of Fig. 48 by referring to differences from the battery system 500 of Fig. 44.

In description of Fig. 48, the end surface frame 92 that is adjacent to the battery cell 10 including the high potential electrode 10A in each of the battery modules 100a to 100d is referred to as the end surface frame 92A, and the end surface frame 92 that is adjacent to the battery cell 10 including the low potential electrode 10B in each of the battery modules 100a to 100d is referred to as the end surface frame 92B.

In the battery system 500, the second printed circuit board 212a on which the communication circuit 24 is mounted is attached to the end surface frame 92A of each of the battery modules 100a to 100d. The first printed circuit board 211a on which the voltage detecting circuit 20 is mounted is attached to the end surface frame 92B of each of the battery modules 100a to 100d. The power supply lines and the communication lines are connected among the battery modules 100a to 100d in the same manner as the example of Fig. 44.

### (3) Effects

In the battery module 100 according to the present embodiment, the first printed circuit board 211a and the second printed circuit board 212a are provided on the one end surface and the other end surface of the battery block 10BB, respectively.

In this case, the battery module 100 can be prevented from increasing in size in the Y-direction and the Z-direction. Therefore, the battery modules 100 can be arranged without difficulty even though there is limited space in the Y-direction and the Z-direction for arranging the battery modules 100. This improves design flexibility of the battery system 500 and the electric vehicle including the battery system 500.

The one surfaces of the pair of end surface frame 92 constitute the one end surface and the other end surface of the battery block 10BB, respectively. This allows the first printed circuit board 211a and the second printed circuit board 212a to be reliably fixed to the pair of end surface frames 92.

The first printed circuit board 211a and the second printed circuit board 212a are provided on the end surface frames 92, respectively, thus eliminating the necessity of using another member (the board holder 95 in the twelfth embodiment) for attaching the first and second printed circuit boards 211a, 212a to the battery block 10BB. This results in simple configuration and improved manufacturing efficiency.

The first printed circuit board 211 a and the second printed circuit board 212a are arranged on the one end surface and the other end surface of the battery block 10BB, respectively, thus facilitating maintenance of the first and second printed circuit boards 211a, 212a.

### [14] Fourteenth Embodiment

Description will be made of a battery module according to a fourteenth embodiment by referring to differences from the battery module 100 according to the twelfth embodiment.

### (1) Configuration of the Battery Module

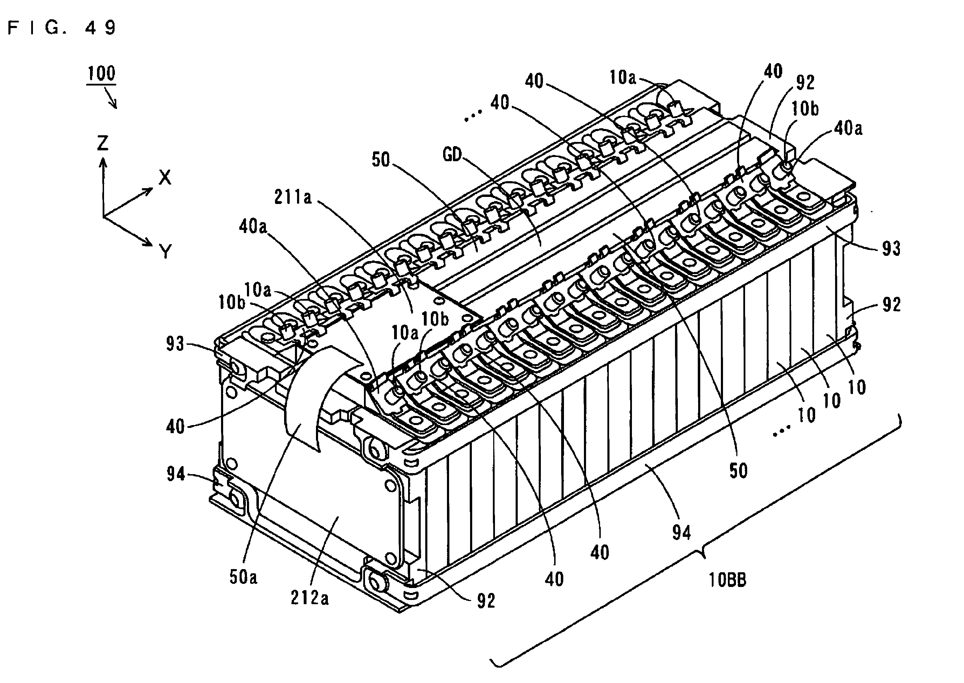

Fig. 49 is an external perspective view of the battery module 100 according to the fourteenth embodiment. As shown in Fig. 49, the second printed circuit board 212a is attached to the one surface of one end surface frame 92 of the pair of end surface frames 92 that is parallel to the YZ plane, and the first printed circuit board 211a is attached to the upper surface of the battery block 10BB that is parallel to the XY plane in the battery module 100. That is, the second printed circuit board 212a is provided on the one end surface of the battery block 10BB, and the first printed circuit board 211a is provided on the upper surface of the battery block 10BB. In this manner, the first printed circuit board 211a and the second printed circuit board 212a are also provided on different planes in the battery block 10BB in the present embodiment. Details are described below.

In the following description, the battery cell 10 adjacent to the one end surface frame 92 to which the second printed circuit board 212a is attached to the battery cell 10 adjacent to the other end surface frame 92 are referred to as the first battery cell 10 to the eighteenth battery cell 10.

In the example of Fig. 49, the first printed circuit board 211a having the rectangular shape is arranged parallel to the XY plane between the plus electrodes 10a and the minus electrodes 10b of the first to fifth battery cells 10. The first printed circuit board 211 a has a pair of lateral sides parallel to the X-direction and a pair of end sides parallel to the Y-direction. The bus bars 40, 40a attached to the first to fifth battery cells 10 are connected at spacings to the pair of lateral sides of the first printed circuit board 211a.

The two FPC boards 50 are arranged to line up in the Y-direction between the plus electrodes 10a and the minus electrodes 10b of the sixth to eighteenth battery cells 10. The two FPC boards 50 extend in the X-direction. The two FPC boards 50 each have a pair of lateral sides parallel to the X-direction. The plurality of bus bars 40 are connected to the lateral side of one FPC board 50 on the opposite side to the other FPC board 50 so as to line up at spacings. Similarly, the plurality of bus bars 40, 40a are connected to the lateral side of the other FPC board 50 on the opposite side to the one FPC board 50 so as to line up at spacings. Each FPC board 50 is connected to the first printed circuit board 211a.

The first printed circuit board 211a and the second printed circuit board 212a are connected to each other through the FPC boards 50a including the connecting lines.

As described above, the gas vent valve 10v (see Figs. 34 and 35) is formed at the center of the upper surface portion of each battery cell 10. A gas duct GD for introducing the gas exhausted from the gas vent valves 10v to the outside without dispersing the gas is provided in the battery module 100 of Fig. 49. The gas duct GD has a longitudinal shape with a concave cross section, and is provided to cover the gas vent valves 10v (see Figs. 34 and 35) of all the battery cells 10.

### (2) Attachment Configuration of the First Printed Circuit Board

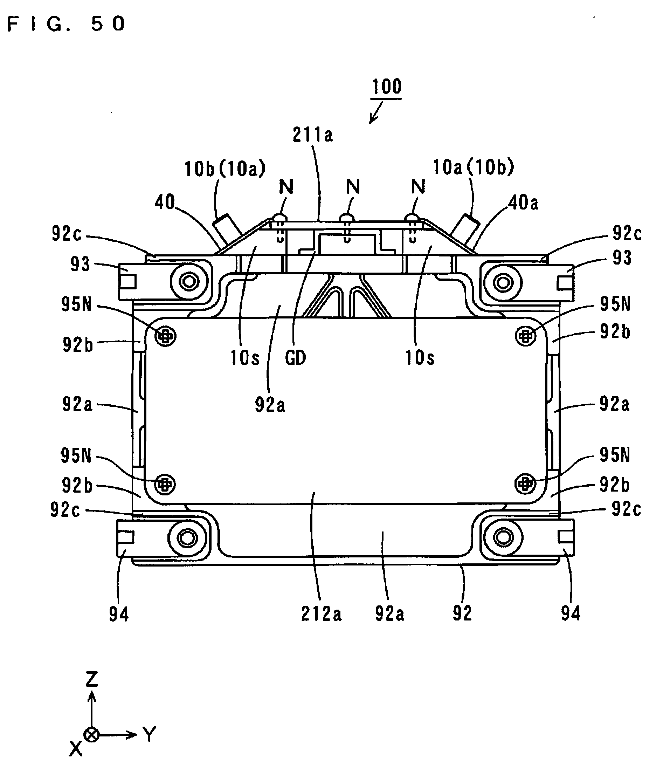

Fig. 50 is a diagram showing the attachment configuration of the first printed circuit board 211a of Fig. 49. Fig. 50 shows an end view of the battery module 100 of Fig. 49. Fig. 50 does not show the FPC board 50a of Fig. 49.

Through holes, not shown, are formed at four corners and in the vicinity of the center of the pair of end sides parallel to the Y-direction in the first printed circuit board 211a. Projections 10s that support the plus electrode 10a and the minus electrode 10b are provided on the upper surface of each battery cell 10. A screw hole, not shown, is formed at an upper end portion of each projection 10s. Screw holes, not shown, are also formed at an upper end portion of the gas duct GD.

The first printed circuit board 211a is aligned on the upper surfaces of the battery cells 10 such that the plurality of through holes formed in the first printed circuit board 211a and the screw holes of the projections 10s and the gas duct GD overlap one another. In this state, screws N are attached to the screw holes of the projections 10s and the gas duct GD through the through holes of the first printed circuit board 211a. This causes the first printed circuit board 211a to be fixed on the upper surfaces of the plurality of battery cells 10 as shown in Figs. 49 and 50.

### (3) Example of Arrangement of the Battery System

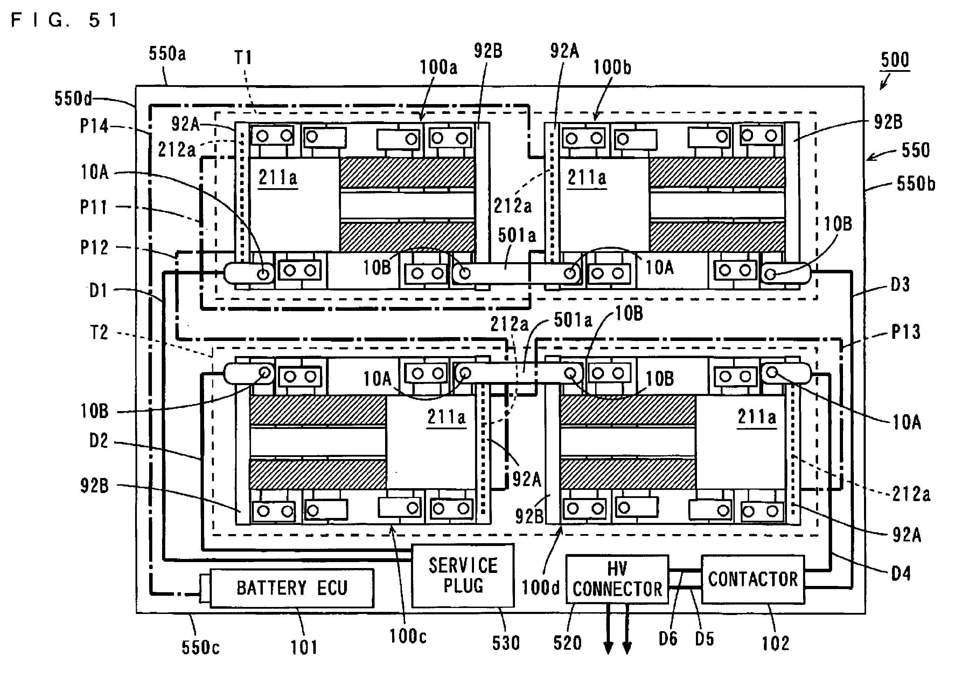

Fig. 51 is a schematic plan view showing one example of arrangement of the battery system 500 according to the fourteenth embodiment. Also in description of Fig. 51, the end surface frame 92 that is adjacent to the battery cell 10 including the high potential electrode 10A of each of the battery modules 100a to 100d is referred to as the end surface frame 92A, and the end surface frame 92 that is adjacent to the battery cell 10 including the low potential electrode 10B of each of the battery modules 100a to 100d is referred to as the end surface frame 92B, similarly to the thirteenth embodiment.

As shown in Fig. 51, the battery system 500 has the same configuration as the battery system 500 of Fig. 48 except that the first printed circuit board 211a is provided on the upper surface of each of the battery modules 100a to 100d.

### (4) Effects

The second printed circuit board 212a is provided on the one end surface of the battery block 10BB, and the first printed circuit board 211a is provided on the upper surface of the battery block 10BB in the battery module 100 according to the present embodiment.

In this case, the battery module 100 can be prevented from increasing in size in the Y-direction. Therefore, the battery modules 100 can be arranged without difficulty even though there is limited space in the Y-direction for arranging the battery modules 100.

Moreover, in this case, an increase in the size of the battery module 100 in the X-direction and the Z-direction can be minimized. Thus, the battery modules 100 can be arranged even though there is limited space in the X-direction and the Z-direction for arranging the battery modules 100. This improves design flexibility of the battery system 500 and the electric vehicle including the battery system 500.

Also in the present embodiment, the voltage detecting circuit 20 is mounted on the first printed circuit board 211a, and the communication circuit 24 is mounted on the second printed circuit board 212a. The voltage detecting circuit 20 corresponding to the number of the plurality of battery cells 10 is required when the number of the plurality of battery cells 10 in each battery module 100 is increased. Therefore, the voltages between the terminals of the plurality of battery cells 10 can be detected by replacing the first printed circuit board 211a. In this case, since the first printed circuit board 211a is provided on the upper surface of the battery block 10BB, the first printed circuit board 211a is easily replaced.

Meanwhile, the configuration of the communication circuit 24 need not be changed even though the number of the plurality of battery cells 10 in each battery module 100 is increased. Therefore, the second printed circuit board 212a need not be replaced when the number of the plurality of battery cells 10 in each battery module 100 is increased.

The first printed circuit board 211a can be easily replaced and the second printed circuit board 212a need not be replaced in the case of increasing the number of the plurality of battery cells 10 of each battery module 100. Accordingly, the number of the plurality of battery cells 10 in each battery module 100 can be easily changed.

### (5) Modifications

The battery module 100 may not include the gas duct GD. In this case, the first printed circuit board 211a is attached to the projections 10s of the battery cells 10. The first printed circuit board 211 a is arranged to cover the gas vent valves 10v (see Figs. 34 and 35) of the first to fifth battery cells 10. Therefore, a through hole is formed in a position opposite to each gas vent valve 10v in the first printed circuit board 211 a. This causes the gas exhausted from the gas vent valves 10v of the first to fifth battery cells 10 to be smoothly introduced to the outside through the through holes of the first printed circuit board 211 a.

The first printed circuit board 211a may be attached to one end surface frame 92 of the pair of end surface frames 92, and the second printed circuit board 212a may be attached to the upper surface of the battery block 10BB. In this case, the communication line 570 can be easily connected to the connector 29 (Fig. 39 (b)) of the second printed circuit board 212a. This facilitates assembly of the battery system 500.

While the first printed circuit board 211a is arranged to cover the gas vent valves 10v (see Figs. 34 and 35) of the first to fifth battery cells 10 as described above, the present invention is not limited to this. The first printed circuit board 211a may be formed to cover the gas vent valves 10v of all the battery cells 10 (The first to eighteenth battery cells 10). The first printed circuit board 211a may be formed to cover the entire upper surface of the battery block 10BB.

### [15] Fifteenth Embodiment

Description will be made of an electric vehicle according to a fifteenth embodiment. The electric vehicle according to the present embodiment includes the battery system according to any of the first to fourteenth embodiments. In the following paragraphs, an electric automobile is described as one example of the electric vehicle.

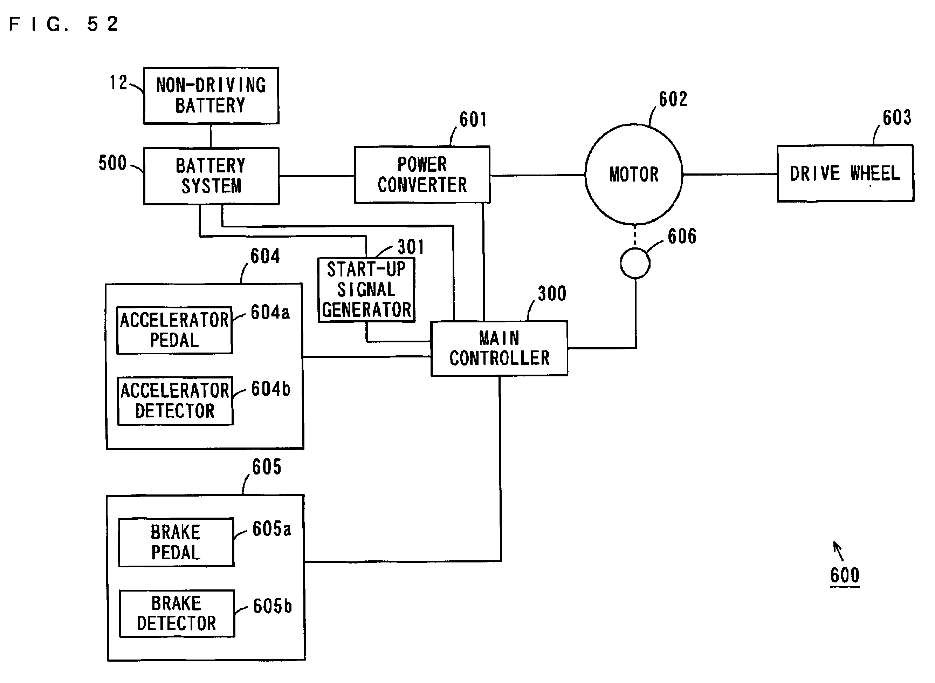

Fig. 52 is a block diagram showing the configuration of the electric automobile including the battery system 500. As shown in Fig. 52, the electric automobile 600 according to the present embodiment includes the battery system 500, the main controller 300, the non-driving battery 12, the start-up signal generator 301, a power converter 601, a motor 602, drive wheels 603, an accelerator system 604, a brake system 605, and a rotational speed sensor 606. When the motor 602 is an alternating current (AC) motor, the power converter 601 includes an inverter circuit.

As described above, the non-driving battery 12 and the start-up signal generator 301 are connected to the battery system 500 in the present embodiment. The battery system 500 is connected to the motor 602 via the power converter 601 while being connected to the main controller 300. The cell information of the plurality of battery modules 100M, 100 (see Fig. 1 or 34) is applied from the control-related circuit 2 (see Fig. 1) of the main circuit board 21 or the battery ECU 101 (see Fig. 42) of the battery system 500 to the main controller 300. Each of the start-up signal generator 301, the accelerator system 604, the brake system 605 and the rotational speed sensor 606 is connected to the main controller 300. The main controller 300 is composed of a CPU and a memory or composed of a microcomputer, for example.

The accelerator system 604 includes an accelerator pedal 604a included in the electric automobile 600 and an accelerator detector 604b that detects an operation amount (depression amount) of the accelerator pedal 604a. When the accelerator pedal 604a is operated by a driver, the accelerator detector 604b detects the operation amount of the accelerator pedal 604a. Note that a state of the accelerator pedal 604a when not being operated by the driver is set as a reference. The detected operation amount of the accelerator pedal 604a is applied to the main controller 300.

The start-up signal generator 301 generates the start-up signal at the time of start-up of the electric automobile 600. The start-up signal is applied to the battery system 500 and the main controller 300.

The brake system 605 includes a brake pedal 605a included in the electric automobile 600 and a brake detector 605b that detects an operation amount (depression amount) of the brake pedal 605a by the driver. When the brake pedal 605a is operated by the driver, the operation amount is detected by the brake detector 605b. The detected operation amount of the brake pedal 605a is applied to the main controller 300.

The rotational speed sensor 606 detects a rotational speed of the motor 602. The detected rotational speed is applied to the main controller 300.

The main controller 300 is started when detecting the start-up signal from the start-up signal generator 301. As described in the foregoing, the cell information of the battery modules 100M, 100, the operation amount of the accelerator pedal 604a, the operation amount of the brake pedal 605a and the rotational speed of the motor 602 are applied to the main controller 300. The main controller 300 performs charge/discharge control of the battery modules 100M, 100 and power conversion control of the power converter 601 based on the information.

Electric power generated by the battery modules 100M, 100 is supplied from the battery system 500 to the power converter 601 at the time of start-up and acceleration of the electric automobile 600 based on the accelerator operation, for example.

Furthermore, the main controller 300 calculates a torque (commanded torque) to be transmitted to the drive wheels 603 based on the applied operation amount of the accelerator pedal 604a, and applies a control signal based on the commanded torque to the power converter 601.

The power converter 601 receives the control signal, and then converts the electric power supplied from the battery system 500 into electric power (driving power) required for driving the drive wheels 603. Accordingly, the driving power converted by the power converter 601 is supplied to the motor 602, and the torque of the motor 602 based on the driving power is transmitted to the drive wheels 603.

Meanwhile, the motor 602 functions as a power generation system at the time of deceleration of the electric automobile 600 based on the brake operation. In this case, the power converter 601 converts regenerated electric power generated by the motor 602 to electric power suitable for charging the battery modules 100M, 100, and supplies the electric power to the battery modules 100M, 100. This causes the battery modules 100M, 100 to be charged.

As described above, the electric automobile 600 according to the present embodiment is provided with the battery system 500 according to any of the first to fourteenth embodiments. Thus, the wiring in the electric automobile 600 can be simplified, and the electric automobile 600 can be reduced in size. In addition, a limitation of space for arranging the battery modules 100M, 100 is relieved. This improves design flexibility and facilitates the manufacture of the electric automobile 600.

### [16] Other Embodiments

(1) While the control-related circuit 2 of the main circuit board 21 includes any of the current detecting circuit 210, the total voltage detecting circuit 213, the electric leakage detecting circuit 214, the contactor controlling circuit 215, the fan controlling circuit 216, the power supplying circuit 217 and the vehicle start-up detecting circuit 218 in the battery systems according to the first to eleventh embodiments, the present invention is not limited to this. The control-related circuit 2 may include at least two or all of the current detecting circuit 210, the total voltage detecting circuit 213, the electric leakage detecting circuit 214, the contactor controlling circuit 215, the fan controlling circuit 216, the power supplying circuit 217 and the vehicle start-up detecting circuit 218. Alternatively, the current detecting circuit 210, the total voltage detecting circuit 213, the electric leakage detecting circuit 214, the contactor controlling circuit 215, the fan controlling circuit 216, the power supplying circuit 217 and the vehicle start-up detecting circuit 218 may be included in at least two main circuit boards 21.
(2) Either one of the first printed circuit board 211a and the second printed circuit board 212a may be provided on the one end surface of the battery block 10BB, and the other may be provided on the one side surface parallel to the XZ plane of the battery block 10BB in the twelfth to fourteenth embodiments.
   In this case, the battery module 100 can be prevented from increasing in size in the Z-direction. Therefore, the battery modules 100 can be arranged without difficulty even though there is limited space in the Z-direction for arranging the battery modules 100.
   Moreover, an increase in the size of the battery module 100 in the X-direction and the Y-direction can be minimized. Therefore, the battery modules 100 can be arranged even though there is limited space in the X-direction and the Y-direction for arranging the battery modules 100. This improves design flexibility of the battery system 500 and the electric vehicle including the battery system 500.
(3) While the communication circuit 24 is provided in the second printed circuit board 212a in the twelfth to fourteenth embodiments, a circuit having the function of the battery ECU 101 may be provided in the second printed circuit board 212a.
   More specifically, the CAN communication circuit 203 may be mounted on the second printed circuit board 212a. In this case, the CAN communication circuit 203 calculates the charged capacity of each battery cell 10 and detects overdischarge, overcharge or abnormal temperature, for example, of the battery cells 10. In addition, the CAN communication circuit 203 applies the calculated charged capacity and the detection results of overdischarge, overcharge or abnormal temperature, for example, to the main controller 300. When detecting overdischarge, overcharge or abnormal temperature, for example, of the battery modules 100, the CAN communication circuit 203 turns off the contactor 102.
   This eliminates the necessity of providing the battery ECU 101 in the battery system 500. Accordingly, the configuration of the battery system 500 is simplified. As described above, in the case of mounting the CAN communication circuit 203 on the second printed circuit board 212a, the second printed circuit board 212a may be provided in only one of the plurality of battery modules 100 in the battery system 500 including the plurality of battery modules 100 as described in the example of Fig. 45.
(4) The total voltage detecting circuit 213 that divides and amplifies the voltage difference between the plus electrode having the highest potential and the minus electrode having the lowest potential in the battery system 500 may be mounted on the first printed circuit board 211a. In this case, the value of the total voltage of the battery system 500 is calculated by the communication
   circuit 24 of the second printed circuit board 212a.
   Not only the communication circuit 24 but also the contactor controlling circuit 215 that controls the operation of the contactor 102 of Fig. 42 may be mounted on the second printed circuit board 212a.
   The fan 581 for releasing heat from the battery modules 100 within the casing 550 is provided in the casing 550 of the battery system 500 in some cases. In this case, the fan controlling circuit 216 for controlling the operation of the fan 581 may be provided on the second printed circuit board 212a.
   In addition to the communication circuit 24, the power supplying circuit 217 that steps down the voltage output from the non-driving battery 12 may be mounted on the second printed circuit board 212a. In this case, the voltage stepped down by the power supplying circuit 217 is applied to the communication circuit 24.
   The electric leakage detecting circuit 214 that detects the presence/absence of electric leakage in the battery system 500 may be mounted on the second printed circuit board 212a. In this case, the presence/absence of electric leakage in the battery system 500 detected by the electric leakage detecting circuit 214 is applied to the main controller 300 as the electric leakage detecting signal by the communication circuit 24.
   The electric vehicle includes the start-up signal generator 301 that generates the start-up signal at the time of start-up. The vehicle start-up detecting circuit 218 that detects the start-up signal generated by the start-up signal generator 301 and starts up the communication circuits 24 of the plurality of battery modules 100 may be mounted on the second printed circuit board 212a.
(5) While the first printed circuit board 211a and the second printed circuit board 212a are connected using the FPC boards including the connecting lines in the twelfth to fourteenth embodiments, the present invention is not limited to this. The first printed circuit board 211a and the second printed circuit board 212a may be connected using connectors and a harness. More specifically, respective connectors are mounted on the first printed circuit board 211a and the second printed circuit board 212a, and the two connectors are connected through the harness. This facilitates the manufacture of the battery modules 100.
(6) While the battery cell 10 has a substantially rectangular parallelepiped shape in the first to fourteenth embodiments, the present invention is not limited to this. The battery cell 10 may have a cylindrical shape.

### [17] Correspondences between Elements in the Claims and Parts in Embodiments

In the following paragraphs, non-limiting examples of correspondences between various elements recited in the claims below and those described above with respect to various preferred embodiments of the present invention are explained.

In the foregoing embodiments, the battery cell 10 is an example of a battery cell, the battery modules 100, 100a to 100d, 100M, 100Ma, 100Mb are examples of a battery module, the main circuit board 21 is an example of a main circuit board and a common circuit board, and the auxiliary circuit board 21a is an example of an auxiliary circuit board. The cell characteristics detecting circuit 1 of the battery modules 100M, 100Ma, 100Mb is an example of a first cell characteristics detecting circuit, and the cell characteristics detecting circuit 1 of the battery modules 100, 100a to 100c is an example of a second cell characteristics detecting circuit.

The control-related circuit 2 is an example of a control-related circuit, the CAN communication function, the current detecting function, the total voltage detecting function, the electric leakage detecting function, the contactor controlling function, the fan controlling function, the power supplying function or the vehicle start-up detecting function is an example of a function related to control of the battery modules, and the voltage/current bus bar 40y, the voltage terminals V1, V2 or the vehicle start-up terminal G is an example of a detecting unit. The current detecting function, the total voltage detecting function, the electric leakage detecting function or the vehicle start-up detecting function is an example of a detecting function, the contactor 102 or the fan terminal F is an example of a control target, the contactor controlling function or the fan controlling function is an example of a controlling function, and the voltage detected by the voltage/current bus bar 40y or the voltage detected by the voltage terminals V1, V2 is an example of a parameter.

The current flowing through the plurality of battery modules 100M, 100Ma, 100Mb, 100, 100a to 100c or the presence/absence of electric leakage is an example of information, the battery system 500 is an example of a battery system, the motor 602 is an example of a motor, each of the drive wheels 603 is an example of a drive wheel, and the electric automobile 600 is an example of an electric vehicle. The battery ECU 101 or the main controller 300 is an example of an external apparatus, the battery block 10BB is an example of a battery block, the voltage detecting circuit 20 and the communication circuit 24 are examples of a circuit, and the one surface of the one end surface frame 92 is an example of a first surface.

The one surface of the board holder 95, the one surface of the other end surface frame 92, or the upper surface of the battery block 10BB that is parallel to the XY plane is an example of a surface that is different from the first surface of the battery block, the one surface of the board holder 95 is an example of a second surface, and the one surface of the other end surface frame 92 is an example of a third surface. The X-direction is an example of a direction intersecting with the first surface, the upper surface of the battery block 10BB that is parallel to the XY plane is an example of a fourth surface, the voltage detecting circuit 20 is an example of a detecting unit, and the communication circuit 24 is an example of a communication unit.

In the first to eleventh embodiments, the series circuit composed of the resistor R and the switching element SW of the main circuit board 21 is an example of a first discharging circuit, and the series circuit composed of the resistor R and the switching element SW of the auxiliary circuit board 21a is an example of a second discharging circuit. In the twelfth to fourteenth embodiments, the equalization circuit EQ is an example of first and second discharging circuits.

In the tenth and eleventh embodiments, the main circuit board 211 is an example of a first circuit board, and the main circuit board 212 is an example of a second circuit board. In the twelfth to fourteenth embodiments, one of the first and second printed circuit boards 211a, 212a is an example of a first circuit board, and the other one of the first and second printed circuit boards 211a, 212a is an example of a second circuit board.

As each of various elements recited in the claims, various other elements having configurations or functions described in the claims can be also used.

While preferred embodiments of the present invention have been described above, it is to be understood that variations and modifications will be apparent to those skilled in the art without departing the scope and spirit of the present invention. The scope of the present invention, therefore, is to be determined solely by the following claims, as interpreted by the description and drawings.

## Claims

1. A battery system comprising a plurality of battery modules each including a plurality of battery cells, wherein
at least one of said plurality of battery modules further includes a main circuit board, another battery module further includes an auxiliary circuit board,
said main circuit board includes a first cell characteristics detecting circuit arranged to detect characteristics of each battery cell and a control-related circuit having a function related to control of said plurality of battery modules, and
said auxiliary circuit board includes a second cell characteristics detecting circuit arranged to detect characteristics of each battery cell, and does not include the control-related circuit having the function related to control of said plurality of battery modules.

2. The battery system according to claim 1, wherein said main circuit board is constituted by a circuit board including said first cell characteristics detecting circuit and said control-related circuit.

3. The battery system according to claim 1, wherein said main circuit board is constituted by a first circuit board including said first cell characteristics detecting circuit and a second circuit board including said control-related circuit.

4. The battery system according to claim 1, further comprising a detecting unit arranged to detect a parameter, wherein
said control-related circuit has a detecting function for detecting information, which is used for controlling said plurality of battery modules, based on the parameter detected by said detecting unit, and
said control-related circuit of said main circuit board is arranged closer than said auxiliary circuit board to said detecting unit.

5. The battery system according to claim 1, further comprising a control target that is related to control of said plurality of battery modules, wherein
said control-related circuit has a controlling function for controlling operation of said control target, and
said control-related circuit of said main circuit board is arranged closer than said auxiliary circuit board to said control target.

6. The battery system according to claim 1, wherein
said main circuit board further includes a first discharging circuit arranged to cause each battery cell of said at least one battery module to discharge, and
said auxiliary circuit board further includes a second discharging circuit arranged to cause each battery cell of said another battery module to discharge.

7. An electric vehicle comprising:
the battery system according to claim 1;
a motor driven by electric power supplied from said plurality of battery modules of said battery system; and
a drive wheel rotated by a torque generated by said motor.

8. A battery module that can communicate with an external apparatus, comprising:
a battery block constituted by a plurality of battery cells that are stacked; and
first and second circuit boards on which circuits for detecting states of said plurality of battery cells and communicating with said external apparatus are mounted, wherein
said battery block has a first surface intersecting with a direction in which said plurality of battery cells are stacked, said first circuit board is provided on said first surface of said battery block, and said second circuit board is provided on a surface that is different from said first surface of said battery block.

9. The battery module according to claim 8, wherein said second circuit board is provided on a second surface that is parallel to said first surface so as to be stacked on said first circuit board.

10. The battery module according to claim 8, wherein said battery block has a third surface that is opposite to said first surface with said plurality of battery cells arranged between said first surface and said third surface, and
said second circuit board is provided on said third surface of said battery block.

11. The battery module according to claim 8, wherein
said battery block has a fourth surface along the direction intersecting with said first surface, and
said second circuit board is provided on said fourth surface of said battery block.

12. The battery module according to claim 8, wherein
said circuits include a detecting unit arranged to detect the states of said plurality of battery cells and a communication unit arranged to communicate with said external apparatus,
said first circuit board includes one of said detecting unit and said communication unit, and
said second circuit board includes the other one of said detecting unit and said communication unit.

13. A battery system comprising a plurality of battery modules each including a plurality of battery cells, wherein
at least one of said plurality of battery modules is the battery module according to claim 8.

14. An electric vehicle comprising:
the battery system according to claim 13;
a motor driven by electric power supplied from said plurality of battery modules included in said battery system; and
a drive wheel rotated by a torque generated by said motor.
